(19) Europäisches Patentamt / European Patent Office / Office européen des brevets

(11) **EP 4 394 507 A1**

(12) **EUROPEAN PATENT APPLICATION**


(43) Date of publication:
**03.07.2024 Bulletin 2024/27**

(21) Application number: **23178649.2**

(22) Date of filing: **12.06.2023**

(51) International Patent Classification (IPC):
***G03F 7/004*** *(2006.01)* ***C07F 7/22*** *(2006.01)*

(52) Cooperative Patent Classification (CPC):
**G03F 7/0042; C07F 7/2224**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.12.2022 KR 20220186374**



(71) Applicant: **Samsung Electronics Co., Ltd.**
**Suwon-si, Gyeonggi-do 16677 (KR)**

(72) Inventors:
- **KOH, Haengdeog**
  **16678 Suwon-si (KR)**
- **KWAK, Yoonhyun**
  **16678 Suwon-si (KR)**
- **KIM, Mijeong**
  **16678 Suwon-si (KR)**
- **KIM, Minsang**
  **16678 Suwon-si (KR)**
- **LEE, Sunyoung**
  **16678 Suwon-si (KR)**
- **LEE, Changheon**
  **16678 Suwon-si (KR)**
- **IM, Kyuhyun**
  **16678 Suwon-si (KR)**
- **CHAE, Jungha**
  **16678 Suwon-si (KR)**
- **HAN, Sunghyun**
  **16678 Suwon-si (KR)**

(74) Representative: **Elkington and Fife LLP**
**Prospect House**
**8 Pembroke Road**
**Sevenoaks, Kent TN13 1XR (GB)**


Remarks:
Amended claims in accordance with Rule 137(2) EPC.

(54) **RESIST COMPOSITION AND METHOD OF FORMING PATTERN BY USING THE SAME**


(57) Provided are a resist composition and a method of forming a pattern by using the same, the resist composition including: an organometallic compound represented by Formula 1; and a polymer including a repeating unit containing a radical generating group, a repeating unit containing a radical accepting group, or any combination thereof.

Formula 1 $Sn(R_{11})_n(OR_{12})_{(4-n)}$

Descriptions of $R_{11}$, $R_{12}$ and n in Formula 1 are provided in the specification.


**FIG. 1**

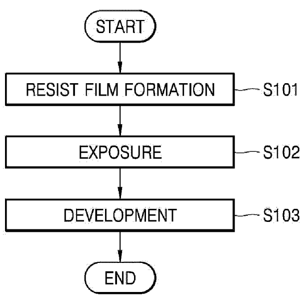


EP 4 394 507 A1

## Description

FIELD OF THE INVENTION

The inventive concepts relate to resist compositions and methods of forming a pattern by using the same.

BACKGROUND OF THE INVENTION

In semiconductor manufacturing, a resist that changes its properties in response to light is used to form micropatterns. Among such resists, chemically amplified resists are widely used. A chemically amplified resist enables patterning by changing the solubility of a base resin in a developer, as an acid generated from a reaction between light and a photoacid generator reacts again with the base resin.

However, such a chemically amplified resist may have issues such as increased surface roughness or decreased pattern uniformity due to diffusion of the generated acid into unexposed regions. In addition, as the semiconductor process becomes increasingly miniaturized, control over acid diffusion becomes more difficult, and thus there is a need to develop a novel type of resist.

In recent years, attempts have been made to develop a material that changes its properties by exposure in order to overcome the limitations of such chemically amplified photoresists. However, a high exposure dose requirement remains an issue.

SUMMARY OF THE INVENTION

Some example embodiments provide a resist composition which changes its properties even at a low dose of exposure and provides a pattern with an improved resolution, and a method of forming a pattern using the resist composition.

Additional aspects will be set forth in part in the description which follows and, in part, will be apparent from the description, or may be learned by practice of the presented example embodiments of the inventive concepts.

According to some example embodiments of the inventive concepts, a resist composition includes an organometallic compound represented by Formula 1 below; and a polymer including a repeating unit containing a radical generating group, a repeating unit containing a radical accepting group, or any combination thereof:

Formula 1 $$Sn(R_{11})_n(OR_{12})_{(4-n)}$$

In Formula 1,

$R_{11}$ may be a linear, branched or cyclic $C_1$-$C_{30}$ monovalent hydrocarbon group optionally containing one or more heteroatoms,
$R_{12}$ may be a linear, branched or cyclic $C_1$-$C_{30}$ monovalent hydrocarbon group optionally containing one or more heteroatoms, or *-$Sn(R_{13})_m(OR_{14})_{(3-m)}$,
n may be an integer from 1 to 4,
$R_{13}$ and $R_{14}$ may be each independently a linear, branched or cyclic $C_1$-$C_{30}$ monovalent hydrocarbon group optionally containing one or more heteroatoms,
m may be an integer from 0 to 3, and
* may be a binding site with a neighboring atom.

In Formula 1, a bond between Sn and $R_{11}$ may be a Sn-carbon(C) single bond, and a bond between Sn and $R_{13}$ may be a Sn-C single bond.

In Formula 1, the organometallic compound may have a molecular weight of about 3,000 g/mol or less.

In Formula 1, when $R_{11}$ and $R_{13}$ may each independently be represented by *-$(L_{11})_{a11}$-$X_{11}$, and/or $R_{12}$ and $R_{14}$ may each independently be represented by *-$(L_{12})_{a12}$-$X_{12}$, $L_{11}$ and $L_{12}$ may each independently be $CR_aR_b$, C=O, S=O, $SO_2$, $PO_2$, or $PO_3$, a11 and a12 may each independently be an integer from 0 to 3, $X_{11}$ and $X_{12}$ may each independently be an unsubstituted or substituted $C_1$-$C_{30}$ alkyl group, an unsubstituted or substituted $C_1$-$C_{30}$ halogenated alkyl group, an unsubstituted or substituted $C_1$-$C_{30}$ alkoxy group, an unsubstituted or substituted $C_1$-$C_{30}$ alkylthio group, an unsubstituted or substituted $C_1$-$C_{30}$ halogenated alkoxy group, an unsubstituted or substituted $C_1$-$C_{30}$ halogenated alkylthio group, an unsubstituted or substituted $C_3$-$C_{30}$ cycloalkyl group, an unsubstituted or substituted $C_3$-$C_{30}$ cycloalkoxy group, an unsubstituted or substituted $C_3$-$C_{30}$ cycloalkylthio group, an unsubstituted or substituted $C_3$-$C_{30}$ heterocycloalkyl group, an unsubstituted or substituted $C_3$-$C_{30}$ heterocycloalkoxy group, an unsubstituted or substituted $C_3$-$C_{30}$ heterocycloalkylthio group, an unsubstituted or substituted $C_2$-$C_{30}$ alkenyl group, an unsubstituted or substituted

$C_2$-$C_{30}$ alkenyloxy group, an unsubstituted or substituted $C_2$-$C_{30}$ alkenylthio group, an unsubstituted or substituted $C_3$-$C_{30}$ cycloalkenyl group, an unsubstituted or substituted $C_3$-$C_{30}$ cycloalkenyloxy group, an unsubstituted or substituted $C_3$-$C_{30}$ cycloalkenylthio group, an unsubstituted or substituted $C_3$-$C_{30}$ heterocycloalkenyl group, an unsubstituted or substituted $C_3$-$C_{30}$ heterocycloalkenyloxy group, an unsubstituted or substituted $C_3$-$C_{30}$ heterocycloalkenylthio group, an unsubstituted or substituted $C_2$-$C_{30}$ alkynyl group, an unsubstituted or substituted $C_2$-$C_{30}$ alkynyloxy group, an unsubstituted or substituted $C_2$-$C_{30}$ alkynylthio group, an unsubstituted or substituted $C_6$-$C_{30}$ aryl group, an unsubstituted or substituted $C_6$-$C_{30}$ aryloxy group, an unsubstituted or substituted $C_6$-$C_{30}$ arylthio group, an unsubstituted or substituted $C_1$-$C_{30}$ heteroaryl group, an unsubstituted or substituted $C_1$-$C_{30}$ heteroaryloxy group, or an unsubstituted or substituted $C_1$-$C_{30}$ heteroarylthio group, $R_a$ and $R_b$ may each independently be hydrogen, deuterium, a hydroxyl group, a cyano group, a nitro group, an unsubstituted or substituted $C_1$-$C_{30}$ alkyl group, an unsubstituted or substituted $C_1$-$C_{30}$ alkoxy group, an unsubstituted or substituted $C_1$-$C_{30}$ alkylthio group, an unsubstituted or substituted $C_3$-$C_{30}$ cycloalkyl group, an unsubstituted or substituted $C_3$-$C_{30}$ cycloalkoxy group, or an unsubstituted or substituted $C_3$-$C_{30}$ cycloalkylthio group, and * may be a binding site with a neighboring atom.

The organometallic compound may be represented by any one of Formulas 1-1 to 1-16:

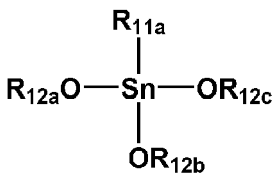
1-1

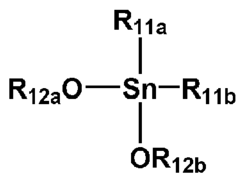
1-2

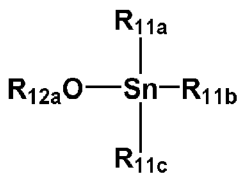
1-3

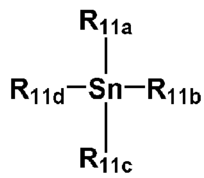
1-4

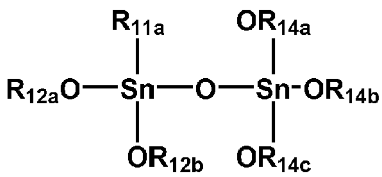
1-5

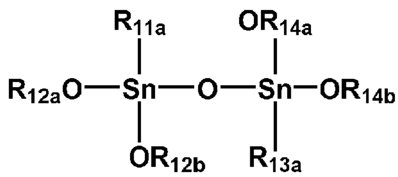
1-6

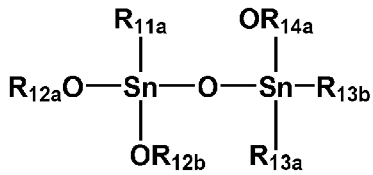
1-7

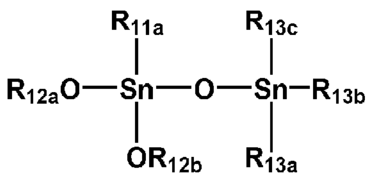
1-8

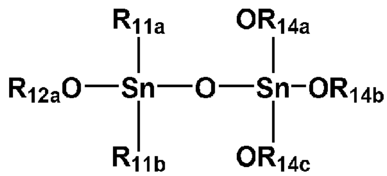
1-9

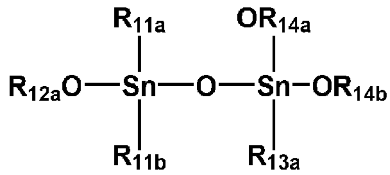
1-10

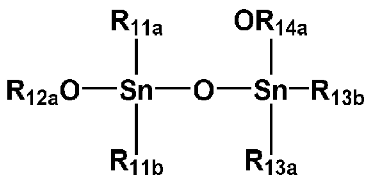
1-11

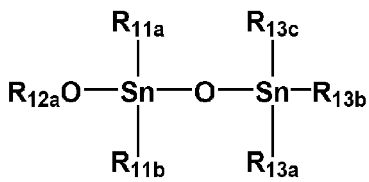
1-12

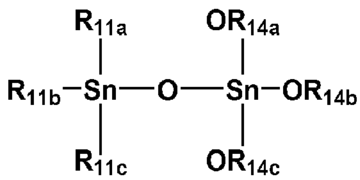
1-13

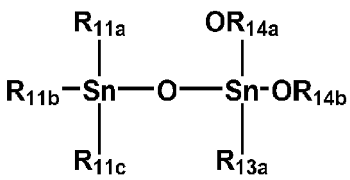
1-14

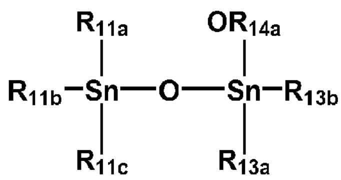
1-15

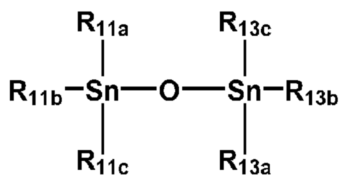
1-16

wherein in Formulas 1-1 to 1-16, $R_{11a}$ to $R_{11d}$ are each independently a linear, branched or cyclic $C_1$-$C_{30}$ monovalent hydrocarbon group optionally containing one or more heteroatoms, $R_{12a}$ to $R_{12c}$ are each independently a linear, branched or cyclic $C_1$-$C_{30}$ monovalent hydrocarbon group optionally containing one or more heteroatoms, or *-$Sn(R_{13})_m(OR_{14})_{(3-m)}$, where $R_{13}$ and $R_{14}$ are each independently a linear, branched or cyclic $C_1$-$C_{30}$ monovalent hydrocarbon group optionally containing one or more heteroatoms, m is an integer from 0 to 3, and * is a binding site with a neighboring atom, $R_{13a}$ to $R_{13c}$ are each independently a linear, branched or cyclic $C_1$-$C_{30}$ monovalent hydrocarbon group optionally containing one or more heteroatoms, and $R_{14a}$ to $R_{14c}$ are each independently a linear, branched or cyclic $C_1$-$C_{30}$ monovalent hydrocarbon group optionally containing one or more heteroatoms.

The radical generating group may include a single bond between a carbon atom and X (C-X) or a single bond between a carbon atom and $X^+$ (C-$X^+$), wherein X is a heteroatom other than a carbon atom and a hydrogen atom.

X may be a halogen, an oxygen atom, a sulfur atom, a selenium atom, a nitrogen atom, or a phosphorus atom.

An unsubstituted or substituted $C_1$-$C_{30}$ aryl group or an unsubstituted or substituted $C_1$-$C_{30}$ heteroaryl group may be bound adjacent to the carbon atom.

The radical generating group may include a partial structure represented by Formula RG:

Formula RG

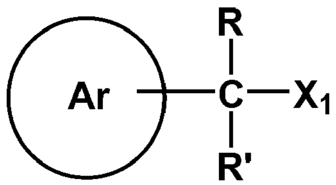

wherein in Formula RG, Ar is an unsubstituted or substituted $C_1$-$C_{30}$ aryl group or an unsubstituted or substituted $C_1$-$C_{30}$ heteroaryl group, R and R' are each independently hydrogen, deuterium, a halogen, or a linear, branched or cyclic $C_1$-$C_{30}$ divalent hydrocarbon group optionally containing one or more heteroatoms, and $X_1$ is an electron withdrawing group.

The radical accepting group may include a lone-pair electron donating group and/or an electron donating group.

The lone-pair electron donating group may include an oxygen atom, a sulfur atom, a nitrogen atom, or a phosphorus atom, as a partial structure.

The electron donating group may include a single bond between a hydrogen atom and Z (Z-H), wherein Z is a heteroatom other than a carbon atom and a hydrogen atom.

The radical accepting group may include a partial structure represented by Formula RA1 or RA2:

Formula RA1

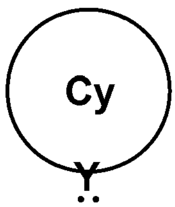

Formula RA2

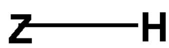

wherein in Formulas RA1 and RA2, Cy is an unsubstituted or substituted $C_1$-$C_{30}$ carbocyclic group or an unsubstituted or substituted $C_1$-$C_{30}$ heterocyclic group, Y is an oxygen atom, a sulfur atom, a nitrogen atom, a phosphorus atom, S=O, P=O, or C=O, Z is an oxygen atom, a sulfur atom, a nitrogen atom, or a phosphorus atom, and : is a lone-pair of electrons.

The repeating unit may contain a radical generating group is represented by Formula 2-1 or 2-2, and the repeating unit may contain a radical accepting group is represented by any one of Formulas 2-3 to 2-6:

Formula 2-1

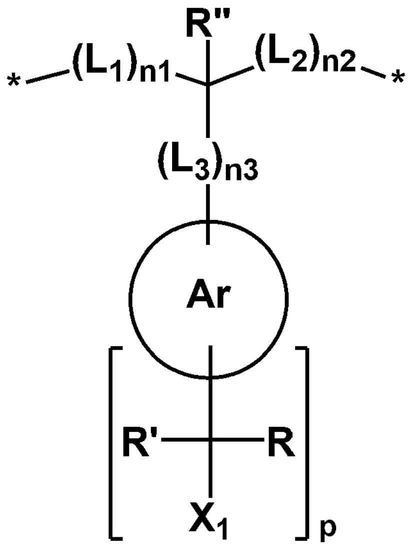

Formula 2-2

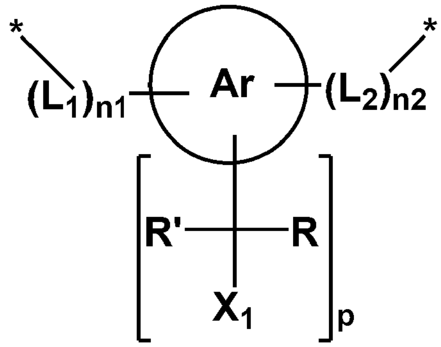

Formula 2-3

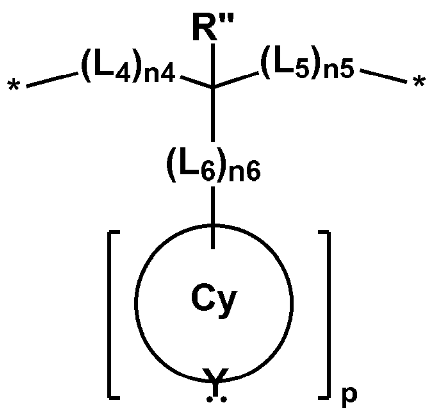

Formula 2-4

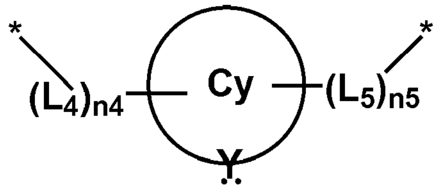

Formula 2-5

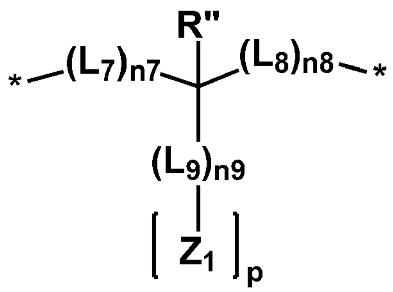

Formula 2-6

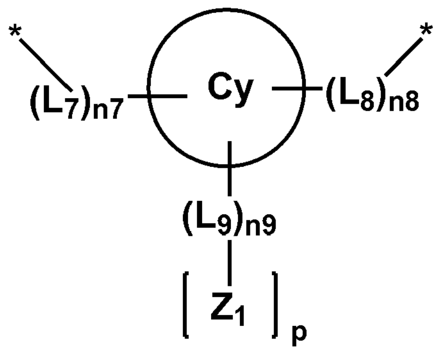

wherein, in Formulas 2-1 to 2-2, Ar is an unsubstituted or substituted $C_1$-$C_{30}$ aryl group or an unsubstituted or substituted $C_1$-$C_{30}$ heteroaryl group, $X_1$ is an electron withdrawing group, R, R', and R" are each independently hydrogen, deuterium, a halogen, or a linear, branched or cyclic $C_1$-$C_{30}$ divalent hydrocarbon group optionally containing one or more heteroatoms, $L_1$ to $L_3$ are each independently a single bond, O, S, C(=O), C(=O)O, OC(=O), C(=O)NH, NHC(=O), a linear, branched or cyclic $C_1$-$C_{30}$ divalent hydrocarbon group optionally containing one or more heteroatoms, or any combination thereof, n1 to n3 are each independently an integer from 1 to 6, p is an integer from 1 to 5, and * is a binding site with a neighboring atom; wherein, in Formulas 2-3 to 2-6 Cy is an unsubstituted or substituted $C_1$-$C_{30}$ carbocyclic group or

an unsubstituted or substituted $C_1$-$C_{30}$ heterocyclic group, Y is an oxygen atom, a sulfur atom, a nitrogen atom, a phosphorus atom, S=O, P=O, or C=O, : is a lone-pair of electrons, $Z_1$ is an electron donating group, R" is hydrogen, deuterium, a halogen, or a linear, branched or cyclic $C_1$-$C_{30}$ monovalent hydrocarbon group optionally containing one or more heteroatoms, $L_4$ to $L_9$ are each independently a single bond, O, S, C(=O), C(=O)O, OC(=O), C(=O)NH, NHC(=O), a linear, branched or cyclic $C_1$-$C_{30}$ divalent hydrocarbon group optionally containing one or more heteroatoms, or any combination thereof, n4 to n9 are each independently an integer from 1 to 6, p is an integer from 1 to 5, and * is a binding site with a neighboring atom.

According to some example embodiments of the inventive concepts, a resist composition includes an organometallic compound represented by Formula 1 below; and a monomer containing a radical generating group or a radical accepting group.

Formula 1 $Sn(R_{11})_n(OR_{12})_{(4-n)}$

In Formula 1,

$R_{11}$ may be a linear, branched or cyclic $C_1$-$C_{30}$ monovalent hydrocarbon group optionally containing one or more heteroatoms,
$R_{12}$ may be a linear, branched or cyclic $C_1$-$C_{30}$ monovalent hydrocarbon group optionally containing one or more heteroatoms, or $*\text{-}Sn(R_{13})_m(OR_{14})_{(3-m)}$,
n may be an integer from 1 to 4,
$R_{13}$ and $R_{14}$ may be each independently a linear, branched or cyclic $C_1$-$C_{30}$ monovalent hydrocarbon group optionally containing one or more heteroatoms,
m may be an integer from 0 to 3, and
* may be a binding site with a neighboring atom.

The monomer may include at least one polymerizable group.

According to some example embodiments of the inventive concepts, a method of forming a pattern includes: forming a resist film based on coating the above-described resist composition; exposing at least a portion of the resist film to a high-energy ray to establish an exposed resist film; and developing the exposed resist film based on using a developer.

The exposing may be performed based on irradiation of deep ultraviolet light (DUV), extreme ultraviolet light (EUV), and/or an electron beam (EB).

A chemical bond between the organometallic compound and the polymer may be formed based on exposing the resist film.

Based on the exposing at least the portion of the resist film, the exposed resist film may include an exposed portion and an unexposed portion, and the developing the exposed resist film may include removing the unexposed portion.

## BRIEF DESCRIPTION OF THE DRAWINGS

The above and other aspects, features, and advantages of certain embodiments of the inventive concepts will be more apparent from the following description taken in conjunction with the accompanying drawings, in which:

FIG. 1 is a flowchart showing a method according to some example embodiments;
FIGS. 2A, 2B, and 2C are side cross-sectional views showing a method of forming a pattern, according to some example embodiments;
FIGS. 3A, 3B, 3C, and 3D show $^{1}H$-NMR and $^{119}Sn$-NMR spectra of Compounds FB and T1; and
FIGS. 4A and 4B are diagrams showing a change in film thickness after development according to dose in Comparative Example 1 and Examples 1 and 2.

## DETAILED DESCRIPTION OF THE EMBODIMENTS

Reference will now be made in detail to example embodiments, some of which are illustrated in the accompanying drawings, wherein like reference numerals refer to like elements throughout. In this regard, some example embodiments may have different forms and should not be construed as being limited to the descriptions set forth herein. Accordingly, some example embodiments are merely described below, by referring to the figures, to explain aspects. The term "and/or" includes any and all combinations of one or more of the associated listed items. Expressions such as "at least one of," when preceding a list of elements, modify the entire list of elements and do not modify the individual

elements of the list.

As the inventive concepts may have various modifications and a number of embodiments, particular embodiments are illustrated in the drawings and described in greater detail in the detailed description. However, the inventive concepts should not be construed as being limited to specific embodiments set forth herein. Rather, these embodiments are to be understood as encompassing all variations, equivalents, or alternatives included in the scope of the inventive concepts. In describing the inventive concepts, if it is determined that a detailed description of a relevant known art may obscure the gist of the inventive concepts, the detailed description thereof will be omitted.

Hereinafter, the terms "above" or "on" may include not only those that are directly on in a contact manner, but also those that are above in a non-contact manner. The singular forms "a," "an," and "the" as used herein are intended to include the plural forms as well unless the context clearly indicates otherwise. It will be understood that the terms "comprise," "include," or "have" as used herein specify the presence of stated elements, but do not preclude the presence or addition of one or more other elements.

The use of the term "the" and similar demonstratives may correspond to both the singular and the plural. Operations constituting methods may be performed in any suitable order unless otherwise indicated herein or otherwise clearly contradicted by context, and are not necessarily limited to the stated order.

The use of all illustrations or illustrative terms in some example embodiments is simply to describe the technical ideas in detail, and the scope of the present inventive concepts is not limited by the illustrations or illustrative terms unless they are limited by claims.

Regardless of whether elements and/or properties thereof are modified as "substantially," it will be understood that these elements and/or properties thereof should be construed as including a manufacturing or operational tolerance (e.g., ±10%) around the stated elements and/or properties thereof.

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

As described herein, when an operation is described to be performed, or an effect such as a structure is described to be established "by" or "through" performing additional operations, it will be understood that the operation may be performed and/or the effect/structure may be established "based on" the additional operations, which may include performing said additional operations alone or in combination with other further additional operations.

The terms "first," "second," "third," etc. may be used herein to describe various elements, but these terms are only used to distinguish one element from another element and these elements should not be limited by these terms.

As used herein, when an element such as a layer, a film, a region, a plate, etc. is described as being on an "above" of, or "on" another element, the element may be disposed on, below, left, or, above the another element while making contact with the another element, or may be disposed on, below, left, or, above the another element without making any contact with the another element.

As used herein, the singular forms are intended to include the plural forms as well, unless the context clearly indicates otherwise. As used herein, unless stated otherwise, the terms "comprises" and/or "comprising," or "includes" and/or "including" specify the presence of stated features, numbers, steps, operations, elements, components, ingredients, materials, or combinations thereof, but do not preclude the presence or addition of one or more other features, numbers, steps, operations, elements, components, ingredients, materials, or combinations thereof.

Whenever a range of values is presented, the range includes as expressly stated all values falling within the range and further includes the boundaries of the range. Accordingly, the range "X to Y" includes all values between X and Y, including X and Y.

As used herein, "$C_x$-$C_y$" means that the number (e.g., quantity) of carbon atoms constituting a substituent ranges from x to y, wherein x and y may each be any natural number. For example, "$C_1$-$C_6$" means that the number of carbon atoms constituting a substituent ranges from 1 to 6, and "$C_6$-$C_{20}$" means that the number of carbon atoms constituting a substituent ranges from 6 to 20.

The term "monovalent hydrocarbon group" as used herein may refer to a monovalent residue derived from an organic compound containing carbon and hydrogen, or a derivative thereof. Specific examples of monovalent hydrocarbon groups may include: linear or branched alkyl groups (e.g., methyl group, ethyl group, propyl group, isopropyl group, butyl group, isobutyl group, sec-butyl group, tert-butyl group, pentyl group, neopentyl group, hexyl group, heptyl group, 2-ethylhexyl group and nonyl group); monovalent saturated cycloaliphatic hydrocarbon groups (cycloalkyl group) (e.g., cyclopentyl group, cyclohexyl group, cyclopentylmethyl group, cyclopentylethyl group, cyclopentylbutyl group, cyclohexylmethyl group, cyclohexylethyl group, cyclohexylbutyl group, 1-adamantyl group, 2-adamantyl group, 1-adamantylmethyl group, norbornyl group, norbornylmethyl group, tricyclodecanyl group, tetracyclododecanyl group, tetracyclododecanylmethyl group, and dicyclohexylmethyl group); monovalent unsaturated aliphatic hydrocarbon groups (alkenyl groups, alkynyl groups) (e.g., allyl groups); monovalent unsaturated cycloaliphatic hydrocarbon groups (cycloalkenyl groups) (e.g., 3-cyclohexenyl); aryl groups (e.g., phenyl group, 1-naphthyl group, and 2-naphthyl group); arylalkyl groups (e.g., benzyl group and diphenylmethyl group); heteroatom-containing monovalent hydrocarbon groups (e.g., tetrahydrofuranyl group, methoxymethyl group, ethoxymethyl group, methylthiomethyl group, acetamidemethyl group, trifluoroethyl group, (2-methoxyethoxy)methyl group, acetoxymethyl group, 2-carboxy-1-cyclohexyl group, 2-oxopropyl group, 4-oxo-1-adamantyl group, and 3-oxocyclohexyl group), or any combination thereof. In addition, in these groups, some hydrogen atoms may be substituted with one or more heteroatoms, for example, an oxygen atom-containing moiety, a sulfur atom-containing moiety, a nitrogen atom-containing moiety, or a halogen atom-containing moiety; or some carbon atoms may be substituted with one or more heteroatoms, for example, an oxygen atom-containing moiety, a sulfur atom-containing moiety, a nitrogen atom-containing moiety. Therefore, these groups may contain a hydroxy group, a cyano group, a carbonyl group, a carboxyl group, an ether bond, an ester bond, a sulfonate ester bond, a carbonate, a lactone ring, a sultone ring, a carboxylic acid anhydride moiety or a haloalkyl moiety.

The term "divalent hydrocarbon group" as used herein refers to a divalent residue, in which one of hydrogen atoms in the monovalent hydrocarbon groups is replaced with a binding site with a neighboring atom. Examples of the divalent hydrocarbon group may include a linear or branched alkylene group, a cycloalkylene group, an alkenylene group, an alkynylene group, a cycloalkylene group, an arylene group, and any one of the aforementioned groups having some of carbon atoms thereof replaced with heteroatoms, and the like. The term "alkyl group" as used herein refers to a linear or branched saturated aliphatic hydrocarbon monovalent group, and as specific examples may include a methyl group, an ethyl group, a propyl group, an iso-butyl group, a sec-butyl group, a tert-butyl group, a pentyl group, an isoamyl group, a hexyl group, and the like. The term "alkylene group" as used herein refers to a linear or branched saturated aliphatic divalent hydrocarbon group, and as specific examples may include a methylene group, an ethylene group, a propylene group, a butylene group, an isobutylene group, and the like.

The term "halogenated alkyl group" as used herein refers to an alkyl group of which at least one hydrogen atom is substituted with a halogen, and as specific examples, may include $CF_3$ and the like.

The term "alkoxy group" as used herein refers to a monovalent group having the formula of $-OA_{101}$ wherein $A_{101}$ is an alkyl group. Specific examples thereof may include a methoxy group, an ethoxy group, an isopropyloxy group, and the like.

The term "alkylthio group" as used herein refers to a monovalent group having the formula of $-SA_{101}$ wherein $A_{101}$ is an alkyl group.

The term "halogenated alkoxy group" as used herein refers to an alkoxy group of which at least one hydrogen atom is substituted with a halogen, and as specific examples, may include $-OCF_3$ and the like.

The term "halogenated alkylthio group" as used herein refers to an alkylthio group of which at least one hydrogen atom is substituted with a halogen, and as specific examples, may include $-SCF_3$ and the like.

The term "cycloalkyl group" as used herein refers to a monovalent saturated cyclic hydrocarbon group and as specific examples, include monocyclic groups such as a cyclopropyl group, a cyclobutyl group, a cyclopentyl group, a cyclohexyl group, and a cycloheptyl group; and condensed polycyclic aromatic groups such as an adamantyl group, a norbornyl group, and the like. The term "cycloalkylene group" as used herein refers to a divalent saturated cyclic hydrocarbon group and as specific examples, include a cyclopentylene group, a cyclohexylene group, an adamantylene group, an adamantylmethylene group, a norbornylene group, a norbornylmethylene group, a tricyclodecanylene group, a tetracyclododecanylene group, a tetracyclododecanylmethylene group, a dicyclohexylmethylene group, and the like.

The term "cycloalkoxy group" as used herein refers to a monovalent group having the formula of $-OA_{102}$ wherein $A_{102}$ is a cycloalkyl group. Specific examples of cycloalkoxy group may include a cyclopropoxy group, a cyclobutoxy group, and the like.

The term "cycloalkylthio group" as used herein refers to a monovalent group having the formula of $-SA_{102}$ wherein $A_{102}$ is a cycloalkyl group.

The term "heterocycloalkyl group" as used herein as used herein refers to a group having one or more carbon atoms in the cycloalkyl groups replaced by heteroatoms, e.g., moieties containing oxygen, sulfur, or nitrogen. Heterocycloalkyl groups may contain, in particular, an ether bond, an ester bond, a sulfonate ester bond, a carbonate, a lactone ring, a sultone ring, or a carboxylic anhydride moiety. The term "heterocycloalkylene group" as used herein refers to a group having one or more carbon atoms in the cycloalkylene groups replaced by moieties containing oxygen, sulfur, or nitrogen, for example.

The term "heterocycloalkoxy group" as used herein refers to a monovalent group having the formula of $-OA_{103}$ wherein $A_{103}$ is a heterocycloalkyl group.

The term "alkenyl" as used herein as used herein refers to a monovalent group of a linear or branched unsaturated aliphatic hydrocarbon group containing one or more carbon-carbon double bonds. The term "alkenylene group" as used herein refers to a divalent group of a linear or branched unsaturated aliphatic hydrocarbon group containing one or more

carbon-carbon double bonds.

The term "alkenyloxy group" as used herein refers to a monovalent group having the formula of $-OA_{104}$ wherein $A_{104}$ is an alkenyl group.

The term "cycloalkenyl group" as used herein refers to an unsaturated monovalent hydrocarbon cyclic group containing one or more carbon-carbon double bonds. The term "cycloalkenylene group" as used herein refers to an unsaturated divalent hydrocarbon cyclic group containing one or more carbon-carbon double bonds.

The term "cycloalkenyloxy group" as used herein refers to a monovalent group having the formula of $-OA_{105}$ wherein $A_{105}$ is a cycloalkenyl group.

The term "heterocycloalkenyl group" as used herein refers to a hydrocarbon group formed when some of carbon atoms in the cycloalkenyl groups are replaced by moieties containing one or more heteroatoms, such as oxygen, sulfur, or nitrogen for example. The term "heterocycloalkenylene group" as used herein refers to a hydrocarbon group formed when some of carbon atoms in the cycloalkenylene groups are replaced by moieties containing one or more heteroatoms, such as oxygen, sulfur, or nitrogen for example.

The term "heterocycloalkenyloxy group" as used herein refers to a monovalent group having the formula of $-OA_{106}$ wherein $A_{106}$ is a heterocycloalkenyl group.

The term "alkynyl group" as used herein refers to a monovalent group of a linear or branched unsaturated aliphatic hydrocarbon group containing one or more carbon-carbon triple bonds.

The term "alkynyloxy group" as used herein refers to a monovalent group having the formula of $-OA_{107}$ wherein $A_{107}$ is an alkynyl group.

The term "aryl group" as used herein refers to a monovalent group having a carbocyclic aromatic system, and as specific examples, may include a phenyl group, a naphthyl group, an anthracenyl group, a phenanthrenyl group, a pyrenyl group, a chrysenyl group, and the like.

The term "aryloxy group" as used herein refers to a monovalent group having the formula of $-OA_{108}$ wherein $A_{108}$ is an aryl group.

The term "heteroaryl group" as used herein refers to a monovalent group having a heterocyclic aromatic system and includes, as specific examples, a pyridinyl group, a pyrimidinyl group, a pyrazinyl group, and the like. The term "heteroarylene group" as used herein refers to a divalent group having a heterocyclic aromatic system.

The term "heteroaryloxy group" as used herein refers to a monovalent group having the formula of $-OA_{109}$ wherein $A_{109}$ is a heteroaryl group.

As used herein, when a definition is not otherwise provided, "substituted" refers to replacement of hydrogen of a compound by a substituent of a halogen, a hydroxy group, a nitro group, a cyano group, an amino group, an azido group, an amidino group, a hydrazino group, a hydrazono group, a carbonyl group, a carbamyl group, a thiol group, an ester group, a carboxyl group or a salt thereof, a sulfonic acid group or a salt thereof, a phosphoric acid or a salt thereof, a $C_1$ to $C_{30}$ alkyl group, a $C_2$ to $C_{30}$ alkenyl group, a $C_2$ to $C_{30}$ alkynyl group, a $C_6$ to $C_{30}$ aryl group, a $C_7$ to $C_{30}$ arylalkyl group, a $C_1$ to $C_{30}$ alkoxy group, a C1 to $C_{20}$ heteroalkyl group, a $C_3$ to $C_{20}$ heterocyclic group, a $C_3$ to $C_{20}$ heteroarylalkyl group, a $C_3$ to $C_{30}$ cycloalkyl group, a $C_3$ to $C_{15}$ cycloalkenyl group, a $C_6$ to $C_{15}$ cycloalkynyl group, a $C_3$ to $C_{30}$ heterocycloalkyl group, or any combination thereof.

As used herein, when a definition is not otherwise provided, "hetero" refers to one including 1 to 4 heteroatoms of N, O, S, Se, Te, Si, or P. As referred to herein, one or more heteroatoms may be N, O, S, Se, Te, Si, or P.

As used herein, when a definition is not otherwise provided, "aromatic ring" refers to a functional group in which all atoms in the cyclic functional group have a p-orbital, and wherein these p-orbitals are conjugated.

The term "substituent group" as used herein may include deuterium, a halogen, a hydroxyl group, a cyano group, a nitro group, a carbonyl group, a carboxylic acid group, an amino group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthiogroup, a $C_1$-$C_{20}$ halogenated alkoxy group, a $C_1$-$C_{20}$ halogenated alkylthiogroup, a $C_3$-$C_{20}$ cycloalkyl group, a $C_3$-$C_{20}$ cycloalkoxy group, a $C_3$-$C_{20}$ cycloalkylthiogroup, a $C_6$-$C_{20}$ aryl group, a $C_6$-$C_{20}$ aryloxy group, a $C_6$-$C_{20}$ arylthio group, a $C_1$-$C_{20}$ heteroaryl group, a $C_1$-$C_{20}$ heteroaryloxy group, or a $C_1$-$C_{20}$ heteroarylthio group; a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, a $C_6$-$C_{20}$ aryloxy group, a $C_6$-$C_{20}$ arylthio group, a $C_1$-$C_{20}$ heteroaryl group, a $C_1$-$C_{20}$ heteroaryloxy group, and a $C_1$-$C_{20}$ heteroarylthio group, substituted with any one from among deuterium, a halogen, a hydroxyl group, a cyano group, a nitro group, a carbonyl group, a carboxylic acid group, an amino group, an ether moiety, an ester moiety, a sulfonate ester moiety, a carbonate moiety, an amide moiety, a lactone moiety, a sultone moiety, a carboxylic anhydride moiety, a $C_1$-$C_{20}$ alkyl group, a $C_1$-$C_{20}$ halogenated alkyl group, a $C_1$-$C_{20}$ alkoxy group, a $C_1$-$C_{20}$ alkylthio group, a $C_1$-$C_{20}$ halogenated alkoxy group, a $C_1$-$C_{20}$ halogenated alkylthio group, a $C_3$-$C_{20}$ cycloalkyl group, a $C_3$-$C_{20}$ cycloalkoxy group, a $C_3$-$C_{20}$ cycloalkylthio group, a $C_6$-$C_{20}$ aryl group, a $C_6$-$C_{20}$ aryloxy group, a $C_6$-$C_{20}$ arylthio group, a $C_1$-$C_{20}$ heteroaryl group, a $C_1$-$C_{20}$ heteroaryloxy group, and a $C_1$-$C_{20}$ heteroarylthio group; or any combination thereof.

Hereinafter, some example embodiments will be described in detail with reference to the drawings, and in the description with reference to the drawings, substantially the same or corresponding components are given the same reference numerals, and the description of the identical components will not be repeated. In the drawings, the thicknesses of various layers and regions may be exaggerated for clarity. In addition, in the drawings, the thicknesses of some layers and regions may be exaggerated for convenience of description. In addition, the examples described below are provided for illustrative purposes only, and various modifications may be possible from such examples.

**[Resist Composition-Containing Polymer]**

A resist composition according to some example embodiments may include an organometallic compound represented by Formula 1 below; and a polymer including a repeating unit containing a radical generating group, a repeating unit containing a radical accepting group, or any combination thereof:

Formula 1 $Sn(Rn_{11})_n(OR_{12})_{(4-n)}$

In Formula 1,

$R_{11}$ may be a linear, branched or cyclic $C_1$-$C_{30}$ monovalent hydrocarbon group optionally containing one or more heteroatoms,
$R_{12}$ may be a linear, branched or cyclic $C_1$-$C_{30}$ monovalent hydrocarbon group optionally containing one or more heteroatoms, or *-$Sn(R_{13})_m(OR_{14})_{(3-m)}$,
n may be an integer from 1 to 4,
$R_{13}$ and $R_{14}$ may be each independently a linear, branched or cyclic $C_1$-$C_{30}$ monovalent hydrocarbon group optionally containing one or more heteroatoms,
m may be an integer from 0 to 3, and
* may be a binding site with a neighboring atom. In some example embodiments of Formula 1 where $R_{12}$ is *-$Sn(R_{13})_m(OR_{14})_{(3-m)}$, * of *-$Sn(R_{13})_m(OR_{14})_{(3-m)}$ is a binding site with a neighboring atom of Formula 1.

The organometallic compound may have a molecular weight of about 3,000 g/mol or less, more specifically, a molecular weight of about 100 g/mol or more to about 1,000 g/mol or less. The organometallic compound may not be a polymer and distinguished from a polymer in which one repeating unit of the polymer contains a metal.

In Formula 1, the bond between Sn and $R_{11}$ may be a Sn-carbon(C) single bond, and the bond between Sn and $R_{13}$ may be a Sn-C single bond. In the organometallic compound, the bond between Sn and $R_{12}$, and between Sn and $R_{14}$ may be linked by an oxygen atom, and carbon atoms included in $R_{11}$ and $R_{13}$ may bind to Sn and Sn, respectively.

For example, in Formula 1, when $R_{11}$ and $R_{13}$ may each independently be represented by *-$(L_{11})_{a11}$-$X_{11}$, and/or

$R_{12}$ and $R_{14}$ may each independently be represented by *-$(L_{12})_{a12}$-$X_{12}$,
$L_{11}$ and $L_{12}$ may be each independently $CR_aR_b$, C=O, S=O, $SO_2$, $PO_2$, or $PO_3$,
a11 and a12 may be each independently an integer from 0 to 3,
$X_{11}$ and $X_{12}$ may each independently be an unsubstituted or substituted $C_1$-$C_{30}$ alkyl group, an unsubstituted or substituted $C_1$-$C_{30}$ halogenated alkyl group, an unsubstituted or substituted $C_1$-$C_{30}$ alkoxy group, an unsubstituted or substituted $C_1$-$C_{30}$ alkylthio group, an unsubstituted or substituted $C_1$-$C_{30}$ halogenated alkoxy group, an unsubstituted or substituted $C_1$-$C_{30}$ halogenated alkylthio group, an unsubstituted or substituted $C_3$-$C_{30}$ cycloalkyl group, an unsubstituted or substituted $C_3$-$C_{30}$ cycloalkoxy group, an unsubstituted or substituted $C_3$-$C_{30}$ cycloalkylthio group, an unsubstituted or substituted $C_3$-$C_{30}$ heterocycloalkyl group, an unsubstituted or substituted $C_3$-$C_{30}$ heterocycloalkoxy group, an unsubstituted or substituted $C_3$-$C_{30}$ heterocycloalkylthio group, an unsubstituted or substituted $C_2$-$C_{30}$ alkenyl group, an unsubstituted or substituted $C_2$-$C_{30}$ alkenyloxy group, an unsubstituted or substituted $C_2$-$C_{30}$ alkenylthio group, an unsubstituted or substituted $C_3$-$C_{30}$ cycloalkenyl group, an unsubstituted or substituted $C_3$-$C_{30}$ cycloalkenyloxy group, an unsubstituted or substituted $C_3$-$C_{30}$ cycloalkenylthio group, an unsubstituted or substituted $C_3$-$C_{30}$ heterocycloalkenyl group, an unsubstituted or substituted $C_3$-$C_{30}$ heterocycloalkenyloxy group, an unsubstituted or substituted $C_3$-$C_{30}$ heterocycloalkenylthio group, an unsubstituted or substituted $C_2$-$C_{30}$ alkynyl group, an unsubstituted or substituted $C_2$-$C_{30}$ alkynyloxy group, an unsubstituted or substituted $C_2$-$C_{30}$ alkynylthio group, an unsubstituted or substituted $C_6$-$C_{30}$aryl group, an unsubstituted or substituted $C_6$-$C_{30}$ aryloxy group, an unsubstituted or substituted $C_6$-$C_{30}$ arylthio group, an unsubstituted or substituted $C_1$-$C_{30}$ heteroaryl group, an unsubstituted or substituted $C_1$-$C_{30}$ heteroaryloxy group, or an unsubstituted or substituted $C_1$-$C_{30}$ heteroarylthio group,
$R_a$ and $R_b$ may each independently be hydrogen, deuterium, a hydroxyl group, a cyano group, a nitro group, an unsubstituted or substituted $C_1$-$C_{30}$ alkyl group, an unsubstituted or substituted $C_1$-$C_{30}$ alkoxy group, an unsubstituted

or substituted $C_1$-$C_{30}$ alkylthio group, an unsubstituted or substituted $C_3$-$C_{30}$ cycloalkyl group, an unsubstituted or substituted $C_3$-$C_{30}$ cycloalkoxy group, or an unsubstituted or substituted $C_3$-$C_{30}$ cycloalkylthio group,

* may be a binding site with a neighboring atom (e.g., a neighboring atom of Formula 1). In some example embodiments, in Formula 1, $R_{11}$ is represented by *-$(L_{11})_{a11}$-$X_{11}$, and $R_{12}$ is represented by *-$(L_{12})_{a12}$-$X_{12}$, where a11, a12, $X_{11}$, $X_{12}$, and * are the same as described above.

In some example embodiments, $L_{11}$ may be $CR_aR_b$ or C=O, and $L_{12}$ may be C=O, S=O, $SO_2$, $PO_2$, $PO_3$, or $NO_2$.

In some example embodiments, $X_{11}$ and $X_{12}$ may each independently be an unsubstituted or substituted $C_1$-$C_{30}$ alkyl group, an unsubstituted or substituted $C_1$-$C_{30}$ alkoxy group, an unsubstituted or substituted $C_6$-$C_{30}$ aryl group, an unsubstituted or substituted $C_6$-$C_{30}$ aryloxy group, an unsubstituted or substituted $C_1$-$C_{30}$ heteroaryl group, or an unsubstituted or substituted $C_1$-$C_{30}$ heteroaryloxy group.

In some example embodiments, $X_{11}$ and $X_{12}$ may each independently be a $C_1$-$C_{20}$ alkyl group unsubstituted or substituted with at least one from among deuterium, a halogen, a hydroxy group, a $C_1$-$C_6$ alkyl group, a $C_1$-$C_6$ halogenated alkyl group, a $C_1$-$C_6$ alkoxy group, a $C_1$-$C_6$ halogenated alkoxy group, $C_1$-$C_6$ halogenated alkylthio group, a $C_3$-$C_6$ cycloalkyl group, $C_3$-$C_6$ cycloalkoxy group, a $C_3$-$C_6$ cycloalkylthio group, and a $C_6$-$C_{10}$ aryl group; or a $C_6$-$C_{20}$ aryl group unsubstituted or substituted with at least one from among deuterium, a halogen, a hydroxy group, a $C_1$-$C_6$ alkyl group, a $C_1$-$C_6$ halogenated alkyl group, a $C_1$-$C_6$ alkoxy group, a $C_1$-$C_6$ halogenated alkoxy group, a $C_1$-$C_6$ halogenated alkylthio group, a $C_3$-$C_6$ cycloalkyl group, a $C_3$-$C_6$ cycloalkoxy group, a $C_3$-$C_6$ cycloalkylthio group, and a $C_6$-$C_{10}$ aryl group.

In some example embodiments, $L_{11}$ may be $CR_aR_b$ or C=O,

$L_{12}$ may be C=O, S=O, $SO_2$, $PO_2$, $PO_3$, or $NO_2$,

a11 and a12 may be each independently 0 or 1, and

In some example embodiments, $X_{11}$ and $X_{12}$ may each independently be a $C_1$-$C_{20}$ alkyl group unsubstituted or substituted with at least one from among deuterium, a halogen, a hydroxy group, a $C_1$-$C_6$ alkyl group, a $C_1$-$C_6$ halogenated alkyl group, a $C_1$-$C_6$ alkoxy group, a $C_1$-$C_6$ halogenated alkoxy group, $C_1$-$C_6$ halogenated alkylthio group, a $C_3$-$C_6$ cycloalkyl group, a $C_3$-$C_6$ cycloalkoxy group, a $C_3$-$C_6$ cycloalkylthio group, and a $C_6$-$C_{10}$ aryl group; or a $C_6$-$C_{20}$ aryl group unsubstituted or substituted with at least one from among deuterium, a halogen, a hydroxy group, a $C_1$-$C_6$ alkyl group, a $C_1$-$C_6$ halogenated alkyl group, a $C_1$-$C_6$ alkoxy group, a $C_1$-$C_6$ halogenated alkoxy group, a $C_1$-$C_6$ halogenated alkylthio group, a $C_3$-$C_6$ cycloalkyl group, a $C_3$-$C_6$ cycloalkoxy group, a $C_3$-$C_6$ cycloalkylthio group, and a $C_6$-$C_{10}$ aryl group.

In particular, the organometallic compound may be represented by any one of Formulas 1-1 to 1-16:

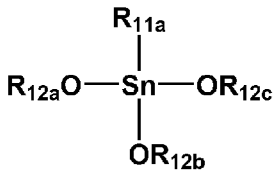
1-1

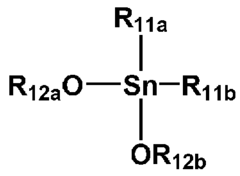
1-2

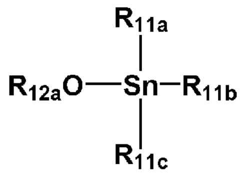
1-3

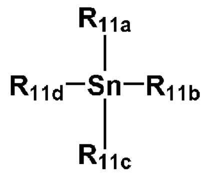
1-4

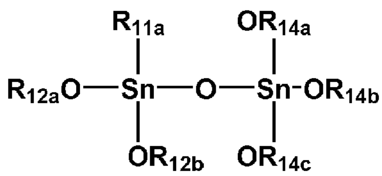
1-5

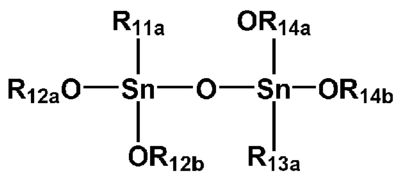
1-6

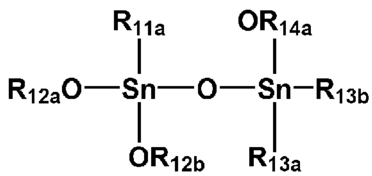
1-7

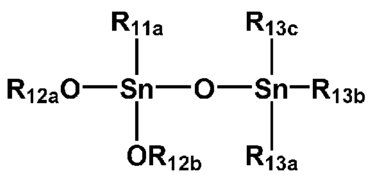
1-8

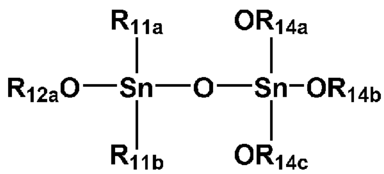
1-9

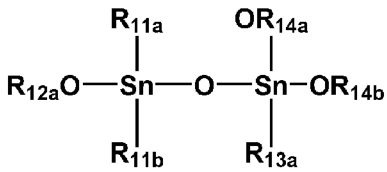
1-10

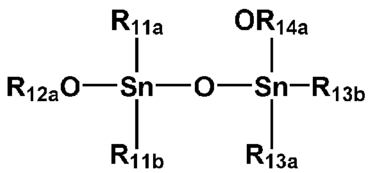
1-11

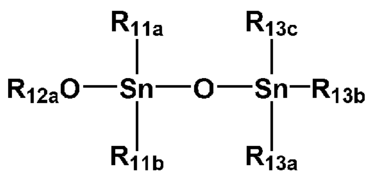
1-12

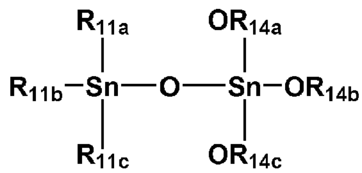
1-13

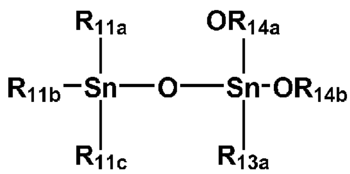
1-14

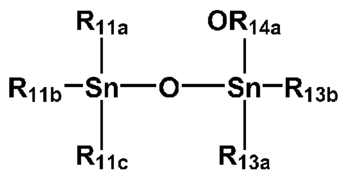
1-15

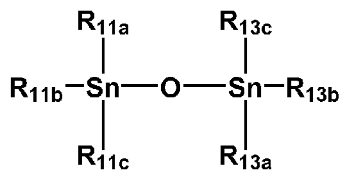
1-16

In Formulas 1-1 to 1-16,

$R_{11a}$ to $R_{11d}$ may be the same as defined with respect to $R_{11}$ in Formula 1 above,
$R_{12a}$ to $R_{12c}$ may be the same as defined with respect to $R_{12}$ in Formula 1 above,
$R_{13a}$ to $R_{13c}$ may be the same as defined with respect to $R_{13}$ in Formula 1 above, and
$R_{14a}$ to $R_{14c}$ may be the same as defined with respect to $R_{14}$ in Formula 1 above.

For example, in Formulas 1-1 to 1-16, $R_{11a}$ to $R_{11d}$ may each independently be a linear, branched or cyclic $C_1$-$C_{30}$ monovalent hydrocarbon group optionally containing one or more heteroatoms, $R_{12a}$ to $R_{12c}$ may each independently be a linear, branched or cyclic $C_1$-$C_{30}$ monovalent hydrocarbon group optionally containing one or more heteroatoms, or $*\text{-}Sn(R_{13})_m(OR_{14})_{(3-m)}$, where $R_{13}$ and $R_{14}$ are each independently a linear, branched or cyclic $C_1$-$C_{30}$ monovalent hydrocarbon group optionally containing one or more heteroatoms, m is an integer from 0 to 3, and * is a binding site with a neighboring atom, $R_{13a}$ to $R_{13c}$ may each independently be a linear, branched or cyclic $C_1$-$C_{30}$ monovalent hydrocarbon group optionally containing one or more heteroatoms, and $R_{14a}$ to $R_{14c}$ may each independently be a linear, branched or cyclic $C_1$-$C_{30}$ monovalent hydrocarbon group optionally containing one or more heteroatoms.
More specifically, the organometallic compound may be represented by any one of Formulas 1-1 to 1-4.
In particular, the organometallic compound may be selected from Group I.

Group I

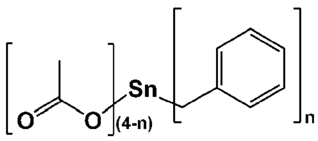
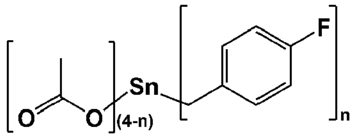
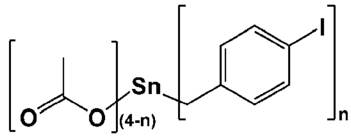

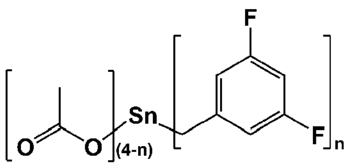
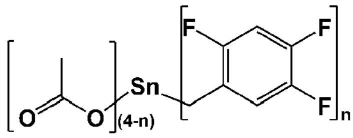
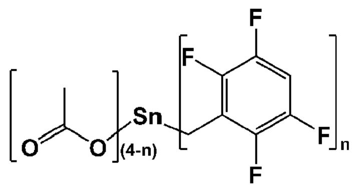

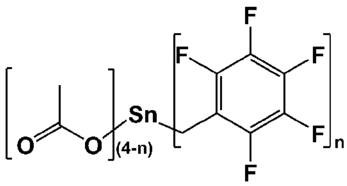
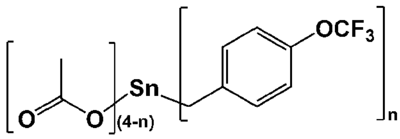
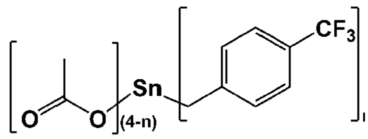

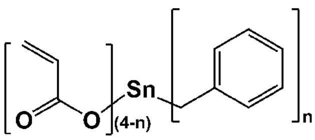
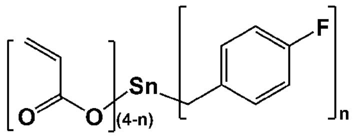
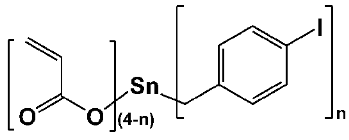
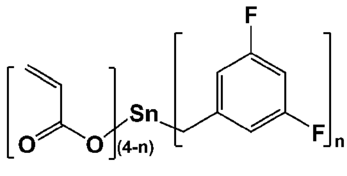
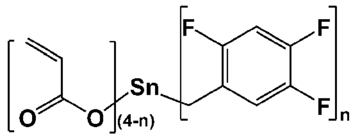
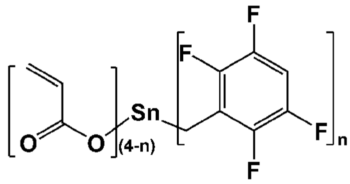
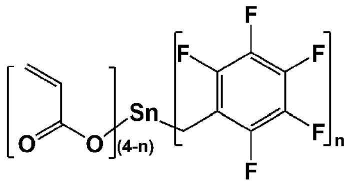
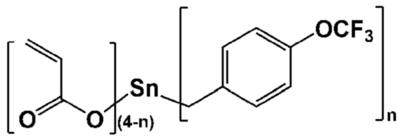
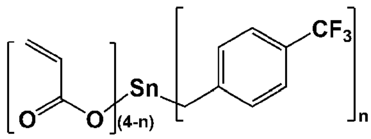
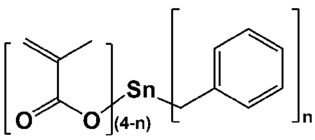
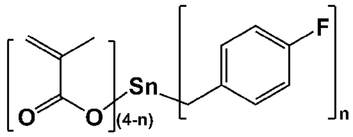
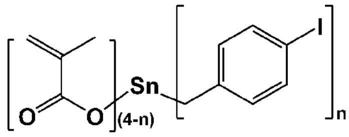
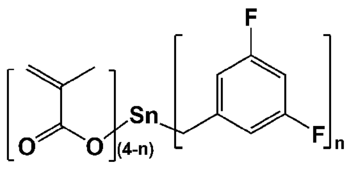
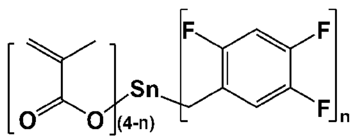
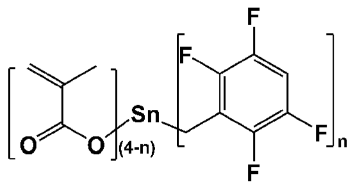
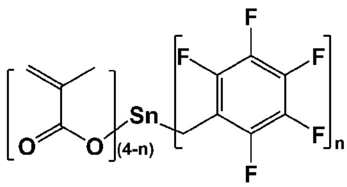
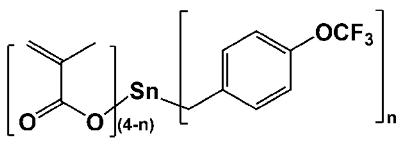
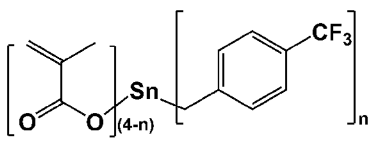

In Group I, n may be an integer from 1 to 4.

For example, in Group I, n may be 2.

The polymer may not substantially contain repeating unit whose structure changes by an acid. For example, the polymer may not include any repeating unit of which structure is changed by an acid. Here, the repeating unit whose structure changes by an acid refers to a repeating unit including an acid-labile group. Accordingly, the polymer may not include any repeating unit that includes any acid labile group. The acid-labile group may refer to an ester group having a tertiary acyclic alkyl carbon, an ester group containing a tertiary alicyclic carbon, or a cyclic acetal, and the like. Acid-labile groups are released from the polymer by an acid and serve to allow the polymer to be more easily dissolved in a developer, for example, an aqueous TMAH solution, and the like.

The radical generating group may include a single bond between a carbon atom and X (C-X) or a single bond between a carbon atom and $X^+$ (C-$X^+$), wherein X may be a heteroatom other than a carbon atom and a hydrogen atom. For example, X may be a halogen, an oxygen atom, a sulfur atom, a selenium atom, a nitrogen atom, or a phosphorus atom. An unsubstituted or substituted $C_1$-$C_{30}$ aryl group or an unsubstituted or substituted $C_1$-$C_{30}$ heteroaryl group may

be bound adjacent to the carbon atom forming a single bond with X in the radical generating group. The carbon atom in the radical generating group may be a benzylic carbon atom at benzylic position.

In particular, the radical generating group may include a partial structure represented by Formula RG:

Formula RG

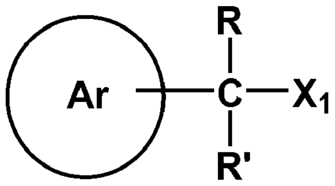

In Formula RG,

Ar may be an unsubstituted or substituted $C_1$-$C_{30}$ aryl group or an unsubstituted or substituted $C_1$-$C_{30}$ heteroaryl group,
R and R' may be each independently hydrogen, deuterium, a halogen, or a linear, branched or cyclic $C_1$-$C_{30}$ divalent hydrocarbon group optionally containing one or more heteroatoms, and
$X_1$ may be an electron withdrawing group.

For example, in Formula RG, $X_1$ may include at least one halogen, oxygen atom, sulfur atom, selenium atom, nitrogen atom, or phosphorus atom.

In particular, in Formula RG, $X_1$ may be an ammonium salt, a phosphonium salt, a sulfonium salt, a selenonium salt, an iodonium salt, a halogen, $R_{31}SO_3$, $R_{31}CO_2$, $R_{31}PO_2(OR_{32})$, or $NO_3$, and
$R_{31}$ and $R_{32}$ may be each independently a linear, branched or cyclic $C_1$-$C_{30}$ monovalent hydrocarbon group optionally containing one or more heteroatoms.

More specifically, in Formula RG, $X_1$may be a group represented by any one of Formulas 3-1 to 3-3 below, Cl, Br, I, $R_{31}SO_3$, $R_{31}CO_2$, $R_{31}PO_2(OR_{32})$, or $NO_3$, and
$R_{31}$ and $R_{32}$ may be each independently a linear, branched or cyclic $C_1$-$C_{30}$ monovalent hydrocarbon group optionally containing one or more heteroatoms:

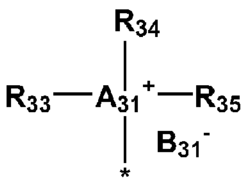

3-1

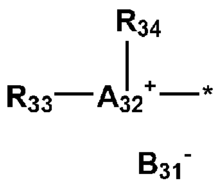

3-2

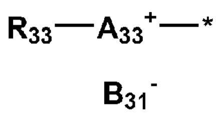

3-3

In Formulas 3-1 to 3-3,

$A_{31}$ may be N or P,
$A_{32}$ may be S or Se,
$A_{33}$ may be I,
$B_{31}^-$ may be a counter anion,
$R_{33}$ and $R_{35}$ may be a linear, branched or cyclic $C_1$-$C_{30}$ monovalent hydrocarbon group optionally containing one or more heteroatoms, and two adjacent groups of $R_{33}$ to $R_{35}$ may optionally bind together to form a ring, and
* may be a binding site with a neighboring atom.

For example, in Formulas 3-1 to 3-3, $B_{31}^-$ may be a halogen ion, $R_{36}SO_3^-$, $R_{36}CO_2^-$, $R_{36}PO_4^-$, $PF_6^-$, or $BF_4^-$, and $R_{36}$ may be a linear, branched or cyclic $C_1$-$C_{20}$ monovalent hydrocarbon optionally containing one or more heteroatoms.

The repeating unit containing a radical generating group may be presented by Formula 2-1 or 2-2:

Formula 2-1

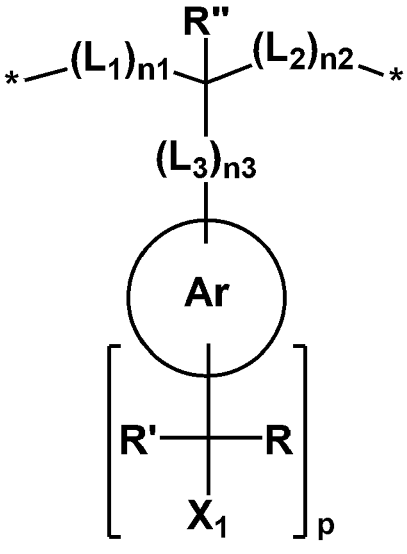

Formula 2-2

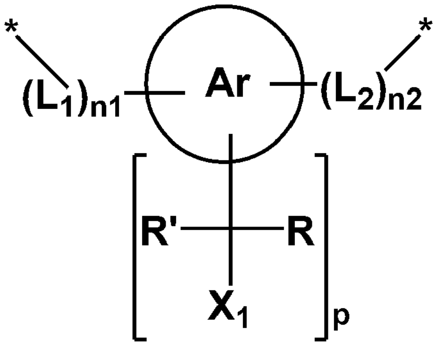

In Formulas 2-1 and 2-2,

Ar may be an unsubstituted or substituted $C_1$-$C_{30}$ aryl group or an unsubstituted or substituted $C_1$-$C_{30}$ heteroaryl group,
R, R', and R" may be each independently hydrogen, deuterium, a halogen, or a linear, branched or cyclic $C_1$-$C_{30}$ divalent hydrocarbon group optionally containing one or more heteroatoms,
$X_1$ may be an electron withdrawing group,
$L_1$ to $L_3$ may be each a single bond or a divalent linker,
n1 to n3 may be each independently an integer from 1 to 6,
p may be an integer from 1 to 5, and
* may be a binding site with a neighboring atom (e.g., a neighboring atom of a neighboring repeating unit of the polymer).

The divalent linker may be O, S, C(=O), C(=O)O, OC(=O), C(=O)NH, NHC(=O), a linear, branched or cyclic $C_1$-$C_{30}$ divalent hydrocarbon group optionally containing one or more heteroatoms, or any combination thereof.

When the repeating unit containing a radical generating group is represented by Formula 2-1, the radical generating group may be present in the side chain as a pendant group.

When the repeating unit containing a radical generating group is represented by Formula 2-2, at least a part of the radical generating group may constitute a part of the main chain.

The radical accepting group may include a lone-pair electron donating group and/or an electron donating group.

In particular, the lone-pair electron donating group may be an oxygen atom, a sulfur atom, a nitrogen atom, or a phosphorus atom. That is, the lone-pair electron donating group may contain an oxygen atom, a sulfur atom, a nitrogen atom, or a phosphorus atom as a partial structure.

In particular, the electron donating group may contain a single bond between a hydrogen atom and Z (Z-H bond) wherein Z is one or more heteroatoms other than a carbon atom and a hydrogen atom.

More particularly, the radical accepting group may include a partial structure represented by Formula RA1 or RA2 below:

Formula RA1

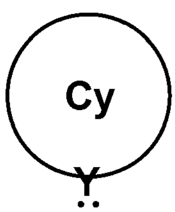

Formula RA2

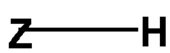

In Formulas RA1 and RA2,

Cy may be an unsubstituted or substituted $C_1$-$C_{30}$ carbocyclic group or an unsubstituted or substituted $C_1$-$C_{30}$ heterocyclic group,
Y may be an oxygen atom, a sulfur atom, a nitrogen atom, a phosphorus atom, S=O, P=O, or C=O,
Z may be an oxygen atom, a sulfur atom, a nitrogen atom, or a phosphorus atom, and
: may represent a lone-pair of electrons.

In Formula RA2, Z may include $NR_{31}$, $PR_{31}$, O, S, or any combination thereof, and $R_{31}$ may be hydrogen, deuterium, or a linear, branched or cyclic $C_1$-$C_{30}$ monovalent hydrocarbon group optionally containing one or more heteroatoms.
In Formula RA2, Z may be $NR_{31}$, $PR_{31}$, O, S, $CO_2$, $SO_3$, $PO_3H$, or $PO(OR_{31})O$.
In Formula RA2, Z may be NH, PH, O, S, $CO_2$, $SO_3$, or $PO_3H$.
The electron withdrawing group may be $NH_2$, $PH_2$, OH, SH, $CO_2H$, $SO_3H$, or $PO_3H_2$.
The repeating unit containing a radical accepting group may be represented by any one of Formulas 2-3 to 2-6 below:

Formula 2-3

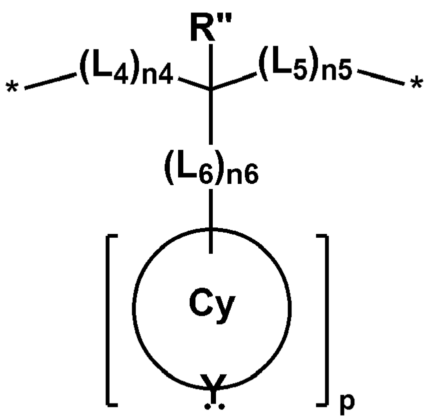

Formula 2-4

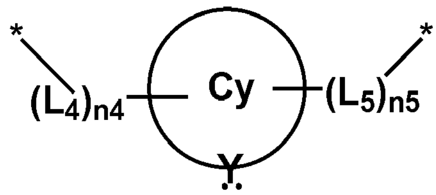

Formula 2-5

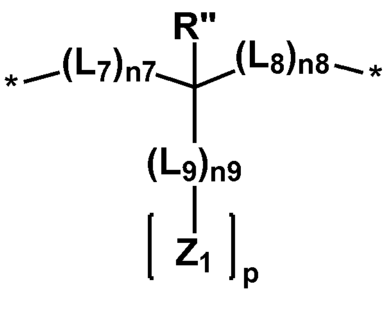

Formula 2-6

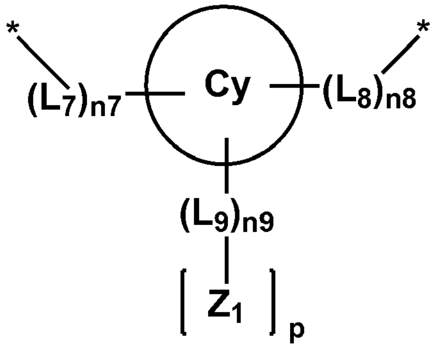

In Chemical Formulas 2-3 to 2-6,

Cy may be an unsubstituted or substituted $C_1$-$C_{30}$ carbocyclic group or an unsubstituted or substituted $C_1$-$C_{30}$ heterocyclic group,
Y may be an oxygen atom, a sulfur atom, a nitrogen atom, a phosphorus atom, S=O, P=O, or C=O,
: may represent a lone-pair of electrons,
$Z_1$ may be an electron donating group,
R" may be hydrogen, deuterium, a halogen, or a linear, branched or cyclic $C_1$-$C_{30}$ monovalent hydrocarbon group optionally containing one or more heteroatoms,
$L_4$ to $L_9$ may each be a single bond or a divalent linker,

n4 to n9 may each independently be an integer from 1 to 6,

p may be an integer from 1 to 5, and

* may be a binding site with a neighboring atom (e.g., a neighboring atom of a neighboring repeating unit of the polymer).

The divalent linker may be O, S, C(=O), C(=O)O, OC(=O), C(=O)NH, NHC(=O), a linear, branched or cyclic $C_1$-$C_{30}$ divalent hydrocarbon group optionally containing one or more heteroatoms, or any combination thereof.

In some example embodiments, the repeating unit containing a radical generating group, and the repeating unit containing a radical accepting group may be selected from Group II below:

Group II

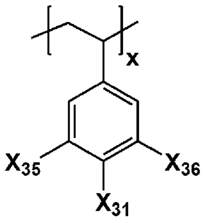
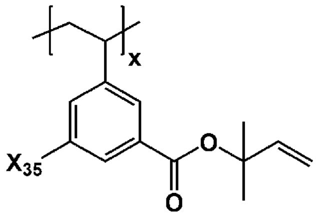
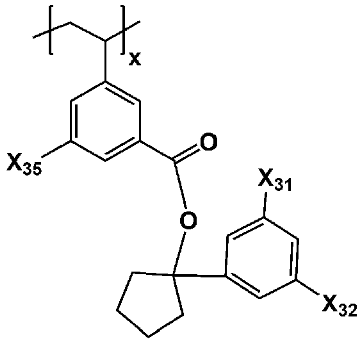
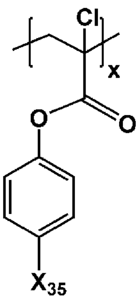

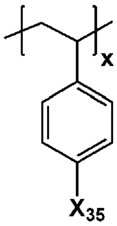
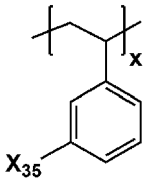
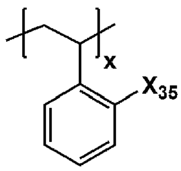

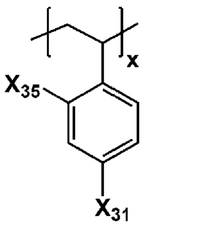
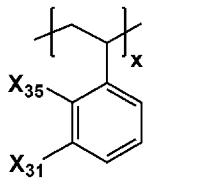
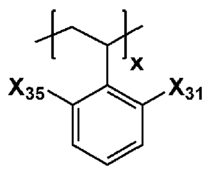
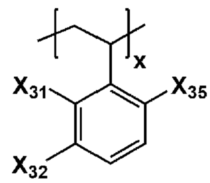
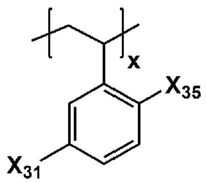
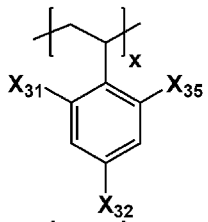
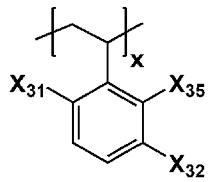
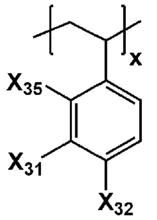
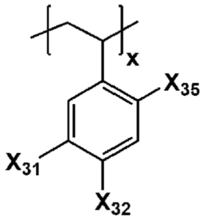
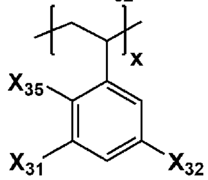
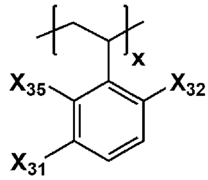
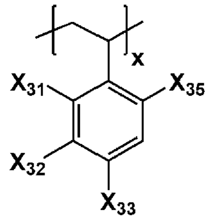
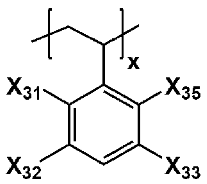
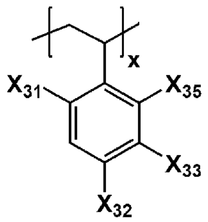
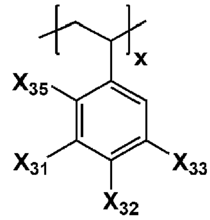
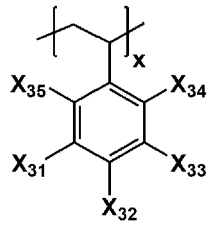
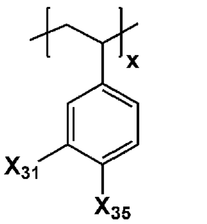
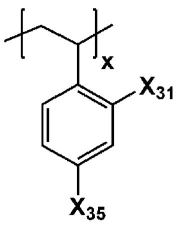
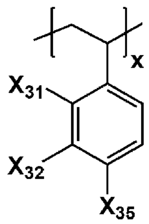
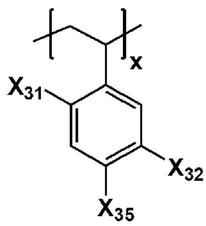
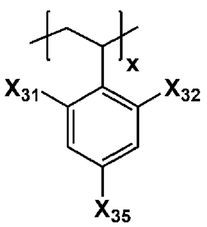
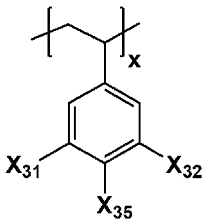
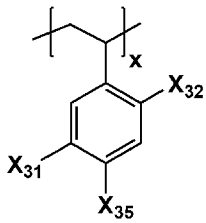
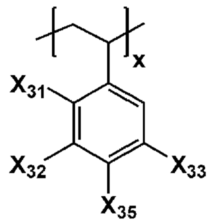
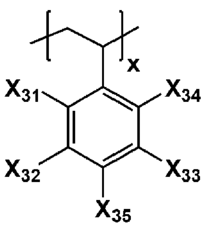

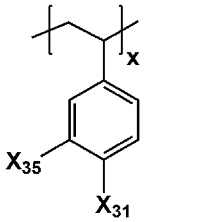
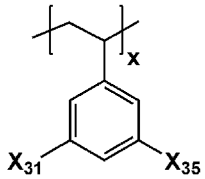
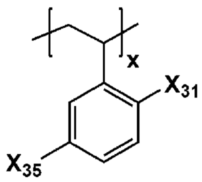
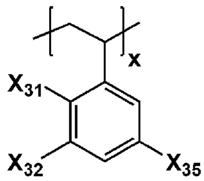

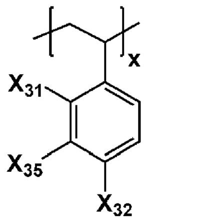
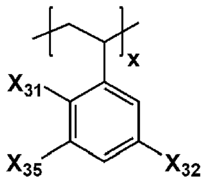
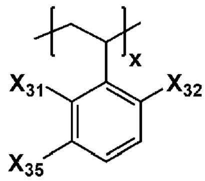
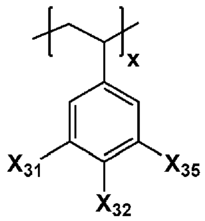

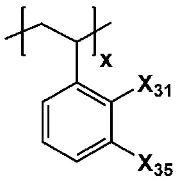
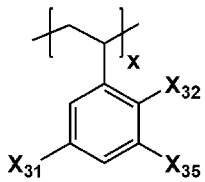
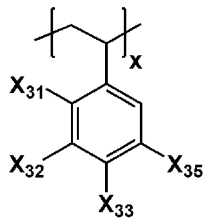
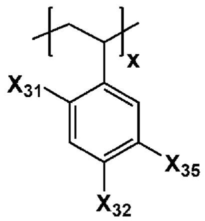

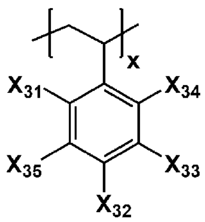
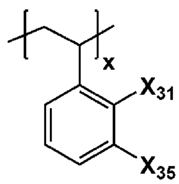
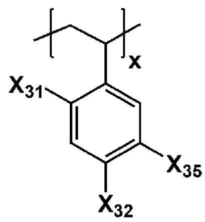

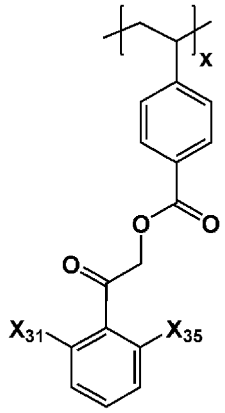

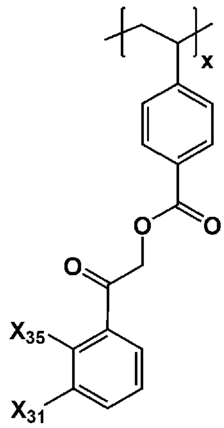

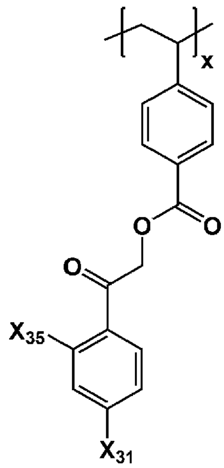

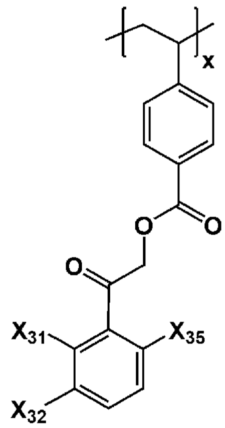

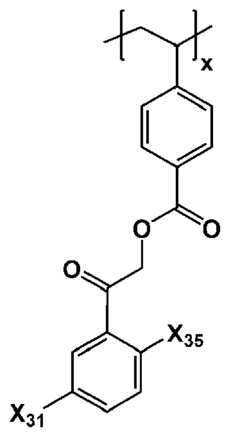

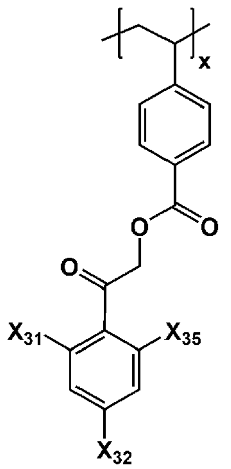

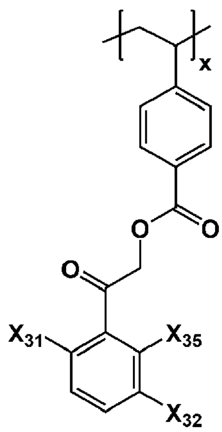

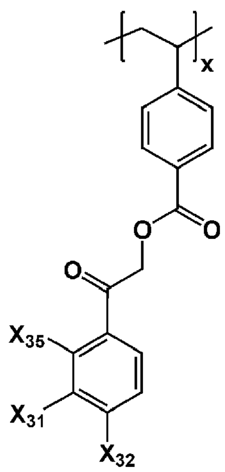

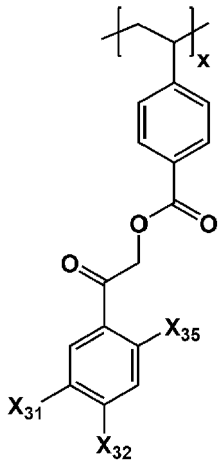
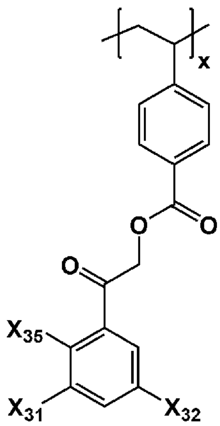
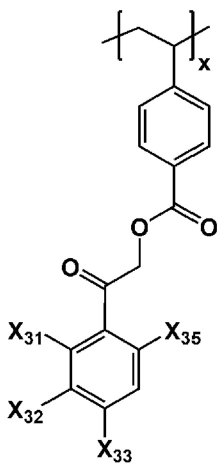
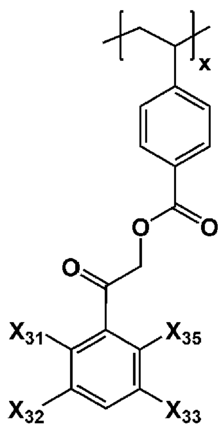

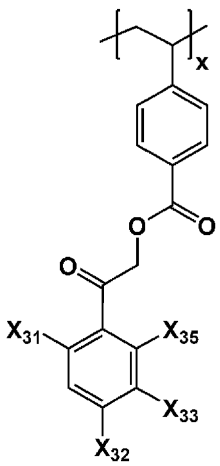
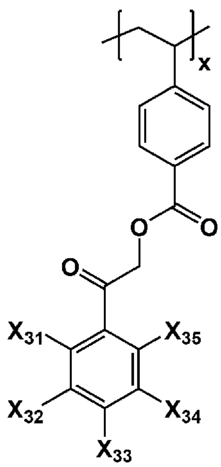

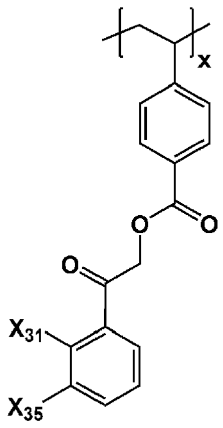
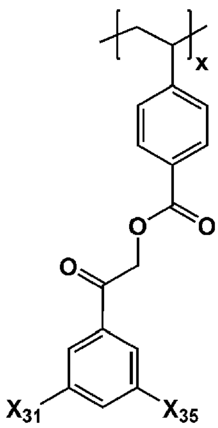
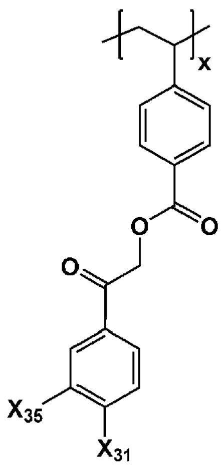
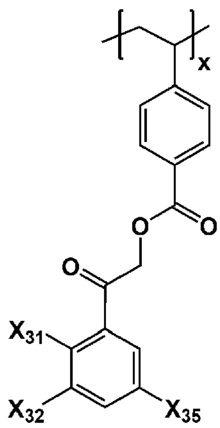

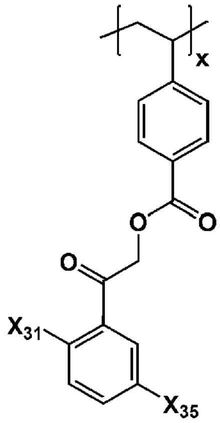
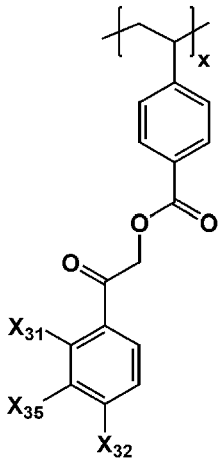
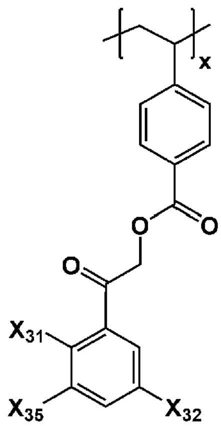
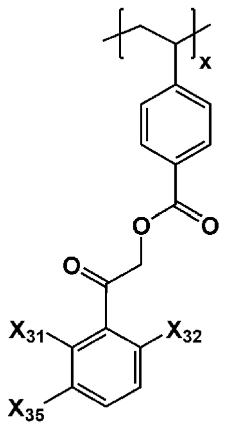

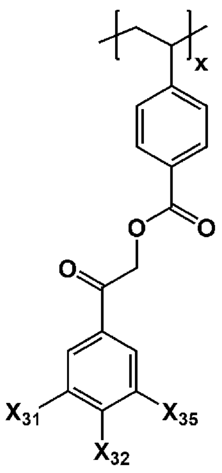

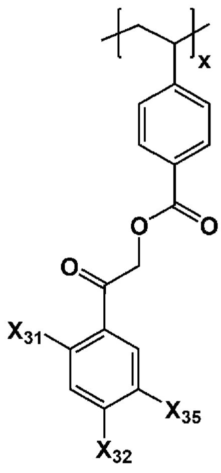

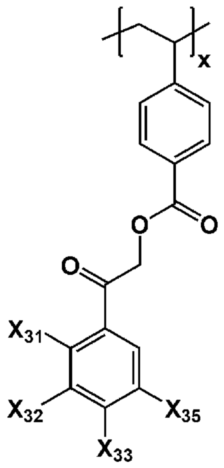

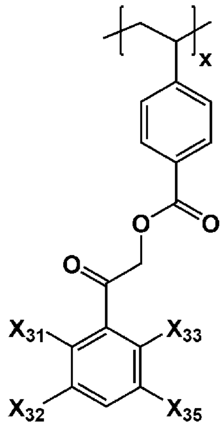

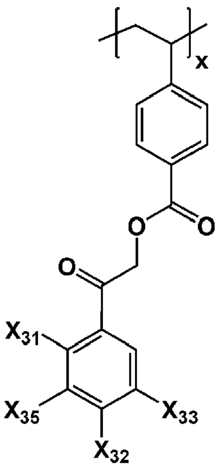

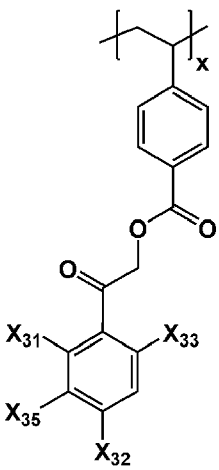

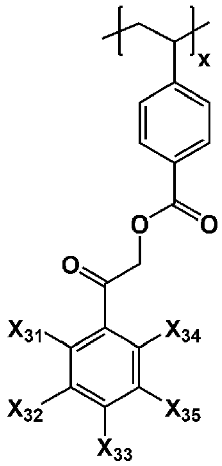

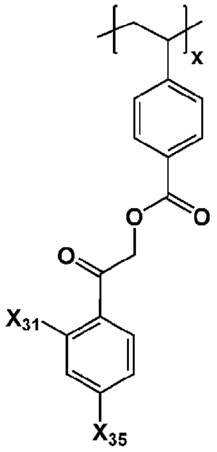
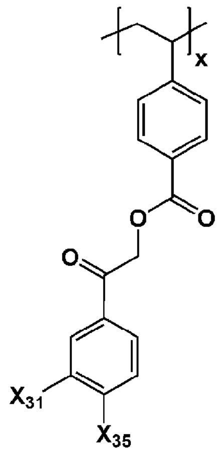
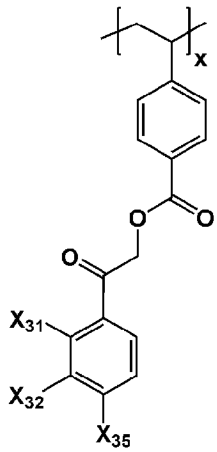
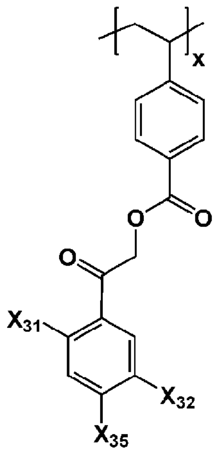

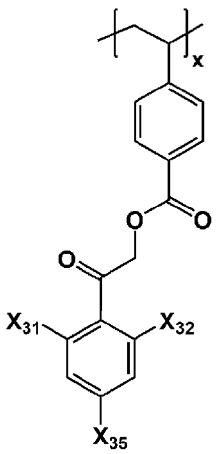
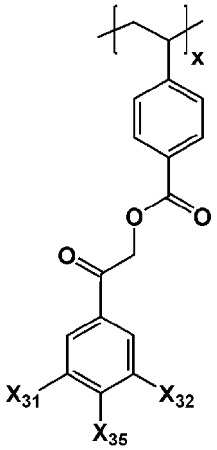
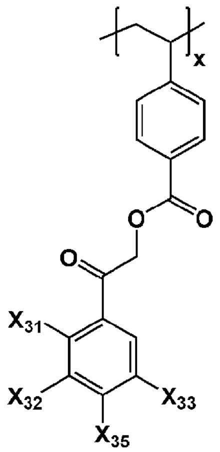
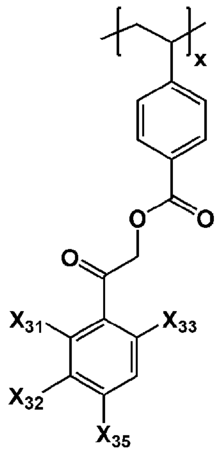

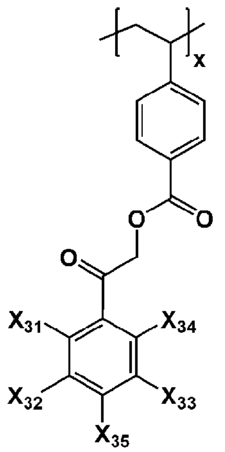
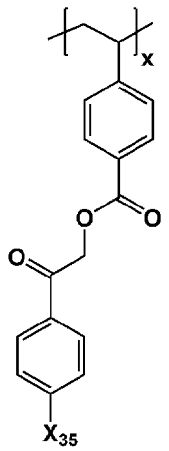
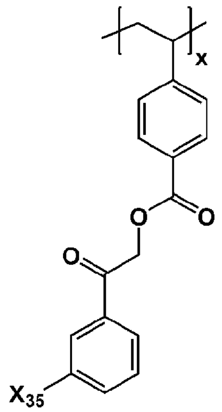
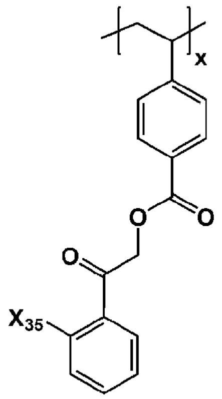

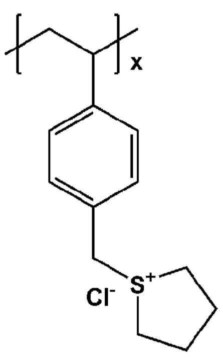
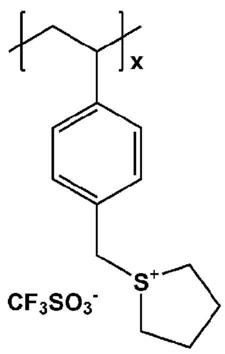
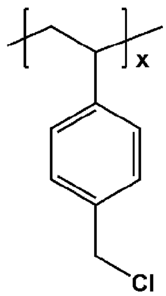

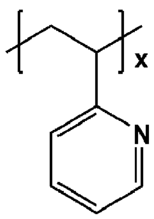
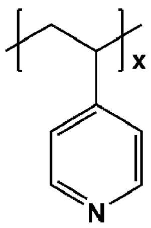
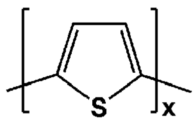
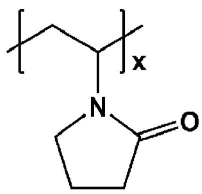

In Group II, $X_{31}$ to $X_{34}$ may each independently be F, I, or $CH_3$, and $X_{35}$ and $X_{36}$ may each independently be OH or $NH_2$, and x may be any integer.

In some example embodiments, the polymer may further include a repeating unit represented by Formula 4 below:

Formula 4

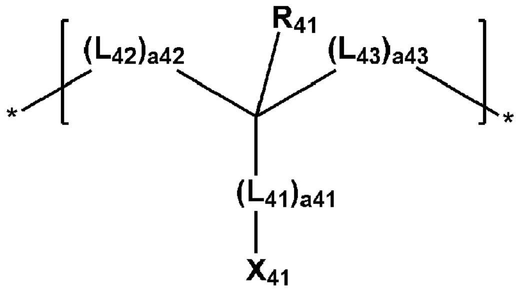

In Formula 4,

$R_{41}$ may be hydrogen, deuterium, a halogen, or a linear, branched or cyclic $C_1$-$C_{30}$ monovalent hydrocarbon group optionally containing one or more heteroatoms,

$L_{41}$ to $L_{43}$ may each independently be single bond, O, S, C(=O), C(=O)O, OC(=O), C(=O)NH, NHC(=O), a divalent group of a linear, branched or cyclic $C_1$-$C_{30}$ hydrocarbon optionally containing a heteroatom, or any combination thereof,

a41 to a43 may each independently be selected from among integers of 1 to 6,

$X_{41}$ may be a non-acid labile group, and

* may be a binding site with a neighboring atom (e.g., a neighboring atom of a neighboring repeating unit of the polymer).

Specifically, in Formula 4 above, $R_{41}$ may be the same as described with respect to $R_{21}$ in Formula 2 above.

Specifically, in Formula 4 above, $L_{41}$ to $L_{43}$ may be the same as described with respect to $L_{21}$ in Formula 2 above.

For example, in Formula 4, $X_{41}$ may be hydrogen or a linear, branched or cyclic $C_1$-$C_{20}$ monovalent hydrocarbon group containing at least one polar moiety selected from among a hydroxy group, a halogen, a cyano group, a carbonyl group, a carboxyl group, O, S, C(=O), C(=O)O, OC(=O), S(=O)O, OS(=O), a lactone ring, a sultone ring, and a carboxylic acid anhydride moiety.

In particular, $X_{41}$ in Formula 4 may be represented by any one of Formulas 5-1 to 5-5:

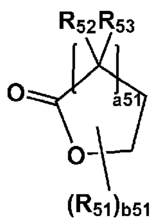
5-1

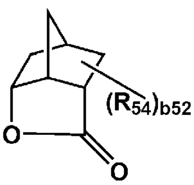
5-2

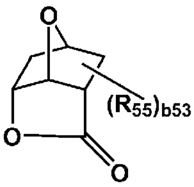
5-3

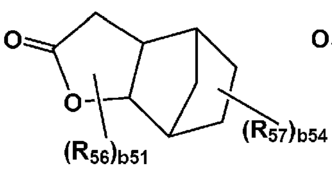
5-4

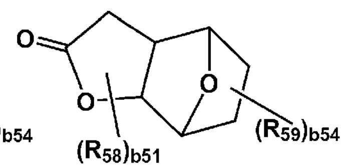
5-5

In Formulas 5-1 to 5-5,

a51 may be 1 or 2;
$R_{51}$ to $R_{59}$ may be each independently a binding site with a neighboring atom, hydrogen, a hydroxy group, a halogen, a cyano group, a $C_1$-$C_6$ alkyl group, a halogenated $C_1$-$C_6$ alkyl group, a $C_1$-$C_6$ alkoxy group, a $C_3$-$C_6$ cycloalkyl group, a $C_3$-$C_6$ cycloalkoxy group, or a $C_6$-$C_{10}$ aryl group;
one of $R_{51}$ to $R_{53}$, one of $R_{54}$, one of $R_{55}$, one of $R_{56}$ and $R_{57}$, and one of $R_{58}$ and $R_{59}$ may be a binding site with a neighboring atom,
b51 may be selected from among integers of 1 to 4;
b52 may be selected from among integers of 1 to 10; and
b53 and b54 may be each independently selected from among integers of 1 to 8.

In some example embodiments, the repeating unit represented by Formula 4 above may be represented by any one of Formulas 4-1 and 4-2 below:

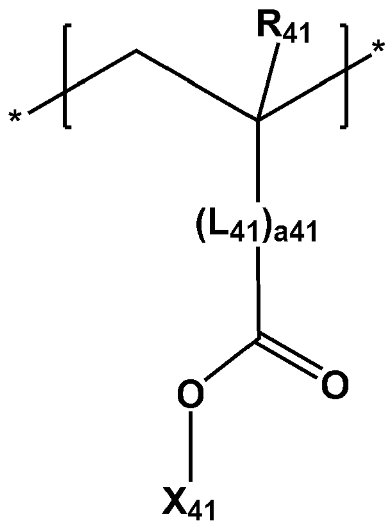

4-1

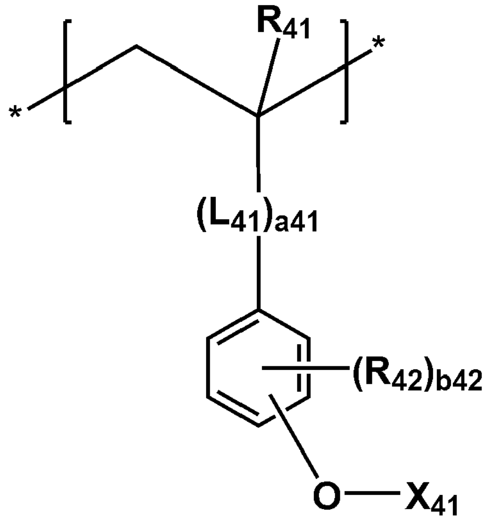

4-2

In Formulas 4-1 and 4-2,

$L_{41}$ and $X_{41}$ may be each the same as defined in Formula 4,
a41 may be selected from among integers of 1 to 4;
$R_{42}$ may be hydrogen or a linear, branched or cyclic $C_1$-$C_{20}$ monovalent hydrocarbon group,
b42 may be selected from among integers of 1 to 4; and
* may be a binding site with a neighboring atom e.g., a neighboring atom of a neighboring repeating unit of the polymer).

In some example embodiments, the polymer may consist of a repeating unit represented by Formula 1 above and a repeating unit represented by Formula 4 above. Specifically, the polymer may include about 1 mol% to about 90 mol% of the repeating unit represented by Formula 4 above and about 10 mol% to about 99 mol% of the repeating unit represented by Formula 1 above. More specifically, the polymer may include about 10 mol% to about 80 mol% of the repeating unit represented by Formula 4 above and about 20 mol% to about 90 mol% of the repeating unit represented by Formula 1 above.

The polymer may consist of one type of repeating unit alone, or may include two or more different types of repeating units.

In cases in which the polymer is a copolymer, the polymer may be a block copolymer or a random copolymer, for example.

The weight average molecular weight (Mw) of the polymer, as measured by gel permeation chromatography using a tetrahydrofuran solvent and a polystyrene standard, may be from about 1,000 to about 500,000, specifically, 2,000 or more, 3,000 or more, 200,000 or less, or 100,000 or less.

The polydispersity index (PDI: Mw/Mn) of the polymer may be from about 1.0 to about 3.0, specifically, from about 1.0 to about 2.0. Within the above ranges, control over dispersibility and/or compatibility of the polymer may be

facilitated, foreign materials may be less likely to remain on patterns, or degradations in pattern profiles may be minimized. Accordingly, the resist composition may be rendered more suitable for forming a micropattern. Accordingly, a resist pattern formed based on the resist composition (e.g., based on forming, exposing, and developing a resist film as described herein) may have reduced risk of defects while having improved miniaturization, and a device (e.g., semiconductor device, electronic device, etc.) manufactured based on the resist pattern may have improved reliability due to reduced defects in the resist pattern while also having improved miniaturization, compactness, or the like.

Without being limited to any particular theory, the organometallic compound may form radicals by heat and/or a high-energy ray. In particular, radicals may be generated from the Sn-C bonds in the organometallic compound, and the polymer may react with the radicals to form chemical bonds. Due to the chemical bonds, crosslinks may be formed at least between the organometallic compound and the polymer, and due to such chemical bonds, properties of the polymer, in particular, solubility in a developer, may change.

Since properties of the polymer can be changed by a high-energy ray, the resist composition may be usable for a non-chemically amplified resist composition.

Since the polymer, due to its relatively high resistance to oxygen and/or moisture, can change its properties only by a high-energy ray, the polymer may provide a resist composition with improved storage stability and the like. Accordingly, a resist pattern formed based on the resist composition (e.g., based on forming, exposing, and developing a resist film as described herein) may have reduced risk of defects while having improved miniaturization, and a device (e.g., semiconductor device, electronic device, etc.) manufactured based on the resist pattern may have improved reliability due to reduced defects in the resist pattern while also having improved miniaturization, compactness, or the like, based on using a resist composition having improved storage stability.

Since in the above polymer, it is the newly formed chemical bonds that induce a change in properties of the polymer, compared to a system that induces a change in properties by dissociation of a polymer backbone, a resist composition which can be patterned at a relatively lower dose of a high-energy ray may be provided. For example, energy expenditures associated with forming a resist pattern may be reduced due to using a low dose of high-energy rays, and thus a cost of manufacture of a resist pattern and/or a semiconductor device, electronic device, or the like based thereon may be reduced.

The polymer may be prepared by any suitable method. For example, the polymer may be prepared by dissolving unsaturated bond-containing monomer(s) in an organic solvent, followed by photo polymerization and/or thermal polymerization in the presence of a radical initiator.

The structure (composition) of the polymer may be identified by performing FT-IR analysis, NMR analysis, fluorescence X-ray (XRF) analysis, mass spectrometry, UV analysis, single crystal X-ray structure analysis, powder X-ray diffraction (PXRD) analysis, liquid chromatography (LC) analysis, size exclusion chromatography (SEC) analysis, thermal analysis, and the like. Specific methods of identification are as described in Examples.

The resist composition may change its solubility with respect to a developer by exposure to a high-energy ray. The resist composition may be a negative-type resist composition which forms a negative-type resist pattern by dissolution and removal of an unexposed portion of a resist film.

In addition, a resist composition according to some example embodiments may be for an alkaline development process that utilizes an alkaline developer for a development treatment during resist pattern formation, or may be for a solvent development process that utilizes a developer including an organic solvent (hereinafter referred to as an organic developer) in such a development treatment.

Since the resist composition is non-chemically amplified type, it may not substantially contain a photoacid generator.

Since properties of the polymer change by exposure, the resist composition may substantially not contain a compound of a molecular weight of about 1,000 or more, other than the polymer.

In the resist composition, the organometallic compound may be about 10 parts by weight to about 1,000 parts by weight, in particular, about 20 parts by weight to about 500 parts by weight with respect to 100 parts by weight of the polymer. When the above range is satisfied, sufficient chemical bonds may be formed between the organometallic compound and the polymer, thus providing a resist composition having improved sensitivity and/or resolution.

Since the polymer is described above, the following description will only concern organic solvents and optional components, which may be included as needed. In addition, the polymer used in the resist composition may be a single type of polymer, or a combination of two or more different types of polymers.

<Organic Solvent>

The resist composition may further include an organic solvent. The organic solvent included in the resist composition is not limited to any particular material and may be any organic solvent capable of dissolving or dispersing a polymer and optional components, etc. which may be included as necessary. The organic solvent may be a single type of organic solvent, or a combination of two or more different types of organic solvents. Alternatively, the organic solvent

may be a mixed solvent containing water and an organic solvent.

Examples of the organic solvent may include alcohol-based solvents, ether-based solvents, ketone-based solvents, amide-based solvents, ester-based solvents, sulfoxide-based solvents, hydrocarbon-based solvents, and the like.

More specifically, examples of the alcohol-based solvent may include: a monohydric alcohol-based solvent, such as methanol, ethanol, n-propanol, isopropanol, n-butanol, isobutanol, sec-butanol, tert-butanol, n-pentanol, isopentanol, 2-methylbutanol, sec-pentanol, tert-pentanol, 3-methoxybutanol, n-hexanol, 2-methylpentanol, sec-hexanol, 2-ethylbutanol, sec-heptanol, 3-heptanol, n-octanol, 2-ethylhexanol, sec-octanol, n-nonyl alcohol, 2,6-dimethyl-4-heptanol, n-decanol, sec-undecyl alcohol, trimethylnonyl alcohol, sec-tetradecyl alcohol, sec-heptadecyl alcohol, furfuryl alcohol, phenol, cyclohexanol, methylcyclohexanol, 3,3,5-trimethylcyclohexanol, benzyl alcohol, and diacetone alcohol; a polyhydric alcohol-based solvent, such as ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, and tripropylene glycol; and a polyhydric alcohol-containing ether-based solvent, such as ethylene glycol monomethyl ether, ethylene glycol monoethyl ether, ethylene glycol monopropyl ether, ethylene glycol monobutyl ether, ethylene glycol monohexyl ether, ethylene glycol monophenyl ether, ethylene glycol mono-2-ethylbutyl ether, diethylene glycol monomethyl ether, diethylene glycol monoethyl ether, diethylene glycol monopropyl ether, diethylene glycol monobutyl ether, diethylene glycol monohexyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether, dipropylene glycol monopropyl ether, and the like.

Examples of the ether-based solvent may include: a dialkyl ether-based solvent, such as diethyl ether, dipropyl ether, dibutyl ether, and the like; a cyclic ether-based solvent, such as tetrahydrofuran, tetrahydropyran, and the like; and an aromatic ring-containing ether-based solvent, such as diphenyl ether, anisole, and the like.

Examples of the ketone-based solvent may include: a chain ketone-based solvent, such as acetone, methyl ethyl ketone, methyl-n-propyl ketone, methyl-n-butyl ketone, diethyl ketone, methyl isobutyl ketone, 2-heptanone, ethyl-n-butyl ketone, methyl-n-hexyl ketone, diisobutyl ketone, trimethyl nonanone, and the like; a cyclic ketone-based solvent, such as cyclopentanone, cyclohexanone, cycloheptanone, cyclooctanone, methylcyclohexanone, and the like; and 2,4-pentanedione, acetonylacetone, acetophenone, and the like.

Examples of the amide-based solvent may include: a cyclic amide-based solvent, such as N,N'-dimethylimidazolidinone, N-methyl-2-pyrrolidone, and the like; and a chain amide-based solvent, such as N-methylformamide, N,N-dimethylformamide, N,N-diethylformamide, acetamide, N-methylacetamide, N,N-dimethylacetamide, N-methylpropionamide, and the like.

Examples of the ester-based solvent may include: an acetate ester-based solvent, such as methyl acetate, ethyl acetate, n-propyl acetate, isopropyl acetate, n-butyl acetate, isobutyl acetate, sec-butyl acetate, n-pentyl acetate, isopentyl acetate, sec-pentyl acetate, 3-methoxybutyl acetate, methylpentyl acetate, 2-ethylbutyl acetate, 2-ethylhexyl acetate, benzyl acetate, cyclohexyl acetate, methylcyclohexyl acetate, n-nonyl acetate, and the like; a polyhydric alcohol-containing ether carboxylate-based solvent, such as ethylene glycol monomethyl ether acetate, ethylene glycol monoethyl ether acetate, diethylene glycol monomethyl ether acetate, diethylene glycol monoethyl ether acetate, diethylene glycol mono-n-butyl ether acetate, propylene glycol monomethyl ether acetate, propylene glycol monoethyl ether acetate, propylene glycol monopropyl ether acetate, propylene glycol monobutyl ether acetate, dipropylene glycol monomethyl ether acetate, dipropylene glycol monoethyl ether acetate, and the like; a carbonate-based solvent, such as dimethyl carbonate, diethyl carbonate, ethylene carbonate, propylene carbonate, and the like; a lactate ester-based solvent, such as methyl lactate, ethyl lactate, n-butyl lactate, n-amyl lactate, and the like; and glycol diacetate, methoxytriglycol acetate, ethyl propionate, n-butyl propionate, isoamyl propionate, diethyloxalate, di-n-butyloxalate, methyl acetoacetate, ethyl acetoacetate, diethyl malonate, dimethyl phthalate, diethyl phthalate, and the like.

Examples of the sulfoxide-based solvent may include dimethyl sulfoxide, diethyl sulfoxide, and the like.

Examples of the hydrocarbon-based solvent include: an aliphatic hydrocarbon-based solvent such as n-pentane, isopentane, n-hexane, isohexane, n-heptane, isoheptane, 2,2,4-trimethyl pentane, n-octane, isooctane, cyclohexane, and methylcyclohexane; and an aromatic hydrocarbon-based solvent such as benzene, toluene, xylene, mesitylene, ethylbenzene, trimethylbenzene, methylethylbenzene, n-propylbenzene, isopropylbenzene, diethylbenzene, isobutylbenzene, triethylbenzene, diisopropylbenzene, n-amylnaphthalene, and the like.

In particular, the organic solvent may be selected from among an alcohol-based solvent, an amide-based solvent, an ester-based solvent, a sulfoxide-based solvent, and any combination thereof. More particularly, the solvent may be selected from among propylene glycol monomethyl ether, propylene glycol monoethyl ether, propylene glycol monomethyl ether acetate, N-methyl-2-pyrrolidone, N,N-dimethylacetamide, ethyl lactate, dimethylsulfoxide, and any combination thereof.

The organic solvent may be used in an amount of about 200 parts by weight to about 5,000 parts by weight, in particular, about 400 parts by weight to about 3,000 parts by weight, with respect to 100 parts by weight of the polymer.

<Optional Components>

The resist composition may further include, as necessary, a surfactant, a crosslinking agent, a levelling agent, a coloring agent, or any combination thereof.

The resist composition may further include a surfactant in order to improve coatability, developing properties, and the like. Specific examples of the surfactant may include nonionic surfactants, such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate, polyethylene glycol distearate, and the like. The surfactant used may be a commercially available product or a synthesized product. Examples of the commercially available surfactant product may include KP341 (manufactured by Shin-Etsu Chemical Co., Ltd.), Polyflow No.75 and Polyflow No.95 (manufactured by Kyoeisha Chemical Co., Ltd.), Ftop EF301, Ftop EF303, and Ftop EF352 (manufactured by Mitsubishi Material Electrochemical Co., Ltd.), MEGAFACE (registered trademark) F171, MEGAFACE F173, R40, R41, and R43 (manufactured by DIC Corp. Ltd.), Fluorad (registered trademark) FC430 and Fluorad FC431 (manufactured by 3M Co., Ltd.), AsahiGuard AG710 (manufactured by AGC Co., Ltd.), Surflon (registered trademark) S-382, Surflon SC-101, Surflon SC-102, Surflon SC-103, Surflon SC-104, Surflon SC-105, and Surflon SC-106 (manufactured by AGC Semi Chemical Co., Ltd.).

The surfactant may be included in an amount of about 0 part by weight to about 20 parts by weight with respect to 100 parts by weight of the polymer. The surfactant may be a single type of surfactant, or a mixture of two or more different types of surfactants.

The method by which the resist composition is prepared is not limited to any particular method. For example, the resist composition may be prepared by mixing a polymer and optional components added as needed in an organic solvent. The temperature or duration for the mixing is not particularly limited. Filtration may be performed after the mixing, if necessary.

**[Resist Composition-Containing Monomer]**

A resist composition according to some example embodiments may include an organometallic compound represented by Formula 1 below; and a monomer containing a radical generating group or a radical accepting group.

Formula 1 $Sn(Rn_{11})_n(OR_{12})_{(4-n)}$

In Formula 1,

$R_{11}$ may be a linear, branched or cyclic $C_1$-$C_{30}$ monovalent hydrocarbon group optionally containing one or more heteroatoms,

$R_{12}$ may be a linear, branched or cyclic $C_1$-$C_{30}$ monovalent hydrocarbon group optionally containing one or more heteroatoms, or *-$Sn(R_{13})_m(OR_{14})_{(3-m)}$,

n may be an integer from 1 to 4,

$R_{13}$ and $R_{14}$ may be each independently a linear, branched or cyclic $C_1$-$C_{30}$ monovalent hydrocarbon group optionally containing one or more heteroatoms, m may be an integer from 0 to 3, and

* may be a binding site with a neighboring atom. In some example embodiments of Formula 1 where $R_{12}$ is *-$Sn(R_{13})_m(OR_{14})_{(3-m)}$, * of *-$Sn(R_{13})_m(OR_{14})_{(3-m)}$ is a binding site with a neighboring atom of Formula 1.

For example, the monomer may include at least one polymerizable group.

Specifically, the polymerizable may include a vinyl group, an acrylate group, a methacrylate group, an oxirane group, an epoxy group, an oxetane group, a thiol group, or any combination thereof, as a partial structure.

More specifically, the polymerizable group may include a vinyl group, an acrylate group, a methacrylate group, or any combination thereof as a partial structure.

In some example embodiments, the monomer containing a radical generating group or a radical accepting group may be selected from Group III below:

Group III

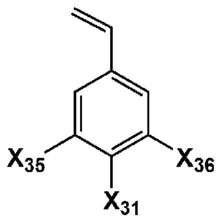
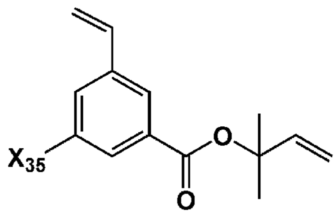
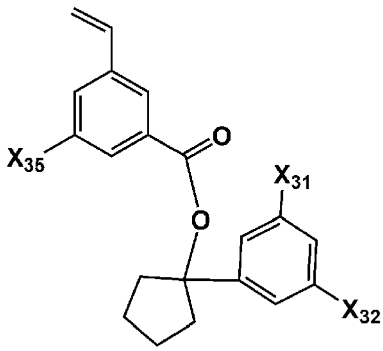
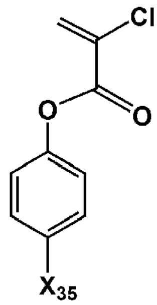

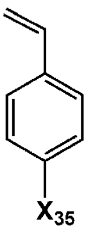
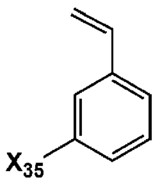
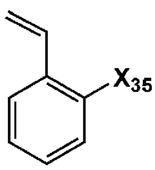

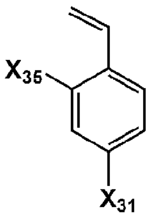
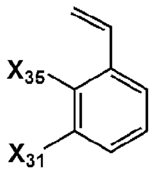
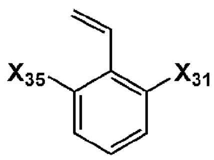
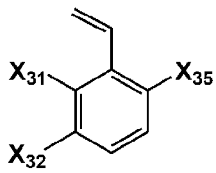
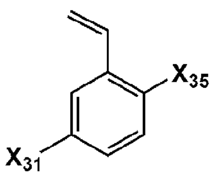
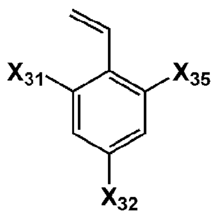
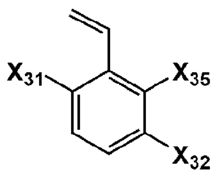
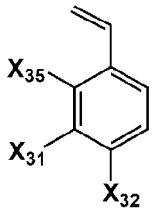
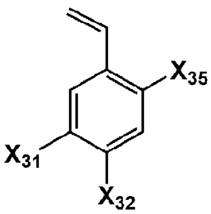
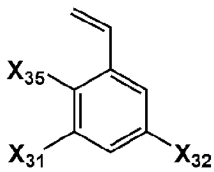
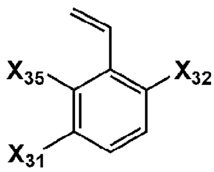
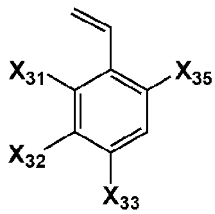
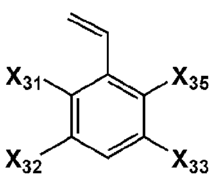
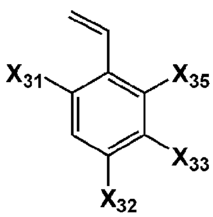
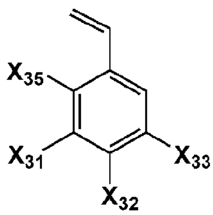
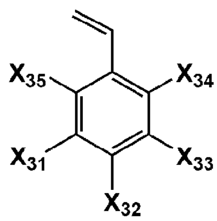
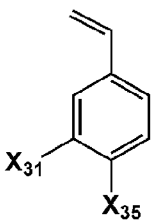
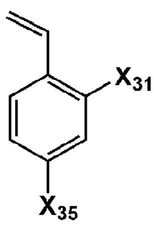
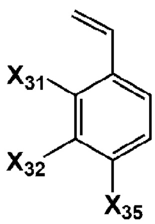
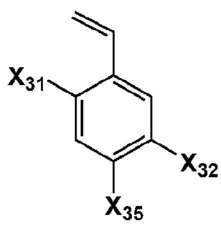
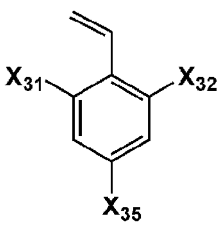
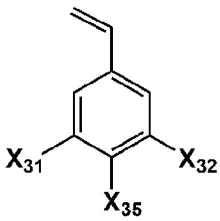
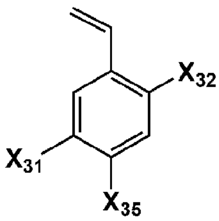
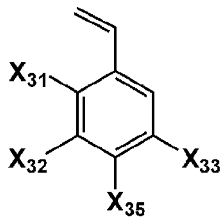
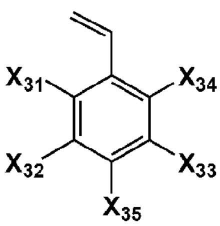

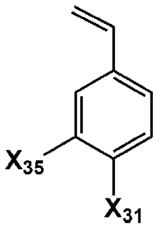
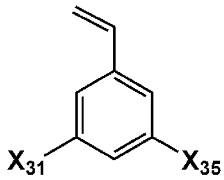
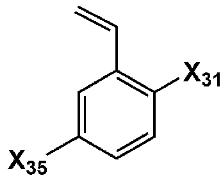
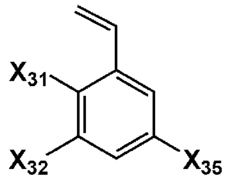

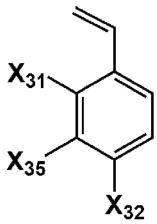
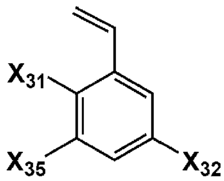
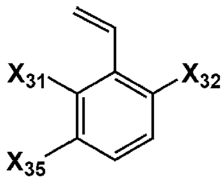
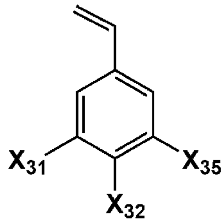

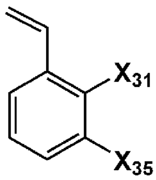
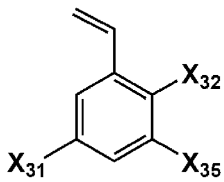
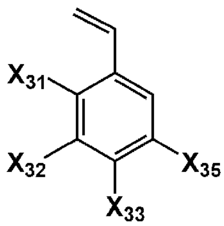
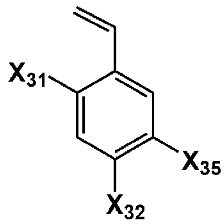

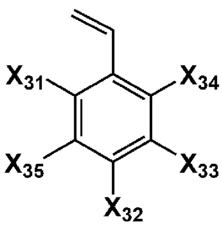
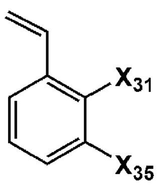
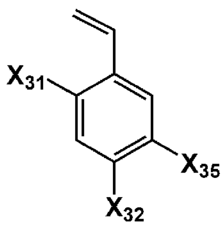

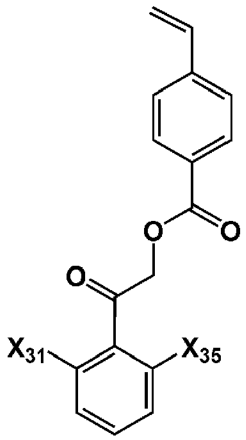
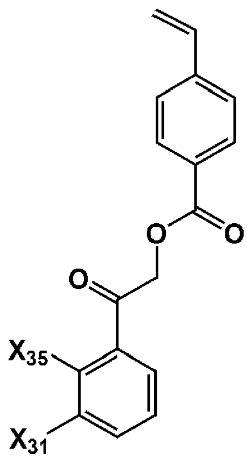
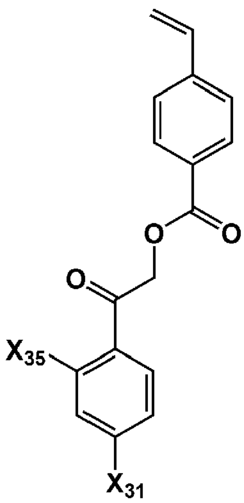
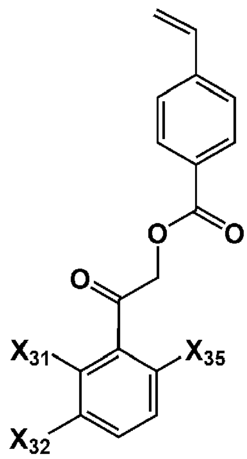

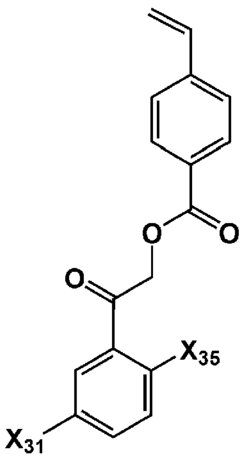
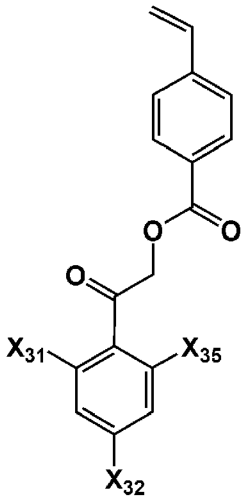
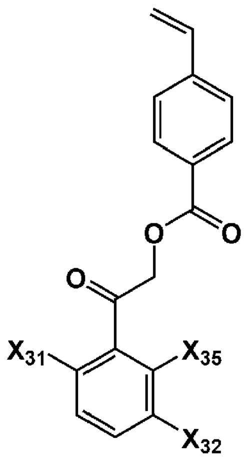
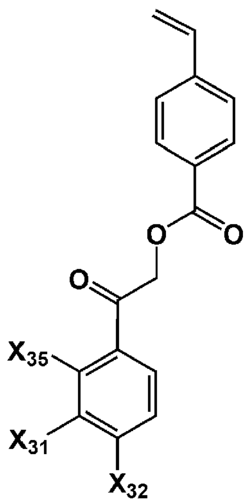

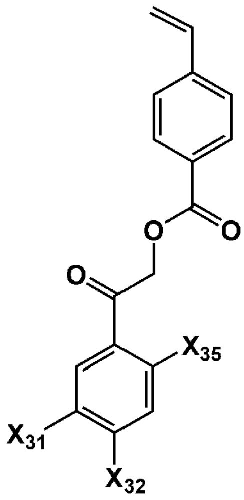
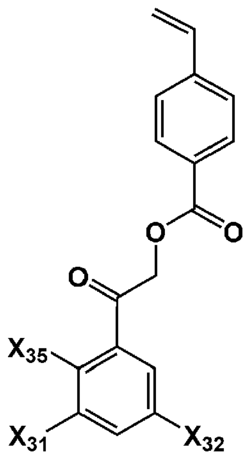
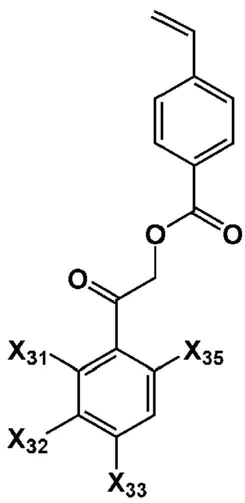
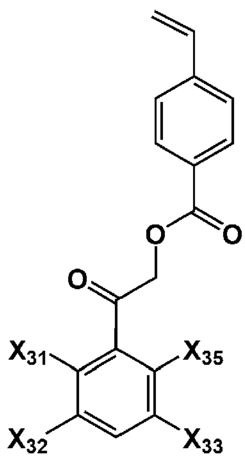

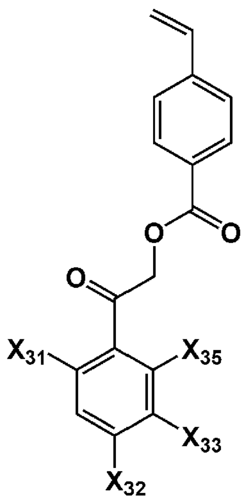
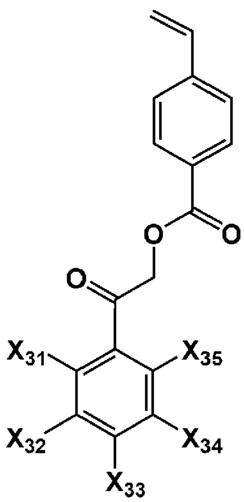

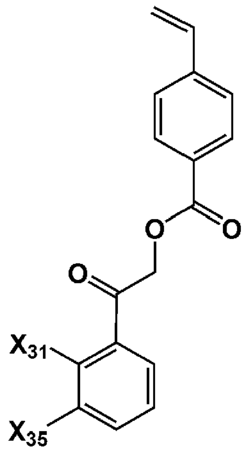
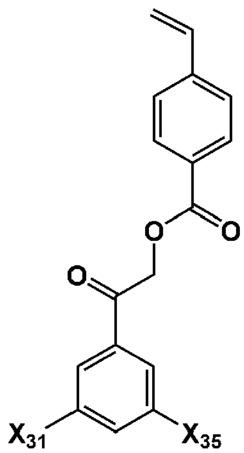
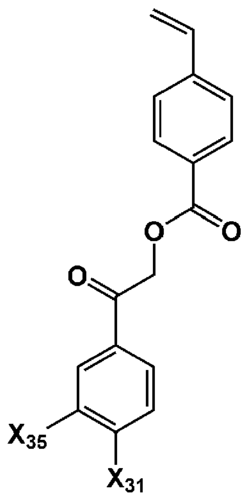
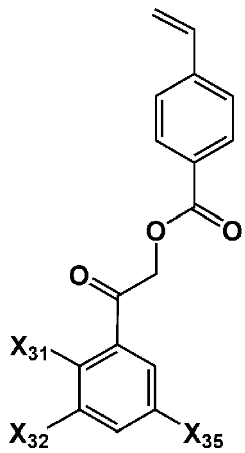

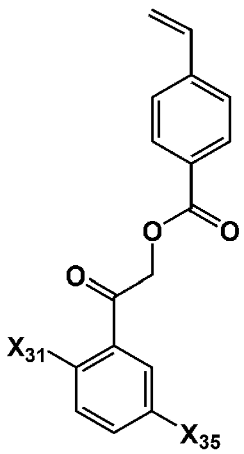
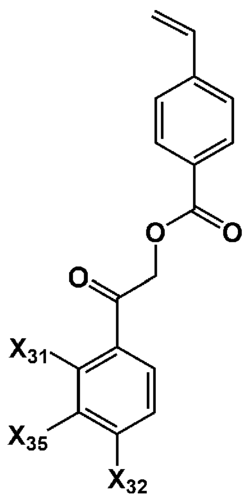
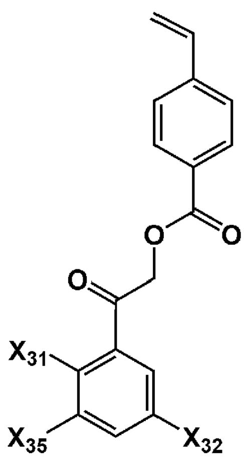
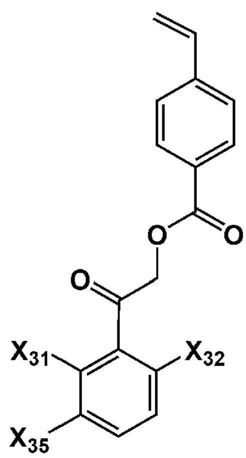

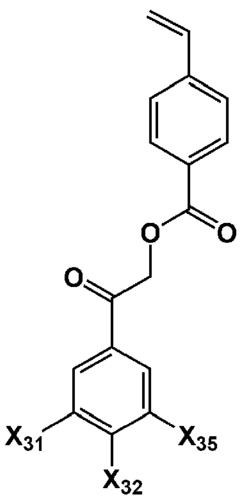

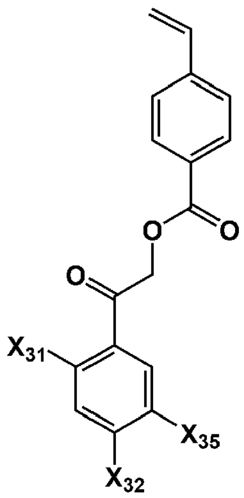

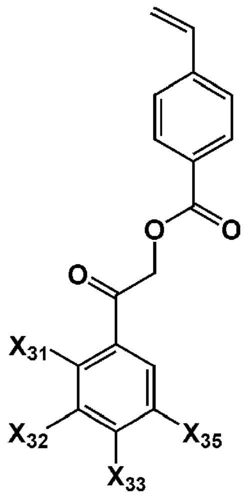

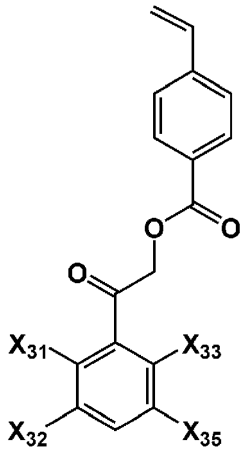

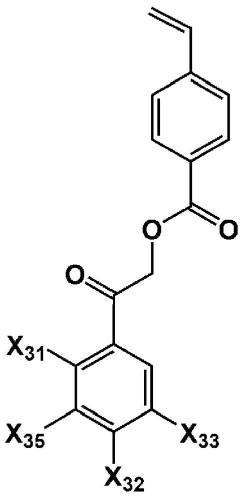

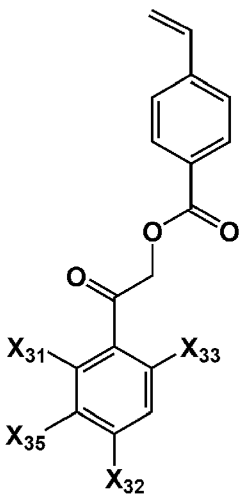

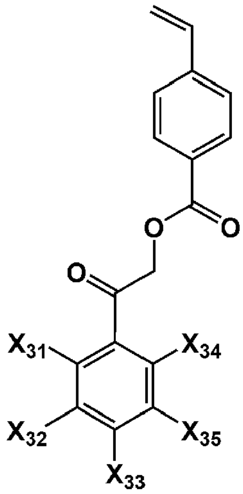

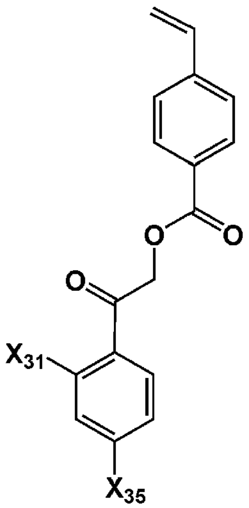
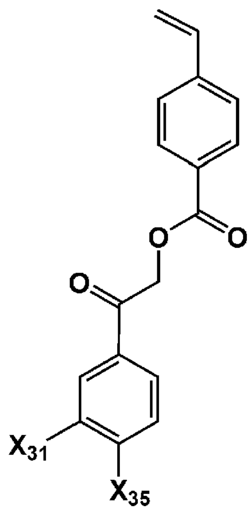
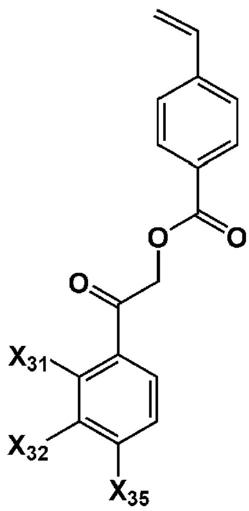
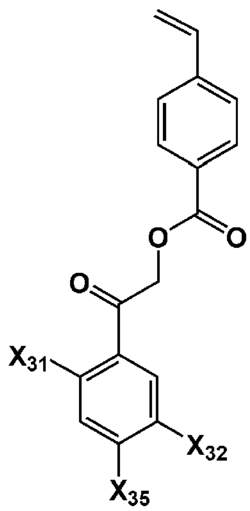
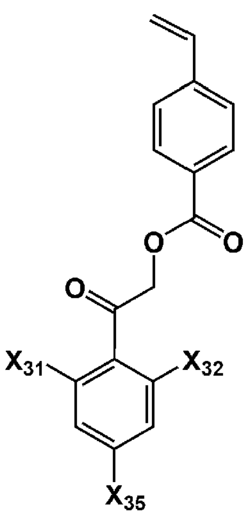
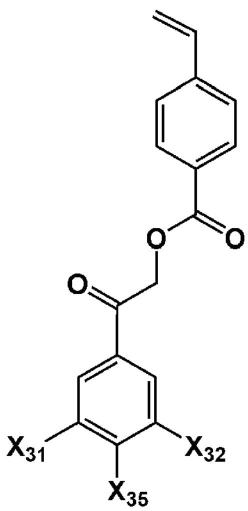
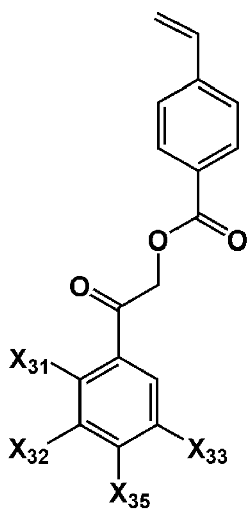
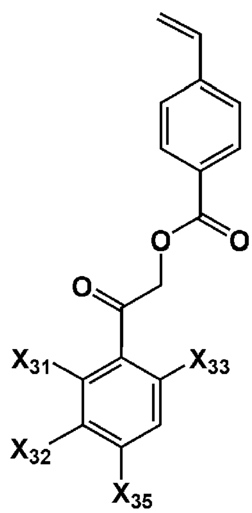
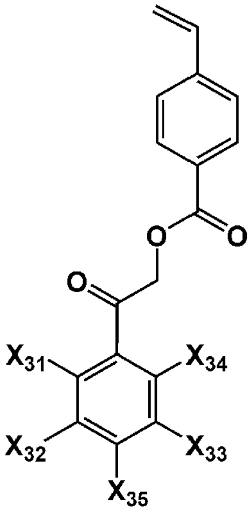
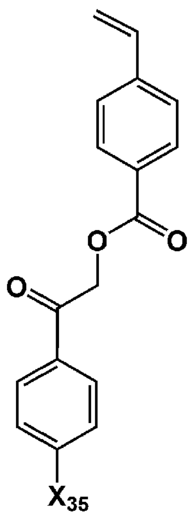
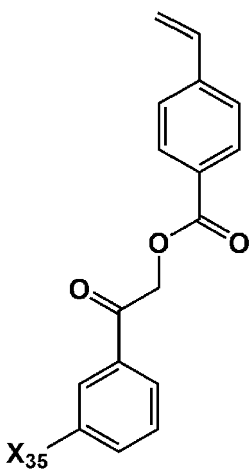
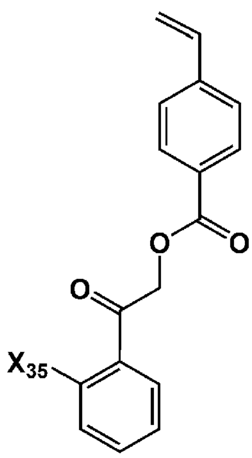

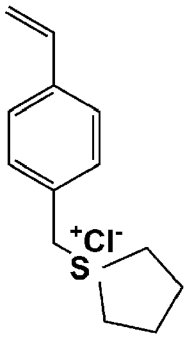

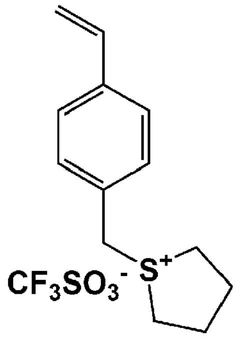

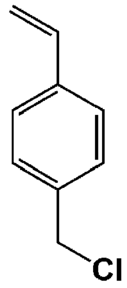

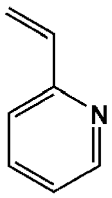

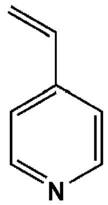

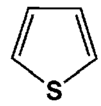

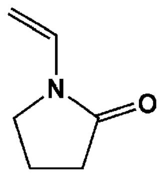

In Group III, $X_{31}$ to $X_{34}$ may each independently be F, I, or $CH_3$, and $X_{35}$ and $X_{36}$ may each independently be OH or $NH_2$.

The resist composition including the monomer, except that it contains monomers instead of polymers, may be identical to the resist composition including the polymer described above. Regarding the resist composition including a monomer, reference can be made to the resist composition including a polymer described above.

**[Method of Forming a Pattern]**

Hereinbelow, referring to FIGS. 1 and 2A to 2C, a method, including a method of forming a pattern according to some example embodiments is described in greater detail. FIG. 1 is a flowchart showing a method of forming a pattern according to some example embodiments, and FIGS. 2A to 2C are side-sectional views showing a method of forming a pattern according to some example embodiments. In some example embodiments, the method may further include manufacturing an electronic device based on the developed exposed resist film. Although a method of forming a pattern using a negative resist composition is described in detail as an example hereinbelow, the method is not limited thereto.

Referring to FIG. 1, a method may include a method of forming a pattern that may include forming a resist film by applying a resist composition (S101), exposing at least a portion of the resist film to a high-energy ray (S102), and developing the exposed resist film by using a developer (S103). The above processes may be omitted as necessary, or may be carried out in a different sequence.

First, referring to FIG. 1 and FIG. 2A, a substrate 100 may be prepared. For example, the substrate 100 may utilize a semiconductor substrate such as a silicon substrate and a germanium substrate, and glass, quartz, ceramics, copper, and the like. In some example embodiments, the substrate 100 may include a compound of Group III-V, such as GaP, GaAs, and GaSb.

A resist film 110 may be formed by (e.g., based on) applying the resist composition to a desired thickness on the substrate 100 by a specific coating method. If necessary, heating (also referred to as pre-bake (PB) or post-annealing bake (PAB)) may be performed to remove residual organic solvent from the resist film 110. In some example embodiments, radicals may be generated by heating the resist film 110, and crosslinks may be formed as the radicals are chemically crosslinked by exposure subsequently. The resist film 110 may include the resist composition according to any of the example embodiments.

The coating method may utilize spin coating, dipping, roller coating, or other common coating methods. Among such coating methods, spin coating in particular may be utilized wherein the resist film 110 may be formed to a desired thickness by adjusting the viscosity, concentration, and/or spinning speed of the resist composition. Specifically, the resist film 110 may have a thickness of about 10 nm to about 300 nm. More specifically, the resist film 110 may have a thickness of about 15 nm to about 200 nm.

The temperature of PAB may have a lower limit of 60 °C or more, specifically, 80 °C or more. In addition, The temperature of PAB may have an upper limit of 200 °C or less, specifically, 180 °C or less. The duration of PAB may have a lower limit of 5 seconds or more, in particular, 10 seconds or more. The duration of PAB may have an upper limit of 600 seconds or less, in particular, 300 seconds or less.

Prior to applying the resist composition onto the substrate 100, a film to be etched (not illustrated) may be further formed on the substrate 100. The film to be etched may refer to a layer to which an image is transferred from a

resist pattern, and which as a result transforms to a pattern. In some example embodiments, the film to be etched may be formed so as to include an insulating material, such as a silicon oxide, a silicon nitride, and a silicon oxynitride. In some example embodiments, the film to be etched may be formed so as to include a conductive material, such as a metal, a metal nitride, a metal silicide, and a metal silicide nitride film. In some example embodiments, the film to be etched may be formed so as to include a semiconductor material such as a polysilicon.

In some example embodiments, there may be an anti-reflection film further formed on the substrate 100 to maximally achieve the efficiency of the resist. The anti-reflection film may be an organic- or inorganic-based anti-reflection film.

In some example embodiments, there may be a protection film further provided on the resist film 110 to reduce the influence of alkaline impurities, etc. introduced during a process. In addition, in cases of immersion lithography, for example, an immersion protection film may be provided on the resist film 110 to avoid a direct contact between the immersion media and the resist film 110.

Next, referring to FIG. 1 and FIG. 2B, at least a portion of the resist film 110 may be exposed to a high-energy ray, thereby establishing an exposed resist film. For example, a high-energy ray having passed through a mask 120 may be irradiated to at least a portion of the resist film 110. As a result, the resist film 110 (e.g., the exposed resist film) may have an exposed portion 111 and an unexposed portion 112.

Without being limited to any particular theory, as radicals are generated in the exposed portion 111 by exposure, and chemical bonds are formed between the radicals, properties of the resist composition may transform.

The exposure in some cases may be carried out by (e.g., based on) irradiating a high-energy ray through a mask 120 having a pattern while using liquid, such as water, as media. Examples of the high-energy ray may include electromagnetic waves such as ultraviolet rays, deep ultraviolet rays, extreme ultraviolet rays (EUV, wavelength 13.5 nm), X-rays, and $\gamma$-rays; and charged particle beams, such as an electron beam (EB), $\alpha$-ray, and the like. Irradiation of the aforementioned high-energy rays may be referred to as "exposure".

The light source during exposure may utilize various light sources such as: laser radiation in the ultraviolet region, such as KrF excimer laser (wavelength 248 nm), ArF excimer laser (wavelength 193 nm), and $F_2$ excimer laser (wavelength 157 nm); harmonic laser radiation in the far-infrared region or vacuum ultraviolet region, through wavelength conversion from laser light from solid-state laser light sources (YAG or semiconductor laser, etc.); and an electron beam or extreme ultraviolet (EUV) radiation, and the like. Although the exposure is commonly carried out through a mask corresponding to a desired pattern, if the light source during exposure is an electron beam, the exposure may be carried out by direct writing without using a mask.

The appropriate dose of a high-energy ray, for example, if the high-energy ray used is EUV, may be 2,000 $mJ/cm^2$ or less, more specifically, 500 $mJ/cm^2$ or less. In addition, if the high-energy ray used is an EB, the appropriate dose may be 5,000 $\mu C/cm^2$ or less, more specifically, 1,000 $\mu C/cm^2$ or less.

In addition, following the exposure, post-exposure bake (PEB) may be carried out. The temperature of the PEB may have a lower limit of 50 °C or more, in particular, 80 °C or more. The temperature of the PEB may have an upper limit of 250 °C or less, in particular, 200 °C or less. The duration of the PEB may have a lower limit of 5 seconds or more, in particular, 10 seconds or more. The duration of the PEB may have an upper limit of 600 seconds or less, in particular, 300 seconds or less.

Next, referring to FIG. 1 and FIG. 2C, the exposed resist film 110 may be developed using a developer. The unexposed portion 112 may be washed away (e.g., removed from the exposed resist film 110) by the developer, while the exposed portion 111 remains without being washed away with the developer. The resultant structure as shown in FIG. 2C may be a resist pattern.

Examples of the developer (also referred to herein interchangeably as a developing solution) may include an alkaline developer, a developer containing an organic solvent (hereinafter referred to as "organic developer") and the like. Examples of a development method may include a dipping process, a puddle process, a spray process, a dynamic dispense process, and the like. The development temperature may be, for example, from about 5 °C or more to about 60 °C or less. The developing time may be, for example, from about 5 seconds or more to about 300 seconds or less.

Examples of the alkaline developer may include an alkaline aqueous solution that has dissolved therein at least one alkaline compound selected from among sodium hydroxide, potassium hydroxide, sodium carbonate, sodium silicate, sodium metasilicate, ammonia water, ethylamine, n-propylamine, diethylamine, di-n-propyl amine, triethylamine, methyldiethylamine, ethyldimethylamine, triethanolamine, tetramethyl ammonium hydroxide (TMAH), pyrrole, piperidine, choline, 1,8-diazabicyclo[5.4.0]-7-undecene (DBU), 1,5-diazabicyclo[4.3.0]-5-nonene (DBN), and the like. The alkaline developer may further include a surfactant.

The content of the alkaline compound in the alkaline developer may have a lower limit of 0.1 wt% or more, specifically 0.5 wt% or more, more specifically, 1 wt% or more. Further, the content of the alkali compound in the alkaline developer may have an upper limit of 20 wt% or less, specifically 10 wt% or less, more specifically, 5 wt% or less.

For the organic solvent included in the organic developer, the same organic solvent presented as an example in <Organic Solvent> under [Resist Composition] section above may be used. In particular, examples of the organic

developer may include nBA (n-butyl acetate), PGME (propylene glycol methyl ether), PGMEA (propylene glycol methyl ether acetate), GBL ($\gamma$-butyrolactone), IPA (isopropanol), or the like.

The content of the organic solvent in the organic developer may have a lower limit of 80 wt% or more, specifically, 90 wt% or more, more specifically, 95 wt% or more, in particular, 99 wt% or more.

The organic developer may include a surfactant. In addition, the organic developer may contain a trace amount of moisture. In addition, during development, the organic developer may be replaced with another type of solvent to thereby stop the development.

The resist pattern after development may be further washed. As a washing solution, distilled water, a rinsing solution, etc. may be used. The rinsing solution is not particularly limited and may be any solution as long as it does not dissolve resist patterns. In particular, the rinsing solution may utilize a solution containing a common organic solvent. Examples of the rinsing solution may include an alcohol-based solvent and an ester-based solvent. After washing, the rinsing solution remaining on the substrate and patterns may be removed. In particular, if distilled water was used, water residues on the substrate and pattern may be removed.

In addition, the developer utilize a single type of developer or a combination of two or more types of developers.

By etching after forming the resist pattern as described above, a patterned wiring substrate may be obtained. The etching may be performed by a known method, such as a dry etching process using a plasma gas, and a wet etching process using an alkaline solution, a copper(II) chloride solution, an iron(II) chloride solution, and the like.

After forming the resist pattern, plating may be performed. The plating may be carried out by a method including, but not limited to, copper plating, solder plating, nickel plating, gold plating, and the like.

Resist pattern residues after etching may be stripped by an organic solvent. Examples of the organic solvent may include, without being limited to, propylene glycol monomethyl ether acetate (PGMEA), propylene glycol monomethyl ether (PGME), ethyl lactate (EL), and the like. The stripping may be carried out by a method including, but not limited to, a dipping method, a spray technique, and the like. In addition, a wiring board on which the resist pattern is formed may be a multilayer wiring board, and may have a small-diameter via hole.

In some example embodiments, the wiring board (also referred to herein as a wiring substrate, for example a printed circuit board) may be formed through a lift-off method in which after forming a resist pattern, a metal is deposited under vacuum, followed by dissolving the resist pattern with a solution.

In some example embodiments, a method may include incorporating the resist pattern and/or a structure based thereon (e.g., a wiring board) into a manufactured electronic device. The electronic device may include, for example, one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a DRAM device, storing a program of instructions, and a processor (e.g., CPU) configured to execute the program of instructions to implement the functionality of the manufactured electronic device and/or any portions thereof.

The electronic device may include one or more devices, structures, or the like (e.g., one or more semiconductor devices in one or more processors, memories, processing circuitry, etc.) which may include the resist pattern and/or a structure based thereon (e.g., a wiring board). As a result, the electronic device may have improved performance, compactness, or the like based on including one or more devices, structures, or the like that are based on (e.g., include, incorporate, or the like) the resist pattern and/or a structure based thereon (e.g., a wiring board), which is formed using a resist composition with improved sensitivity, resolution, storage stability, and the like as described herein, such that one or more patterns of the resist pattern and/or a structure based thereon (e.g., a pattern wiring substrate) may have improved resolution, compactness (e.g., miniaturization), or the like. Accordingly, the electronic device and/or one or more devices thereof that are based on the resist pattern may have improved miniaturization due to including fine patterns while also having improved reliability due to reduced risk of having process defects due to improved uniformity of patterns thereof, reduced surface roughness thereof, reduction or prevention of acid diffusion, and/or with reduced or minimized exposure to high doses of light to complete manufacture thereof. As a further result, the yield of manufacture of defect-free electronic devices may thus be improved, and/or costs of manufacture thereof may be reduced, based on the method according to some example embodiments.

The present inventive concepts will be described in greater detail with reference to Examples and Comparative Examples below, but the technical scope of the present inventive concepts are not limited to the following Examples.

**[EXAMPLES]**

**Synthesis Example 1: Synthesis of SP33**

In a 100 mL reactor, initiator V601 (Wako chemical Co., 0.426 g, 1.84 mmol), 2-acetoxy styrene, and 0.2 grams of an azo initiator (V601) (0.9 mmol) were dissolved in 3 mL of 1,4-dioxane. Nitrogen was bubbled through the resulting solution for about 20 minutes, while stirring the same at room temperature. Upon completion of the bubbling, the reactor was sealed back, and a polymerization reaction was conducted at 80 °C for 4 hours. Upon completion of the reaction, the resulting polymerization product was precipitated in 200 mL of hexane. Using a glass filter, the resulting precipitates were obtained and dried in a vacuum drying oven at 40 °C overnight. Polymer SP33 (yield: 55%) having a weight average molecular weight of 6,320 g/mol and PDI of 1.55 was obtained.

**Synthesis Example 2: Synthesis of Compound T1**

(1) Synthesis of Di(4-Fluorobenzyl) Tin Dichloride (FB)

<Di(4-Fluorobenzyl) Tin Dichloride (FB)>

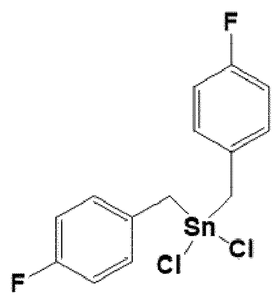

Tin powder (8.2 g, 69 mmol) and 120 mL of dry toluene were placed in a 250-mL reaction flask, and heated to 90 °C. Next, 0.82 grams of distilled water was added as a catalyst, and 4-fluorobenzyl chloride (10 g, 69 mmol) was dropwise added over 10 minutes. After raising the reaction temperature to 130 °C, the resulting mixture was heated under reflux for 4 hours. Upon completion of the reaction, unreacted powder was removed by a filter, and white crystals were obtained through cooling. By washing the obtained white crystals with cold toluene and drying at 40 °C overnight, 10.92 grams of Compound FB were obtained (yield: 60%). Compound FB thus obtained was analyzed by $^{1}$H-NMR and $^{119}$Sn-NMR and the results thereof are shown in FIGS. 3A and 3B.

(2) Synthesis of Di(4-Fluorobenzyl) Tin Carboxylate (Acetate) (T1)

<Di(4-Fluorobenzyl) Tin Carboxylate (Acetate) (T1)>

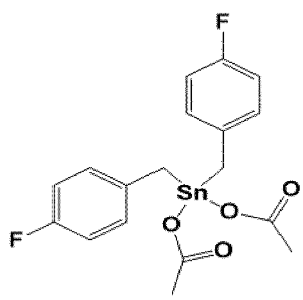

Di(4-fluorobenzyl) tin dichloride (0.5 g, 1.23 mmol) and 7 grams of acetone were placed in a 50-mL reaction flask in an ice bath. Then, sodium acetate (0.2 g, 2.45 mmol) was added thereto. After stirring overnight, the resulting

mixture was filtered, and the solids thus obtained were dried to produce 0.45 grams of Compound T1 (yield: 65%). Compound T1 thus obtained was analyzed by $^{1}H$-NMR and $^{119}Sn$-NMR and the results thereof are shown in FIGS. 3C and 3D.

**Evaluation Example: Evaluation on Thin Film Development**

The polymer synthesized in Synthesis Example 1 and Compound T1 synthesized in Synthesis Example 2 were dissolved at a concentration of 2 wt% in a casting solvent disclosed in Table 1 below. Here, the weight ratio of the polymer and the organometallic compound was as disclosed in Table 1 below. On a silicon wafer coated with 3 nm-thick of HMDS as a lower film, a casting solution was spin-coated at 1,500 rpm. By drying the wafer at 120 °C for 1 minute, a film having an initial thickness disclosed in Table 1 below was prepared. Next, the film was exposed to a DUV having a wavelength of 254 nm at a dose of 0 to 60 mJ/cm$^2$, followed by drying for 1 minute at a temperature of 150 °C to 200 °C. The dried film was immersed, at 25 °C for 60 seconds, in a PGMEA solution containing 2 wt% of acetic acid dissolved therein as a developer. Then, the thickness of the film remaining thereafter was measured, and the results thereof are shown in Table 2 and FIGS. 4A to 4C.

[Table 1]

| | Organometallic compound | Polymer | Casting solvent | Weight ratio (T1: Polymer) | PAB (°C) | Initial thickness (nm) | PEB (°C) |
|---|---|---|---|---|---|---|---|
| Comparative Example 1 | T1 | - | Ethyl lactate | - | 120 | 19.6 | 200 |
| Example 1 | T1 | SP33 | Ethyl lactate | 2:1 | 120 | 20.1 | 150 |

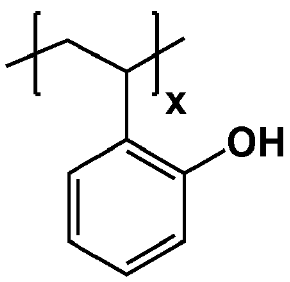

**SP33**

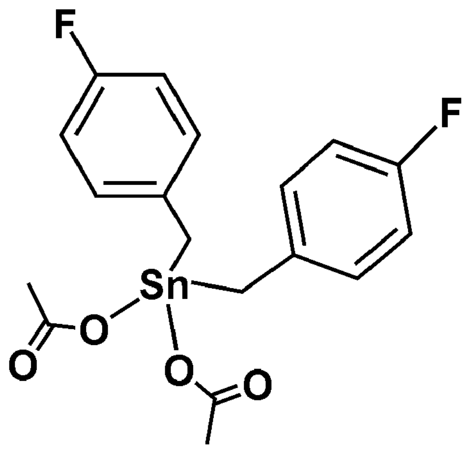

**T1**

[Table 2]

| | Organometallic compound | Polymer | Eth (mJ/cm$^2$) | E1 (mJ/cm$^2$) | Film remaining ratio (%) | 9 |
|---|---|---|---|---|---|---|
| Comparative Example 1 | T1 | - | 22 | 50 | 50 | 1.4 |
| Example 1 | T1 | SP33 | 42 | 70 | 49.2 | 2.2 |

In Table 2, $E_{th}$ represents exposure dose at the point in time when the thin film starts to be cured, and $E_1$ represents exposure dose at a saturation point at which the thickness of the thin film no longer increases. Film remaining ratio is a percentage value obtained by dividing the thickness of the thin film at the saturation point by the initial thickness,

and $\gamma$ represents contrast curve and is a value calculated by Equation 1 below.

Equation 1

$$\gamma = \left| \log \left( \frac{E_{th}}{E_1} \right) \right|^{-1}$$

Referring to Table 2, it can be seen that Example 1 has a greater $\gamma$ value than that of Comparative Example 1, and this suggests that the resist composition of Example 1 has an improved sensitivity compared to the resist composition of Comparative Example 1.

Some example embodiments disclosed herein may provide a resist composition having improved sensitivity and providing a pattern with an improved resolution.

It should be understood that some example embodiments described herein should be considered in a descriptive sense only and not for purposes of limitation. Descriptions of features or aspects within each example embodiment should typically be considered as available for other similar features or aspects in some example embodiments. While some example embodiments have been described with reference to the figures, it will be understood by those of ordinary skill in the art that various changes in form and details may be made therein without departing from the scope as defined by the following claims.

## Claims

**1.** A resist composition, comprising:

an organometallic compound represented by Formula 1; and
a polymer comprising a repeating unit containing a radical generating group, a repeating unit containing a radical accepting group, or any combination thereof:

Formula 1 $Sn(Rn_{11})_n(OR_{12})_{(4-n)}$

wherein in Formula 1,

$R_{11}$ is a linear, branched or cyclic $C_1$-$C_{30}$ monovalent hydrocarbon group optionally containing one or more heteroatoms,
$R_{12}$ is a linear, branched or cyclic $C_1$-$C_{30}$ monovalent hydrocarbon group optionally containing one or more heteroatoms, or $*\text{-}Sn(R_{13})_m(OR_{14})_{(3-m)}$, wherein

$R_{13}$ and $R_{14}$ are each independently a linear, branched or cyclic $C_1$-$C_{30}$ monovalent hydrocarbon group optionally containing one or more heteroatoms,
m is an integer from 0 to 3, and
* is a binding site with a neighboring atom, and

n is an integer from 1 to 4.

**2.** The resist composition of claim 1, wherein, in Formula 1, a bond between Sn and $R_{11}$ is a Sn-carbon(C) single bond, and a bond between Sn and $R_{13}$ is a Sn-C single bond; and/or
wherein, in Formula 1, the organometallic compound has a molecular weight of 3,000 g/mol or less.

**3.** The resist composition of claims 1 or 2, wherein, in Formula 1,

when $R_{11}$ and $R_{13}$ are each independently represented by $*\text{-}(L_{11})_{a11}\text{-}X_{11}$, and/or $R_{12}$ and $R_{14}$ are each independently represented by $*\text{-}(L_{12})_{a12}\text{-}X_{12}$,
$L_{11}$ and $L_{12}$ are each independently $CR_aR_b$, C=O, S=O, $SO_2$, $PO_2$, or $PO_3$,
a11 and a12 are each independently an integer from 0 to 3,
$X_{11}$ and $X_{12}$ are each independently an unsubstituted or substituted $C_1$-$C_{30}$ alkyl group, an unsubstituted or

substituted $C_1$-$C_{30}$ halogenated alkyl group, an unsubstituted or substituted $C_1$-$C_{30}$ alkoxy group, an unsubstituted or substituted $C_1$-$C_{30}$ alkylthio group, an unsubstituted or substituted $C_1$-$C_{30}$ halogenated alkoxy group, an unsubstituted or substituted $C_1$-$C_{30}$ halogenated alkylthio group, an unsubstituted or substituted $C_3$-$C_{30}$ cycloalkyl group, an unsubstituted or substituted $C_3$-$C_{30}$ cycloalkoxy group, an unsubstituted or substituted $C_3$-$C_{30}$ cycloalkylthio group, an unsubstituted or substituted $C_3$-$C_{30}$ heterocycloalkyl group, an unsubstituted or substituted $C_3$-$C_{30}$ heterocycloalkoxy group, an unsubstituted or substituted $C_3$-$C_{30}$ heterocycloalkylthio group, an unsubstituted or substituted $C_2$-$C_{30}$ alkenyl group, an unsubstituted or substituted $C_2$-$C_{30}$ alkenyloxy group, an unsubstituted or substituted $C_2$-$C_{30}$ alkenylthio group, an unsubstituted or substituted $C_3$-$C_{30}$ cycloalkenyl group, an unsubstituted or substituted $C_3$-$C_{30}$ cycloalkenyloxy group, an unsubstituted or substituted $C_3$-$C_{30}$ cycloalkenylthio group, an unsubstituted or substituted $C_3$-$C_{30}$ heterocycloalkenyl group, an unsubstituted or substituted $C_3$-$C_{30}$ heterocycloalkenyloxy group, an unsubstituted or substituted $C_3$-$C_{30}$ heterocycloalkenylthio group, an unsubstituted or substituted $C_2$-$C_{30}$ alkynyl group, an unsubstituted or substituted $C_2$-$C_{30}$ alkynyloxy group, an unsubstituted or substituted $C_2$-$C_{30}$ alkynylthio group, an unsubstituted or substituted $C_6$-$C_{30}$ aryl group, an unsubstituted or substituted $C_6$-$C_{30}$ aryloxy group, an unsubstituted or substituted $C_6$-$C_{30}$ arylthio group, an unsubstituted or substituted $C_1$-$C_{30}$ heteroaryl group, an unsubstituted or substituted $C_1$-$C_{30}$ heteroaryloxy group, or an unsubstituted or substituted $C_1$-$C_{30}$ heteroarylthio group,

$R_a$ and $R_b$ are each independently hydrogen, deuterium, a hydroxyl group, a cyano group, a nitro group, an unsubstituted or substituted $C_1$-$C_{30}$ alkyl group, an unsubstituted or substituted $C_1$-$C_{30}$ alkoxy group, an unsubstituted or substituted $C_1$-$C_{30}$ alkylthio group, an unsubstituted or substituted $C_3$-$C_{30}$ cycloalkyl group, an unsubstituted or substituted $C_3$-$C_{30}$ cycloalkoxy group, or an unsubstituted or substituted $C_3$-$C_{30}$ cycloalkylthio group, and

* is a binding site with a neighboring atom.

4. The resist composition of any of claims 1-3, wherein the organometallic compound is represented by any one of Formulas 1-1 to 1-16:

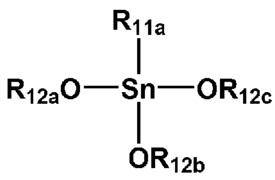

1-1

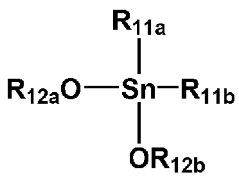

1-2

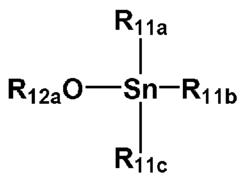

1-3

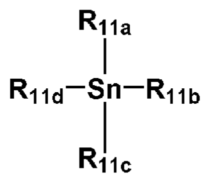

1-4

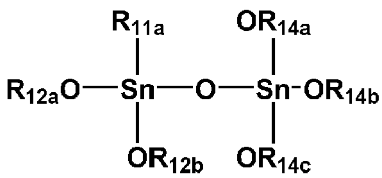

1-5

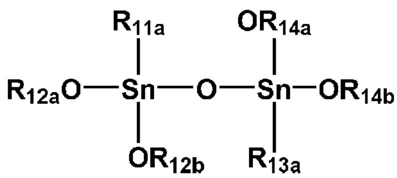

1-6

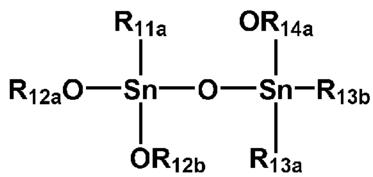

1-7

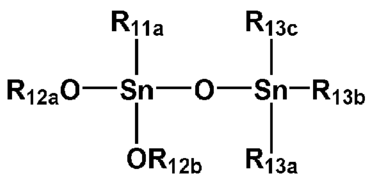

1-8

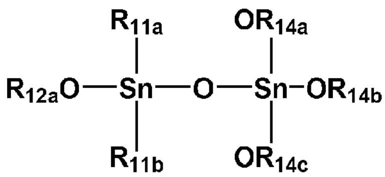

1-9

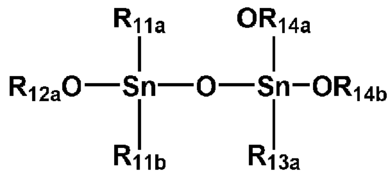

1-10

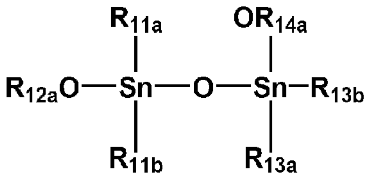

1-11

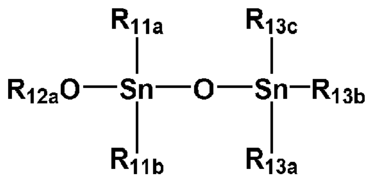

1-12

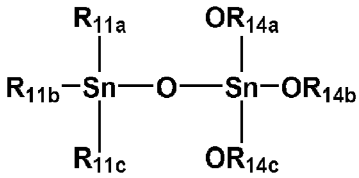

1-13

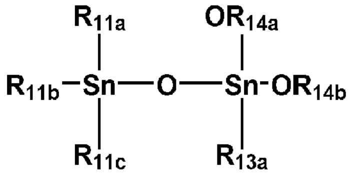

1-14

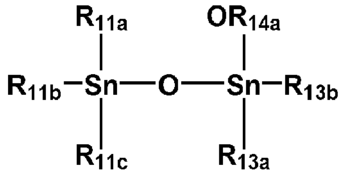

1-15

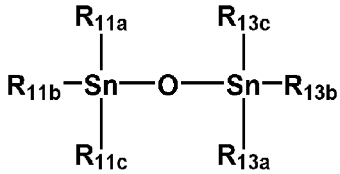

1-16

wherein in Formulas 1-1 to 1-16,

$R_{11a}$ to $R_{11d}$ are each independently a linear, branched or cyclic $C_1$-$C_{30}$ monovalent hydrocarbon group optionally containing one or more heteroatoms,
$R_{12a}$ to $R_{12c}$ are each independently a linear, branched or cyclic $C_1$-$C_{30}$ monovalent hydrocarbon group optionally containing one or more heteroatoms, or $*\text{-}Sn(R_{13})_m(OR_{14})_{(3-m)}$, where $R_{13}$ and $R_{14}$ are each independently a linear, branched or cyclic $C_1$-$C_{30}$ monovalent hydrocarbon group optionally containing one or more heteroatoms, m is an integer from 0 to 3, and * is a binding site with a neighboring atom,
$R_{13a}$ to $R_{13c}$ are each independently a linear, branched or cyclic $C_1$-$C_{30}$ monovalent hydrocarbon group optionally containing one or more heteroatoms, and
$R_{14a}$ to $R_{14c}$ are each independently a linear, branched or cyclic $C_1$-$C_{30}$ monovalent hydrocarbon group optionally containing one or more heteroatoms.

**5.** The resist composition of any of claims 1-4, wherein
the radical generating group comprises a single bond between a carbon atom and X (C-X) or a single bond between a carbon atom and $X^+$ ($C\text{-}X^+$), wherein X is a heteroatom other than a carbon atom and a hydrogen atom.

**6.** The resist composition of claim 5, wherein X is a halogen, an oxygen atom, a sulfur atom, a selenium atom, a nitrogen atom, or a phosphorus atom; and/or
wherein an unsubstituted or substituted $C_1$-$C_{30}$ aryl group or an unsubstituted or substituted $C_1$-$C_{30}$ heteroaryl group is bound adjacent to the carbon atom.

**7.** The resist composition of any of claims 1-6, wherein

the radical generating group comprises a partial structure represented by Formula RG:

Formula RG

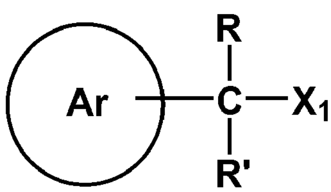

wherein in Formula RG,

Ar is an unsubstituted or substituted $C_1$-$C_{30}$ aryl group or an unsubstituted or substituted $C_1$-$C_{30}$ heteroaryl group,
R and R' are each independently hydrogen, deuterium, a halogen, or a linear, branched or cyclic $C_1$-$C_{30}$ divalent hydrocarbon group optionally containing one or more heteroatoms, and

$X_1$ is an electron withdrawing group.

**8.** The resist composition of any of claims 1-7, wherein
the radical accepting group comprises a lone-pair electron donating group and/or an electron donating group.

**9.** The resist composition of claim 8, wherein the lone-pair electron donating group comprises an oxygen atom, a sulfur atom, a nitrogen atom, or a phosphorus atom, as a partial structure; and/or
wherein the electron donating group comprises a single bond between a hydrogen atom and Z (Z-H), wherein Z is a heteroatom other than a carbon atom and a hydrogen atom.

**10.** The resist composition of any of claims 1-9, wherein

the radical accepting group comprises a partial structure represented by Formula RA1 or RA2:

Formula RA1

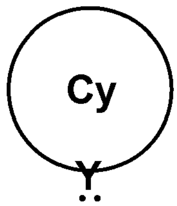

Formula RA2

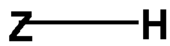

wherein in Formulas RA1 and RA2,

Cy is an unsubstituted or substituted $C_1$-$C_{30}$ carbocyclic group or an unsubstituted or substituted $C_1$-$C_{30}$ heterocyclic group,
Y is an oxygen atom, a sulfur atom, a nitrogen atom, a phosphorus atom, S=O, P=O, or C=O,
Z is an oxygen atom, a sulfur atom, a nitrogen atom, or a phosphorus atom, and
: is a lone-pair of electrons.

**11.** The resist composition of any of claims 1-10, wherein

the repeating unit containing a radical generating group is represented by Formula 2-1 or 2-2, and
the repeating unit containing a radical accepting group is represented by any one of Formulas 2-3 to 2-6:

Formula 2-1

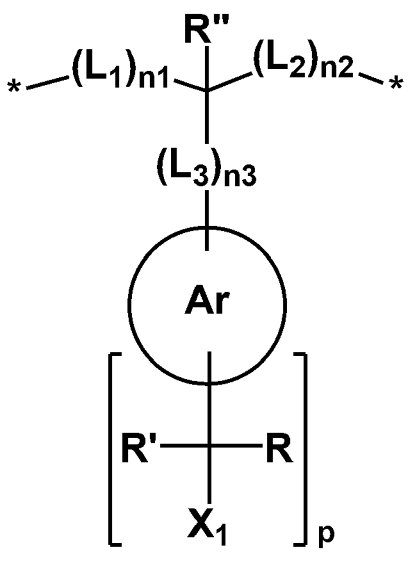

Formula 2-2

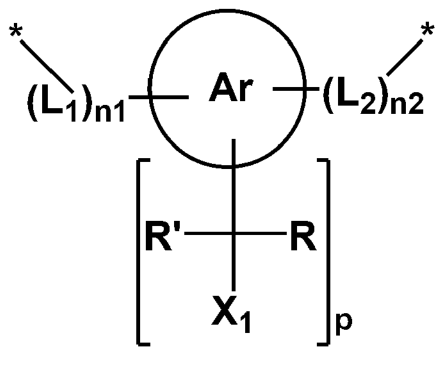

Formula 2-3

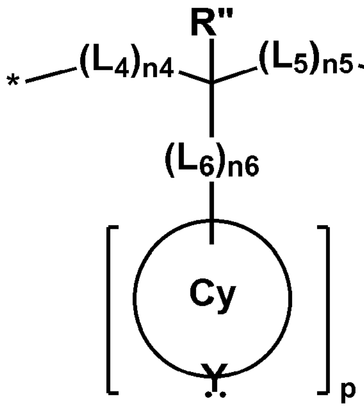

Formula 2-4

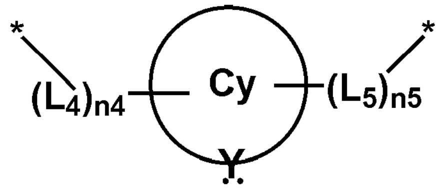

Formula 2-5

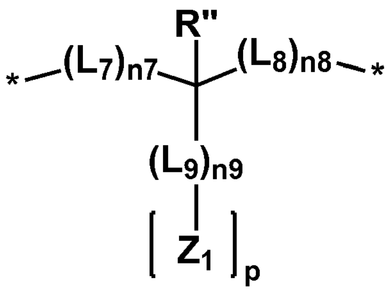

Formula 2-6

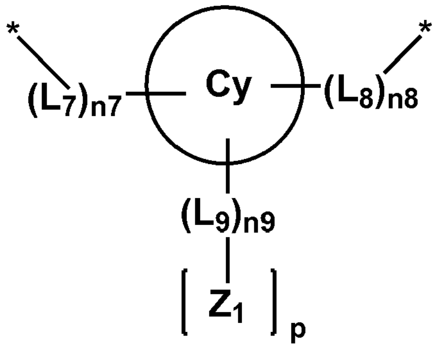

wherein, in Formulas 2-1 to 2-2,

Ar is an unsubstituted or substituted $C_1$-$C_{30}$ aryl group or an unsubstituted or substituted $C_1$-$C_{30}$ heteroaryl group,
$X_1$ is an electron withdrawing group,
R, R', and R" are each independently hydrogen, deuterium, a halogen, or a linear, branched or cyclic $C_1$-$C_{30}$ divalent hydrocarbon group optionally containing one or more heteroatoms,
$L_1$ to $L_3$ are each independently a single bond, O, S, C(=O), C(=O)O, OC(=O), C(=O)NH, NHC(=O), a linear, branched or cyclic $C_1$-$C_{30}$ divalent hydrocarbon group optionally containing one or more heteroatoms, or any combination thereof,
n1 to n3 are each independently an integer from 1 to 6,
p is an integer from 1 to 5, and
* is a binding site with a neighboring atom,

wherein, in Formulas 2-3 to 2-6,

Cy is an unsubstituted or substituted $C_1$-$C_{30}$ carbocyclic group or an unsubstituted or substituted $C_1$-$C_{30}$ heterocyclic group,
Y is an oxygen atom, a sulfur atom, a nitrogen atom, a phosphorus atom, S=O, P=O, or C=O,
: is a lone-pair of electrons,
$Z_1$ is an electron donating group,
R" is hydrogen, deuterium, a halogen, or a linear, branched or cyclic $C_1$-$C_{30}$ monovalent hydrocarbon group optionally containing one or more heteroatoms,
$L_4$ to $L_9$ are each independently a single bond, O, S, C(=O), C(=O)O, OC(=O), C(=O)NH, NHC(=O), a linear, branched or cyclic $C_1$-$C_{30}$ divalent hydrocarbon group optionally containing one or more heteroatoms, or any combination thereof,
n4 to n9 are each independently an integer from 1 to 6,
p is an integer from 1 to 5, and

* is a binding site with a neighboring atom.

**12.** A resist composition, comprising:

an organometallic compound represented by Formula 1; and
a monomer containing a radical generating group or a radical accepting group:

Formula 1 $Sn(R_{11})_n(OR_{12})_{(4-n)}$

wherein in Formula 1,

$R_{11}$ is a linear, branched or cyclic $C_1$-$C_{30}$ monovalent hydrocarbon group optionally containing one or more heteroatoms,
$R_{12}$ is a linear, branched or cyclic $C_1$-$C_{30}$ monovalent hydrocarbon group optionally containing one or more heteroatoms, or *-$Sn(R_{13})_m(OR_{14})_{(3-m)}$, wherein

$R_{13}$ and $R_{14}$ are each independently a linear, branched or cyclic $C_1$-$C_{30}$ monovalent hydrocarbon group optionally containing one or more heteroatoms,
m is an integer from 0 to 3, and
* is a binding site with a neighboring atom, and

n is an integer from 1 to 4;
preferably wherein the monomer comprises at least one polymerizable group.

**13.** A method of forming a pattern, the method comprising:

forming a resist film based on applying the resist composition of any of claims 1-12;
exposing at least a portion of the resist film to a high-energy ray to establish an exposed resist film; and
developing the exposed resist film based on using a developer.

**14.** The method of claim 13, wherein the exposing is performed based on irradiation of deep ultraviolet light (DUV), extreme ultraviolet light (EUV), and/or an electron beam (EB); and/or
wherein a chemical bond between the organometallic compound and the polymer is formed based on exposing the resist film.

**15.** The method of claims 13 or 14, wherein

based on the exposing at least the portion of the resist film, the exposed resist film comprises an exposed portion and an unexposed portion, and
the developing the exposed resist film includes removing the unexposed portion.

**Amended claims in accordance with Rule 137(2) EPC.**

**1.** A resist composition, comprising:

an organometallic compound represented by Formula 1; and
a polymer comprising a repeating unit containing a radical generating group, a repeating unit containing a radical accepting group, or any combination thereof:

Formula 1 $Sn(R_{11})_n(OR_{12})_{(4-n)}$

wherein in Formula 1,

$R_{11}$ is a linear, branched or cyclic $C_1$-$C_{30}$ monovalent hydrocarbon group optionally containing one or more heteroatoms,
$R_{12}$ is a linear, branched or cyclic $C_1$-$C_{30}$ monovalent hydrocarbon group optionally containing one or more heteroatoms, or *-$Sn(R_{13})_m(OR_{14})_{(3-m)}$, wherein

$R_{13}$ and $R_{14}$ are each independently a linear, branched or cyclic $C_1$-$C_{30}$ monovalent hydrocarbon group optionally containing one or more heteroatoms,
m is an integer from 0 to 3,

a bond between Sn and $R_{11}$ is a Sn-carbon(C) single bond, and a bond between Sn and $R_{13}$ is a Sn-C single bond, and
* is a binding site with a neighboring atom, and
n is 2 or 4,
wherein the resist composition does not contain a photoacid generator.

**2.** The resist composition of claim 1, wherein, in Formula 1,
wherein, in Formula 1, the organometallic compound has a molecular weight of 3,000 g/mol or less.

**3.** The resist composition of claims 1 or 2, wherein, in Formula 1,

when $R_{11}$ and $R_{13}$ are each independently represented by *-$(L_{11})_{a11}$-$X_{11}$, and/or $R_{12}$ and $R_{14}$ are each independently represented by *-$(L_{12})_{a12}$-$X_{12}$,
$L_{11}$ and $L_{12}$ are each independently $CR_aR_b$, C=O, S=O, $SO_2$, $PO_2$, or $PO_3$,
a11 and a12 are each independently an integer from 0 to 3,
$X_{11}$ and $X_{12}$ are each independently an unsubstituted or substituted $C_1$-$C_{30}$ alkyl group, an unsubstituted or substituted $C_1$-$C_{30}$ halogenated alkyl group, an unsubstituted or substituted $C_1$-$C_{30}$ alkoxy group, an unsubstituted or substituted $C_1$-$C_{30}$ alkylthio group, an unsubstituted or substituted $C_1$-$C_{30}$ halogenated alkoxy group, an unsubstituted or substituted $C_1$-$C_{30}$ halogenated alkylthio group, an unsubstituted or substituted $C_3$-$C_{30}$ cycloalkyl group, an unsubstituted or substituted $C_3$-$C_{30}$ cycloalkoxy group, an unsubstituted or substituted $C_3$-$C_{30}$ cycloalkylthio group, an unsubstituted or substituted $C_3$-$C_{30}$ heterocycloalkyl group, an unsubstituted or substituted $C_3$-$C_{30}$ heterocycloalkoxy group, an unsubstituted or substituted $C_3$-$C_{30}$ heterocycloalkylthio group, an unsubstituted or substituted $C_2$-$C_{30}$ alkenyl group, an unsubstituted or substituted $C_2$-$C_{30}$ alkenyloxy group, an unsubstituted or substituted $C_2$-$C_{30}$ alkenylthio group, an unsubstituted or substituted $C_3$-$C_{30}$ cycloalkenyl group, an unsubstituted or substituted $C_3$-$C_{30}$ cycloalkenyloxy group, an unsubstituted or substituted $C_3$-$C_{30}$ cycloalkenylthio group, an unsubstituted or substituted $C_3$-$C_{30}$ heterocycloalkenyl group, an unsubstituted or substituted $C_3$-$C_{30}$ heterocycloalkenyloxy group, an unsubstituted or substituted $C_3$-$C_{30}$ heterocycloalkenylthio group, an unsubstituted or substituted $C_2$-$C_{30}$ alkynyl group, an unsubstituted or substituted $C_2$-$C_{30}$ alkynyloxy group, an unsubstituted or substituted $C_2$-$C_{30}$ alkynylthio group, an unsubstituted or substituted $C_6$-$C_{30}$ aryl group, an unsubstituted or substituted $C_6$-$C_{30}$ aryloxy group, an unsubstituted or substituted $C_6$-$C_{30}$ arylthio group, an unsubstituted or substituted $C_1$-$C_{30}$ heteroaryl group, an unsubstituted or substituted $C_1$-$C_{30}$ heteroaryloxy group, or an unsubstituted or substituted $C_1$-$C_{30}$ heteroarylthio group,
$R_a$ and $R_b$ are each independently hydrogen, deuterium, a hydroxyl group, a cyano group, a nitro group, an unsubstituted or substituted $C_1$-$C_{30}$ alkyl group, an unsubstituted or substituted $C_1$-$C_{30}$ alkoxy group, an unsubstituted or substituted $C_1$-$C_{30}$ alkylthio group, an unsubstituted or substituted $C_3$-$C_{30}$ cycloalkyl group, an unsubstituted or substituted $C_3$-$C_{30}$ cycloalkoxy group, or an unsubstituted or substituted $C_3$-$C_{30}$ cycloalkylthio group, and
* is a binding site with a neighboring atom.

**4.** The resist composition of any of claims 1-3, wherein the organometallic compound is represented by any one of Formulas 1-2 and 1-4 to 1-16:

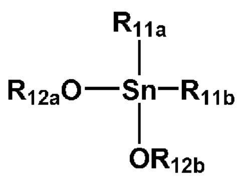
1-2

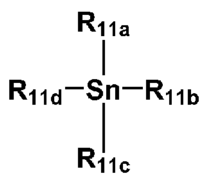
1-4

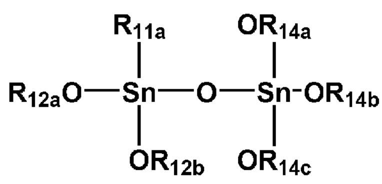

**1-5**

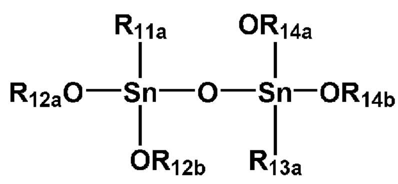

**1-6**

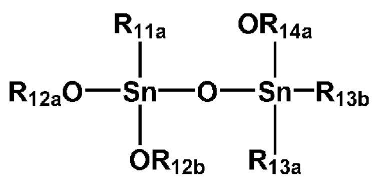

**1-7**

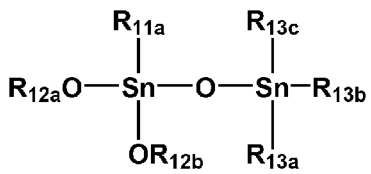

**1-8**

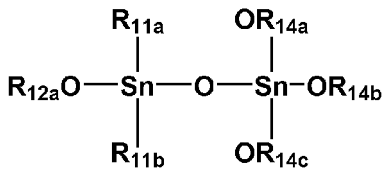

**1-9**

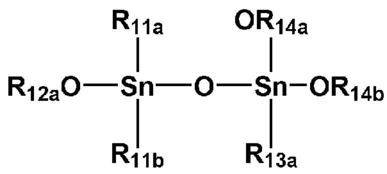

**1-10**

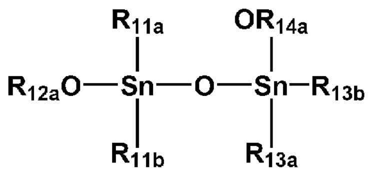

**1-11**

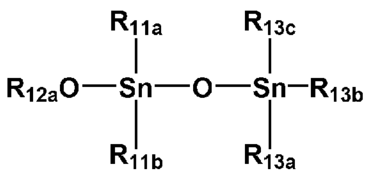

**1-12**

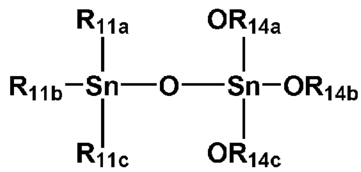

**1-13**

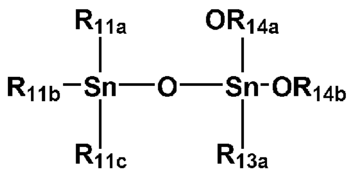

**1-14**

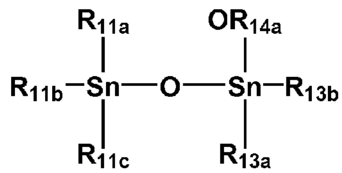

**1-15**

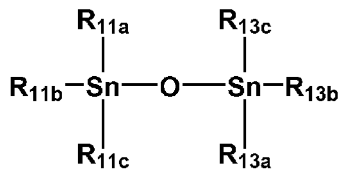

**1-16**

wherein in Formulas 1-2 and 1-4 to 1-16,

$R_{11a}$ to $R_{11d}$ are each independently a linear, branched or cyclic $C_1$-$C_{30}$ monovalent hydrocarbon group optionally containing one or more heteroatoms,
$R_{12a}$ and $R_{12b}$ are each independently a linear, branched or cyclic $C_1$-$C_{30}$ monovalent hydrocarbon group optionally containing one or more heteroatoms, or $*$-$Sn(R_{13})_m(OR_{14})_{(3-m)}$, where $R_{13}$ and $R_{14}$ are each independently a linear, branched or cyclic $C_1$-$C_{30}$ monovalent hydrocarbon group optionally containing one or more heteroatoms, m is an integer from 0 to 3, and * is a binding site with a neighboring atom,
$R_{13a}$ to $R_{13c}$ are each independently a linear, branched or cyclic $C_1$-$C_{30}$ monovalent hydrocarbon group optionally containing one or more heteroatoms, and
$R_{14a}$ to $R_{14c}$ are each independently a linear, branched or cyclic $C_1$-$C_{30}$ monovalent hydrocarbon group optionally containing one or more heteroatoms.

**5.** The resist composition of any of claims 1-4, wherein
the radical generating group comprises a single bond between a carbon atom and X (C-X) or a single bond between a carbon atom and $X^+$ (C-$X^+$), wherein X is a heteroatom other than a carbon atom and a hydrogen atom.

**6.** The resist composition of claim 5, wherein X is a halogen, an oxygen atom, a sulfur atom, a selenium atom, a nitrogen atom, or a phosphorus atom; and/or
wherein an unsubstituted or substituted $C_1$-$C_{30}$ aryl group or an unsubstituted or substituted $C_1$-$C_{30}$ heteroaryl group is bound adjacent to the carbon atom.

**7.** The resist composition of any of claims 1-6, wherein
the radical generating group comprises a partial structure represented by Formula RG:

Formula RG

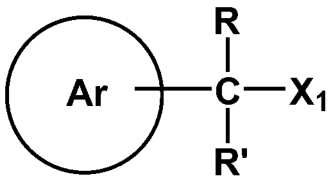

wherein in Formula RG,

Ar is an unsubstituted or substituted $C_1$-$C_{30}$ aryl group or an unsubstituted or substituted $C_1$-$C_{30}$ heteroaryl group,
R and R' are each independently hydrogen, deuterium, a halogen, or a linear, branched or cyclic $C_1$-$C_{30}$ divalent hydrocarbon group optionally containing one or more heteroatoms, and
$X_1$ is an electron withdrawing group.

**8.** The resist composition of any of claims 1-7, wherein
the radical accepting group comprises a lone-pair electron donating group and/or an electron donating group.

**9.** The resist composition of claim 8, wherein the lone-pair electron donating group comprises an oxygen atom, a sulfur atom, a nitrogen atom, or a phosphorus atom, as a partial structure; and/or
wherein the electron donating group comprises a single bond between a hydrogen atom and Z (Z-H), wherein Z is a heteroatom other than a carbon atom and a hydrogen atom.

**10.** The resist composition of any of claims 1-9, wherein
the radical accepting group comprises a partial structure represented by Formula RA1 or RA2:

Formula RA1

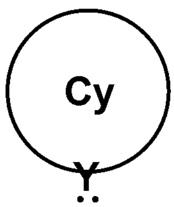

Formula RA2

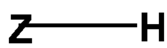

wherein in Formulas RA1 and RA2,

Cy is an unsubstituted or substituted $C_1$-$C_{30}$ carbocyclic group or an unsubstituted or substituted $C_1$-$C_{30}$ heterocyclic group,
Y is an oxygen atom, a sulfur atom, a nitrogen atom, a phosphorus atom, S=O, P=O, or C=O,
Z is an oxygen atom, a sulfur atom, a nitrogen atom, or a phosphorus atom, and
: is a lone-pair of electrons.

**11.** The resist composition of any of claims 1-10, wherein

the repeating unit containing a radical generating group is represented by Formula 2-1 or 2-2, and
the repeating unit containing a radical accepting group is represented by any one of Formulas 2-3 to 2-6:

Formula 2-1

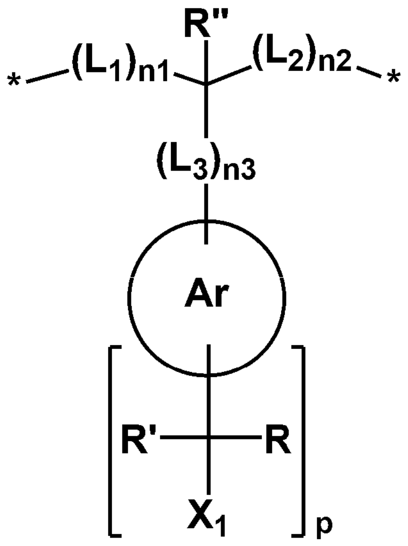

Formula 2-2

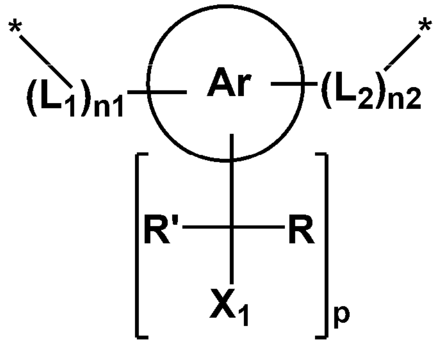

Formula 2-3

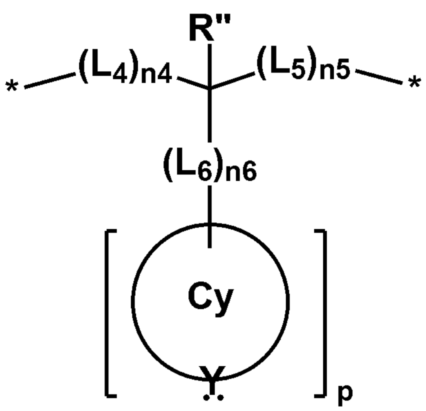

Formula 2-4

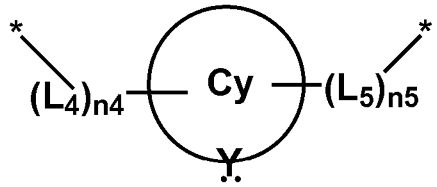

Formula 2-5

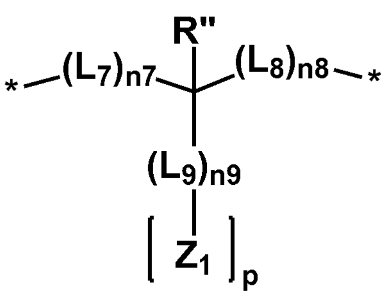

Formula 2-6

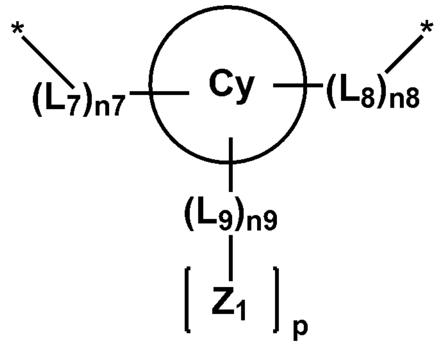

wherein, in Formulas 2-1 to 2-2,

Ar is an unsubstituted or substituted $C_1$-$C_{30}$ aryl group or an unsubstituted or substituted $C_1$-$C_{30}$ heteroaryl group,
$X_1$ is an electron withdrawing group,
R, R', and R" are each independently hydrogen, deuterium, a halogen, or a linear, branched or cyclic $C_1$-$C_{30}$ divalent hydrocarbon group optionally containing one or more heteroatoms,

$L_1$ to $L_3$ are each independently a single bond, O, S, C(=O), C(=O)O, OC(=O), C(=O)NH, NHC(=O), a linear, branched or cyclic $C_1$-$C_{30}$ divalent hydrocarbon group optionally containing one or more heteroatoms, or any combination thereof,
n1 to n3 are each independently an integer from 1 to 6,
p is an integer from 1 to 5, and
* is a binding site with a neighboring atom,
wherein, in Formulas 2-3 to 2-6,
Cy is an unsubstituted or substituted $C_1$-$C_{30}$ carbocyclic group or an unsubstituted or substituted $C_1$-$C_{30}$ heterocyclic group,
Y is an oxygen atom, a sulfur atom, a nitrogen atom, a phosphorus atom, S=O, P=O, or C=O,
: is a lone-pair of electrons,
$Z_1$ is an electron donating group,
R" is hydrogen, deuterium, a halogen, or a linear, branched or cyclic $C_1$-$C_{30}$ monovalent hydrocarbon group optionally containing one or more heteroatoms,
$L_4$ to $L_9$ are each independently a single bond, O, S, C(=O), C(=O)O, OC(=O), C(=O)NH, NHC(=O), a linear, branched or cyclic $C_1$-$C_{30}$ divalent hydrocarbon group optionally containing one or more heteroatoms, or any combination thereof,
n4 to n9 are each independently an integer from 1 to 6,
p is an integer from 1 to 5, and
* is a binding site with a neighboring atom.

**12.** A resist composition, comprising:

an organometallic compound represented by Formula 1; and
a monomer containing a radical generating group or a radical accepting group:

Formula 1 $Sn(R_{11})_n(OR_{12})_{(4-n)}$

wherein in Formula 1,

$R_{11}$ is a linear, branched or cyclic $C_1$-$C_{30}$ monovalent hydrocarbon group optionally containing one or more heteroatoms,
$R_{12}$ is a linear, branched or cyclic $C_1$-$C_{30}$ monovalent hydrocarbon group optionally containing one or more heteroatoms, or *-$Sn(R_{13})_m(OR_{14})_{(3-m)}$, wherein
$R_{13}$ and $R_{14}$ are each independently a linear, branched or cyclic $C_1$-$C_{30}$ monovalent hydrocarbon group optionally containing one or more heteroatoms,
m is an integer from 0 to 3,
a bond between Sn and $R_{11}$ is a Sn-carbon(C) single bond, and a bond between Sn and $R_{13}$ is a Sn-C single bond, and
* is a binding site with a neighboring atom, and
n is 2 or 4;
preferably wherein the monomer comprises at least one polymerizable group,
wherein the resist composition does not contain a photoacid generator.

**13.** A method of forming a pattern, the method comprising:

forming a resist film based on applying the resist composition of any of claims 1-12;
exposing at least a portion of the resist film to a high-energy ray to establish an exposed resist film; and
developing the exposed resist film based on using a developer.

**14.** The method of claim 13, wherein the exposing is performed based on irradiation of deep ultraviolet light (DUV), extreme ultraviolet light (EUV), and/or an electron beam (EB).

**15.** The method of claims 13 or 14, wherein

based on the exposing at least the portion of the resist film, the exposed resist film comprises an exposed portion and an unexposed portion, and
the developing the exposed resist film includes removing the unexposed portion.

FIG. 1

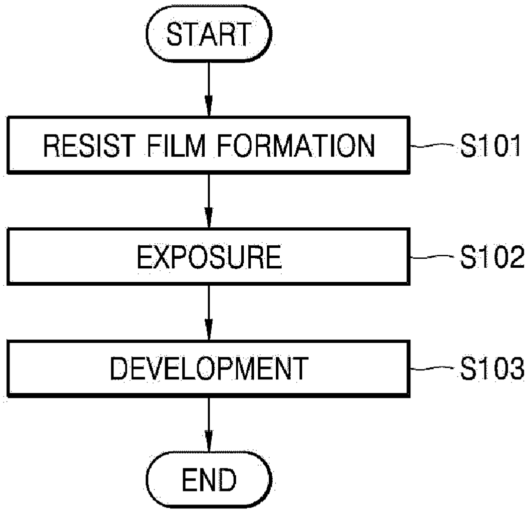
START
RESIST FILM FORMATION
S101
EXPOSURE
S102
DEVELOPMENT
S103
END

FIG. 2A

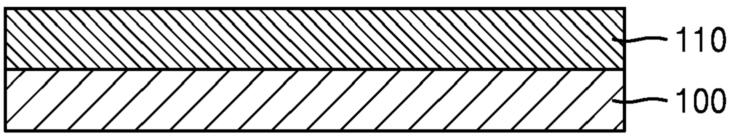

FIG. 2B

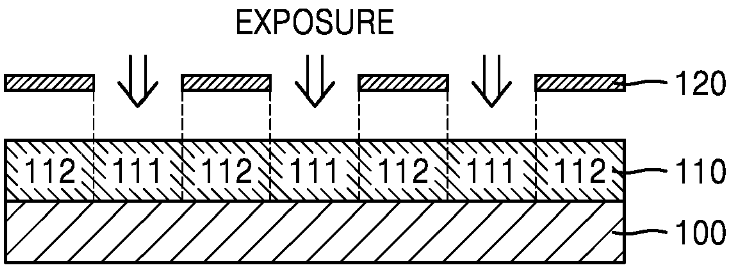

FIG. 2C

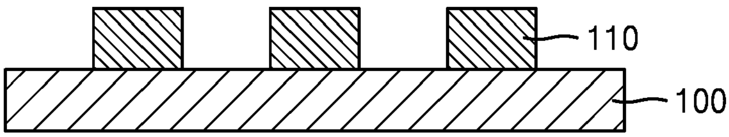

# FIG. 3A

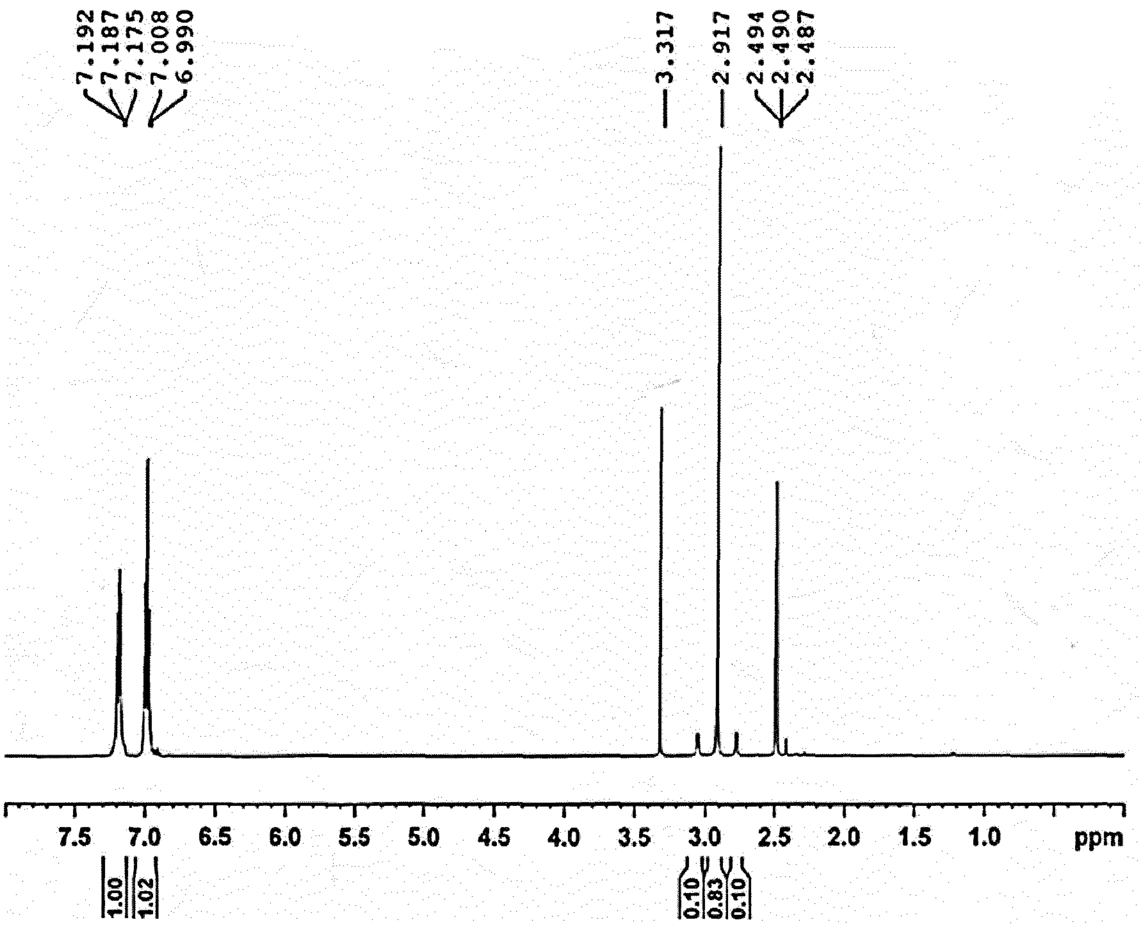
7.192
7.187
7.175
7.008
6.990
3.317
2.917
2.494
2.490
2.487
7.5 7.0 6.5 6.0 5.5 5.0 4.5 4.0 3.5 3.0 2.5 2.0 1.5 1.0 ppm
1.00
1.02
0.10
0.83
0.10

FIG. 3B

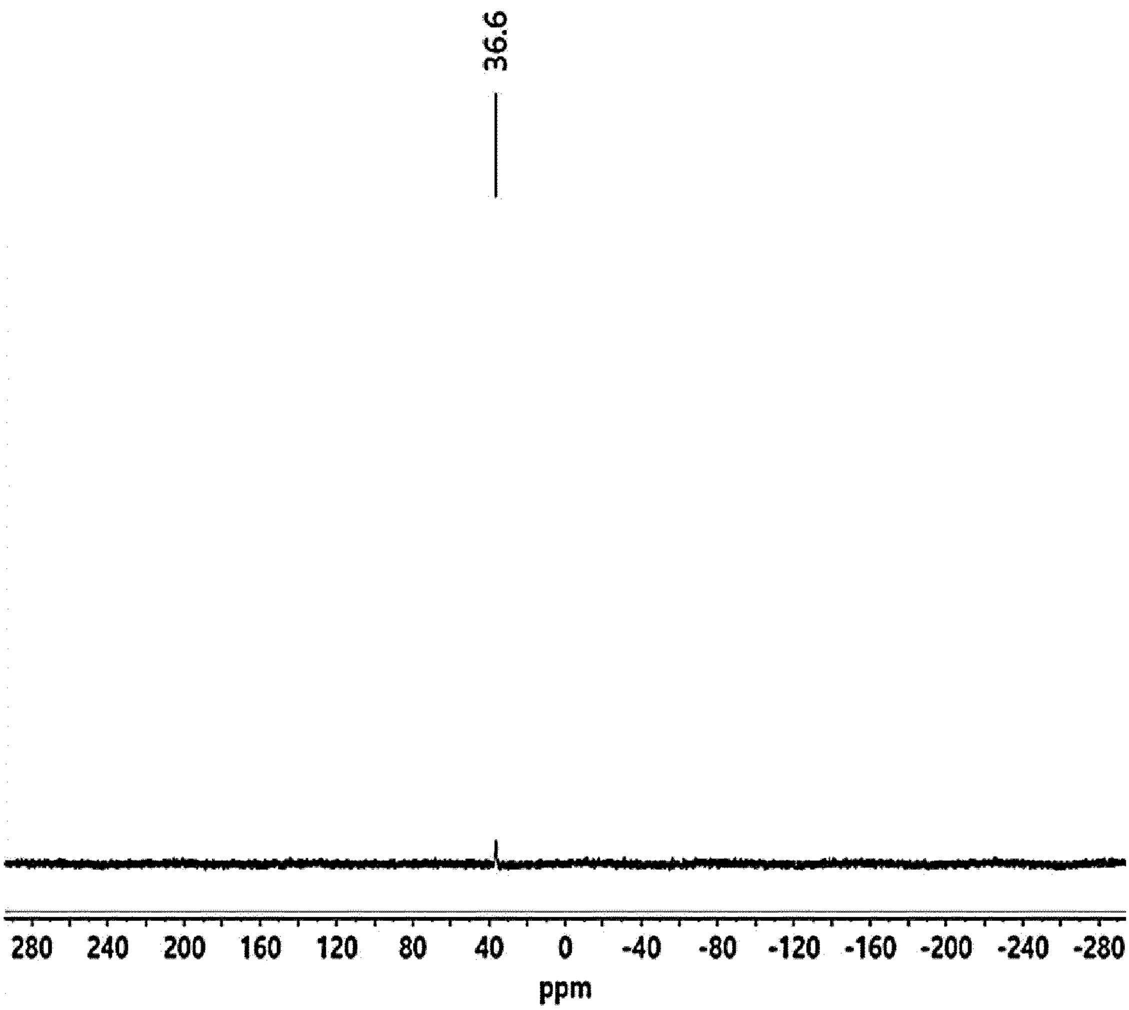

FIG. 3C

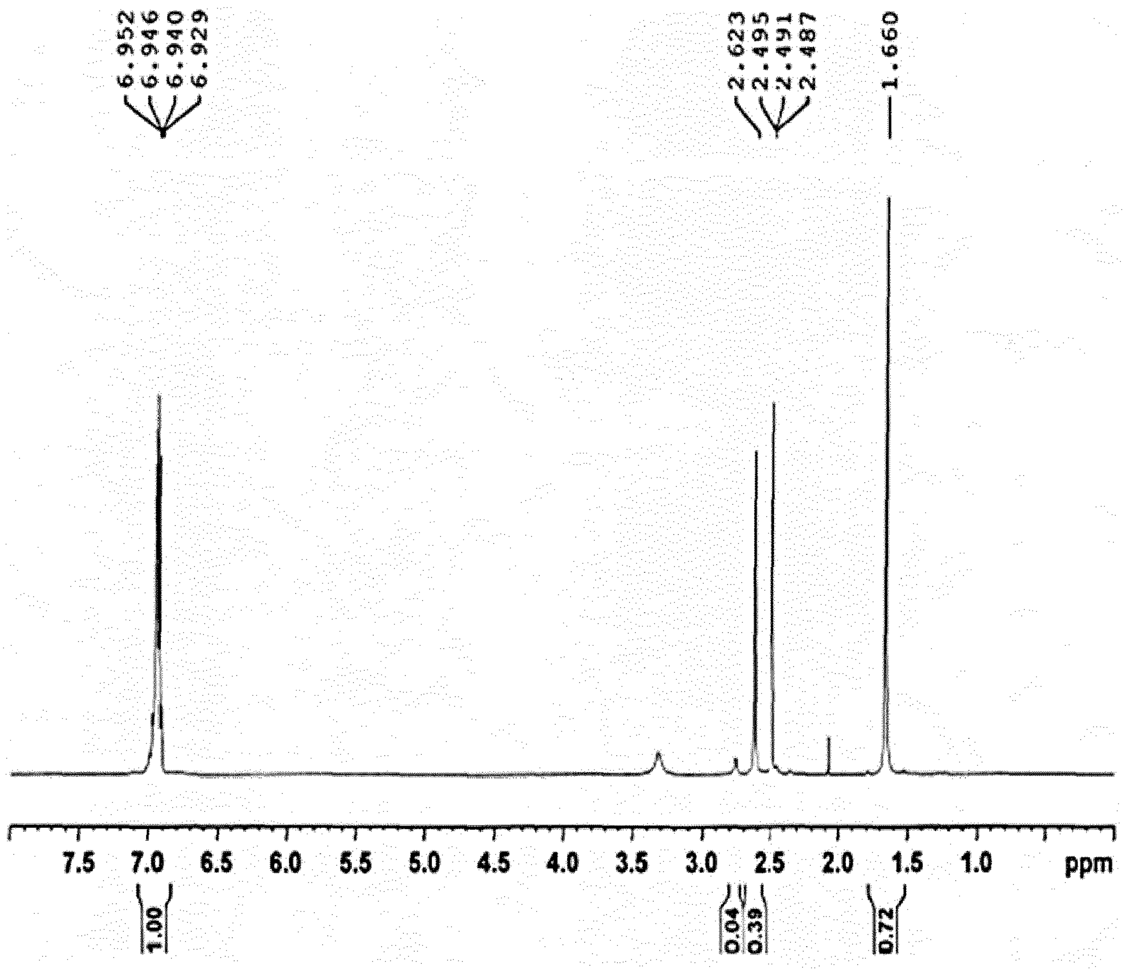
6.952
6.946
6.940
6.929
2.623
2.495
2.491
2.487
1.660
7.5 7.0 6.5 6.0 5.5 5.0 4.5 4.0 3.5 3.0 2.5 2.0 1.5 1.0 ppm
1.00
0.04
0.39
0.72

FIG. 3D

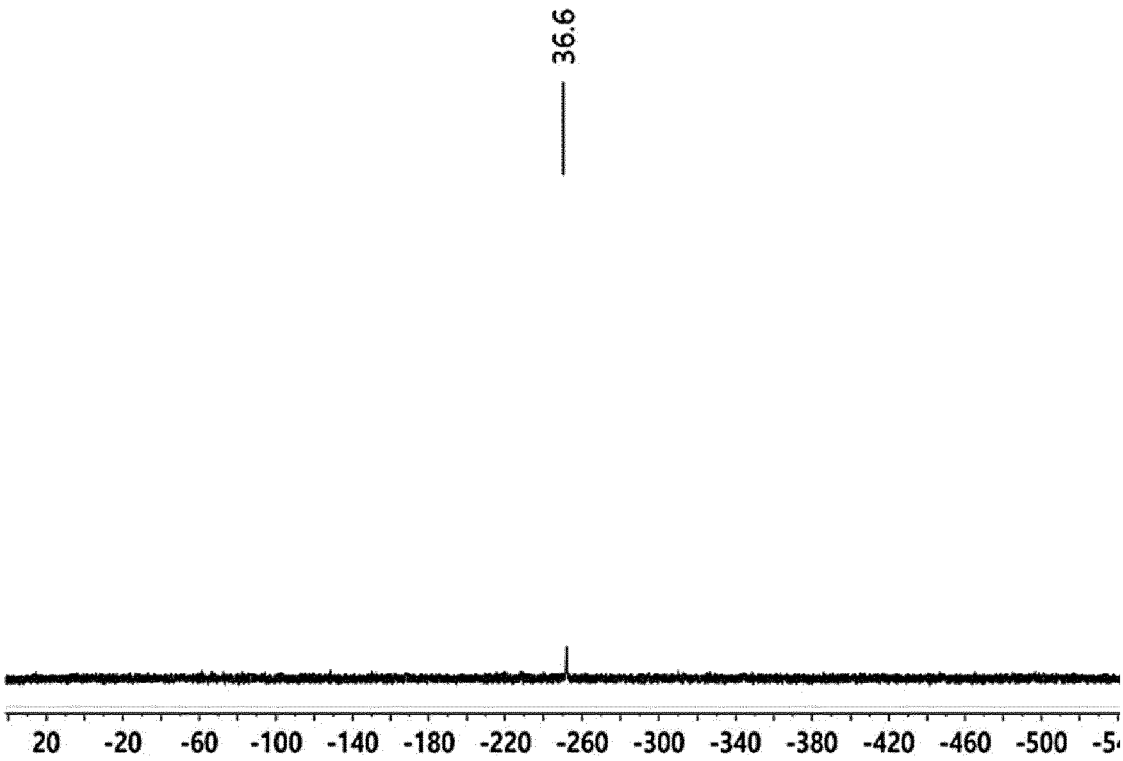

FIG. 4A

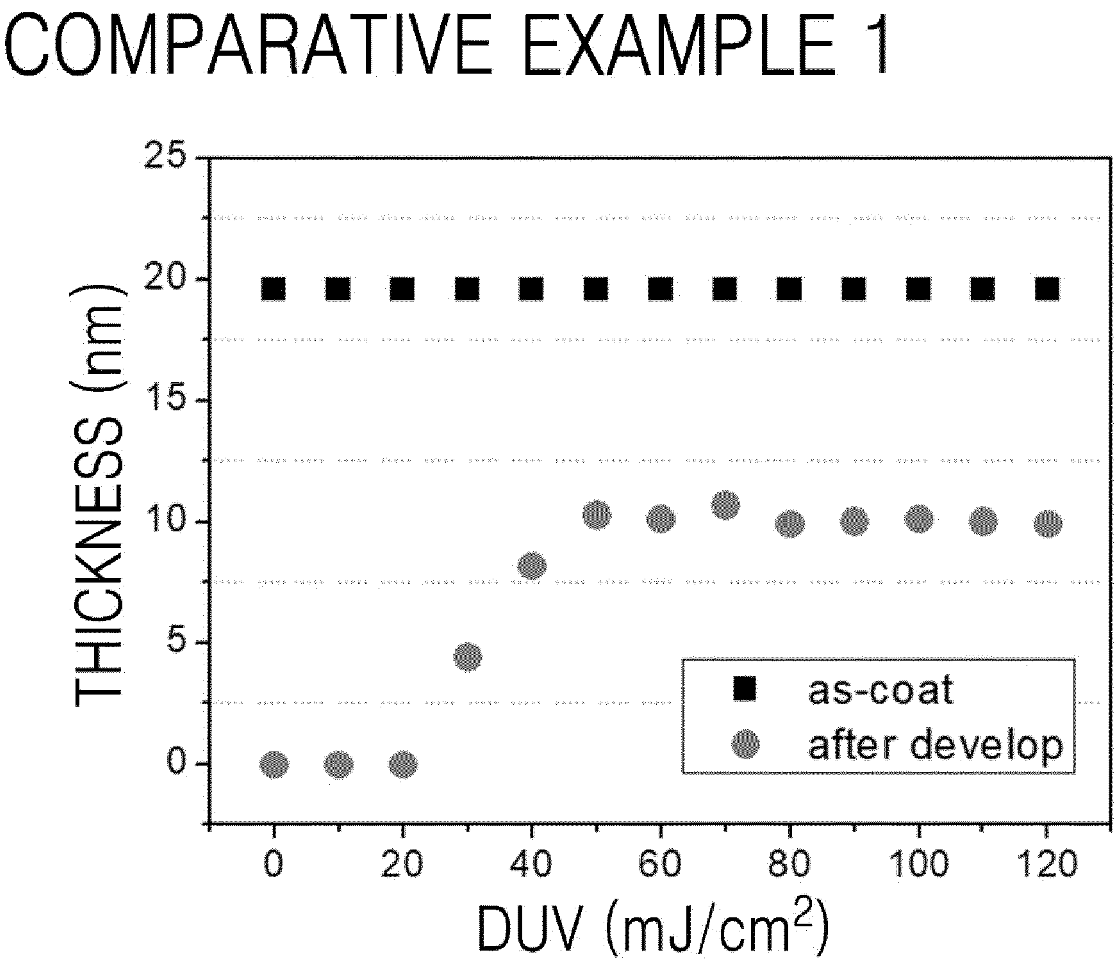
COMPARATIVE EXAMPLE 1
THICKNESS (nm)
25
20
15
10
5
0
0
20
40
60
80
100
120
DUV (mJ/cm2)
as-coat
after develop

FIG. 4B

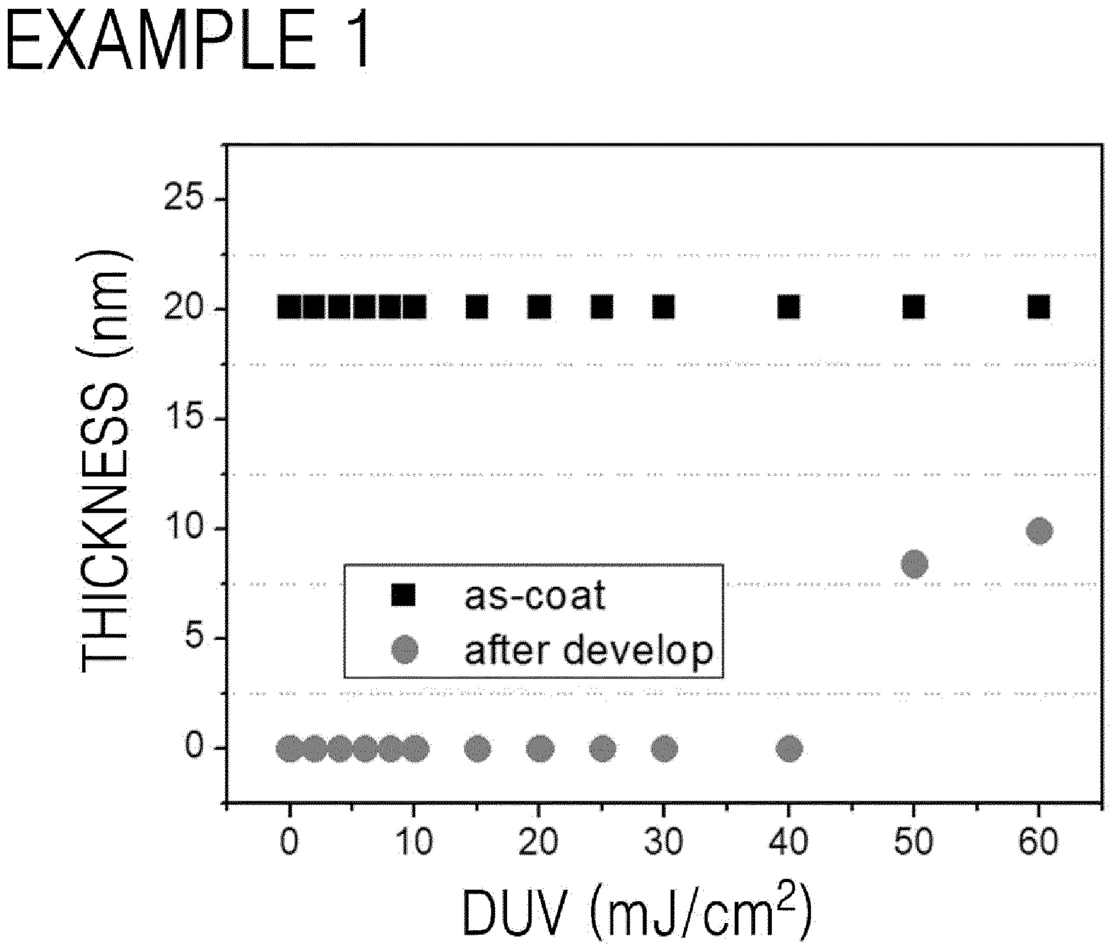
EXAMPLE 1
THICKNESS (nm)
25
20
15
10
5
0
0
10
20
30
40
50
60
DUV ($mJ/cm^2$)
as-coat
after develop

Europäisches Patentamt
European Patent Office
Office européen des brevets

# EUROPEAN SEARCH REPORT

Application Number
EP 23 17 8649

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2 745 820 A (MACK GERRY P) 15 May 1956 (1956-05-15) * column 2, line 59 - column 3, line 30; claims 1,2; examples 1-6 * * column 1, lines 11-43 * ----- | 1-6,8,9, 12 | INV. G03F7/004 C07F7/22 |
| X | US 11 347 147 B2 (TOYO GOSEI CO LTD [JP]) 31 May 2022 (2022-05-31) * column 35, lines 25-37; claims 1-10; examples 1-40 * ----- | 1-6,8-15 | |
| X | US 2021/333708 A1 (MOON KYUNG SOO [KR] ET AL) 28 October 2021 (2021-10-28) * paragraphs [0053], [0054] - [0063], [0078], [0073] - [0084]; claims 1-12; examples 1-8 * ----- | 1-6,8-15 | |
| X | US 2022/334474 A1 (LEE HONGJOON [KR] ET AL) 20 October 2022 (2022-10-20) * paragraphs [0007], [0020] - [0045], [0082], [0106] - [0107]; claims 1-20; figures 2, 3A, 3B, 4A, 4B * ----- | 1-15 | TECHNICAL FIELDS SEARCHED (IPC) G03F C07F |

The present search report has been drawn up for all claims

1

| Place of search | Date of completion of the search | Examiner |
|---|---|---|
| Munich | 29 November 2023 | Eggers, Karin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 23 17 8649

This annex lists the patent family members relating to the patent documents cited in the above-mentioned European search report. The members are as contained in the European Patent Office EDP file on
The European Patent Office is in no way liable for these particulars which are merely given for the purpose of information.

29-11-2023

| Patent document cited in search report | | Publication date | Patent family member(s) | Publication date |
|---|---|---|---|---|
| US 2745820 | A | 15-05-1956 | NONE | |
| US 11347147 | B2 | 31-05-2022 | JP WO2018084050 A1 | 26-09-2019 |
| | | | KR 20190082279 A | 09-07-2019 |
| | | | TW 201827444 A | 01-08-2018 |
| | | | US 2019243243 A1 | 08-08-2019 |
| | | | WO 2018084050 A1 | 11-05-2018 |
| US 2021333708 | A1 | 28-10-2021 | KR 20200014216 A | 10-02-2020 |
| | | | TW 202007691 A | 16-02-2020 |
| | | | US 2020041897 A1 | 06-02-2020 |
| | | | US 2021333708 A1 | 28-10-2021 |
| US 2022334474 | A1 | 20-10-2022 | NONE | |

EPO FORM P0459

For more details about this annex : see Official Journal of the European Patent Office, No. 12/82